(19) Europäisches Patentamt
European Patent Office
Office européen des brevets

(11) EP 2 669 966 A1

(12) EUROPEAN PATENT APPLICATION
published in accordance with Art. 153(4) EPC

(43) Date of publication:
**04.12.2013 Bulletin 2013/49**

(21) Application number: **12739774.3**

(22) Date of filing: **27.01.2012**

(51) Int Cl.:
***H01L 51/42*** (2006.01) ***C08G 61/12*** (2006.01)
***H01L 29/786*** (2006.01) ***H01L 51/05*** (2006.01)
***H01L 51/30*** (2006.01)

(86) International application number:
**PCT/JP2012/051870**

(87) International publication number:
**WO 2012/102390 (02.08.2012 Gazette 2012/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.01.2011 JP 2011016941**
**28.04.2011 JP 2011102534**
**31.08.2011 JP 2011189783**

(71) Applicant: **Mitsubishi Chemical Corporation**
**Chiyoda-ku**
**Tokyo 100-8251 (JP)**

(72) Inventors:
- **OKABE, Misako**
  **Yokohama-shi, Kanagawa 227-8502 (JP)**
- **ENDA, Jun**
  **Yokohama-shi, Kanagawa 227-8502 (JP)**
- **AKIYAMA, Seiji**
  **Yokohama-shi, Kanagawa 227-8502 (JP)**
- **OOTA, Hitoshi**
  **Yokohama-shi, Kanagawa 227-8502 (JP)**
- **FUJITA, Rieko**
  **Yokohama-shi, Kanagawa 227-8502 (JP)**
- **OOTSUBO, Saika**
  **Yokohama-shi, Kanagawa 227-8502 (JP)**

(74) Representative: **HOFFMANN EITLE**
**Patent- und Rechtsanwälte**
**Arabellastrasse 4**
**81925 München (DE)**

# (54) PHOTOELECTRIC CONVERSION ELEMENT, SOLAR CELL, AND SOLAR CELL MODULE

(57) An object of the present invention is to provide a photoelectric conversion element, a solar cell and a solar cell module with improved photoelectric conversion efficiency. The object is achieved with a photoelectric conversion element comprising a pair of electrodes, an active layer disposed between the electrodes and an electron extraction layer disposed between at least one of the electrodes and the active layer, wherein the active layer contains a copolymer having a repeating unit represented by General Formula (1) below, and the electron extraction layer contains a compound represented by General Formula (E1) below.

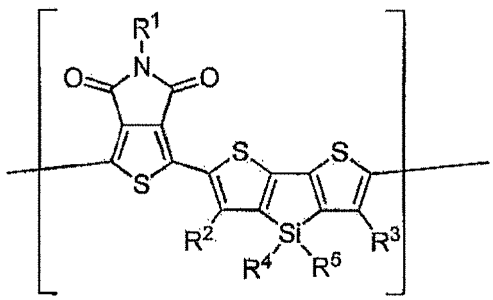
(1)

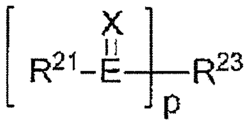
(E1)

EP 2 669 966 A1

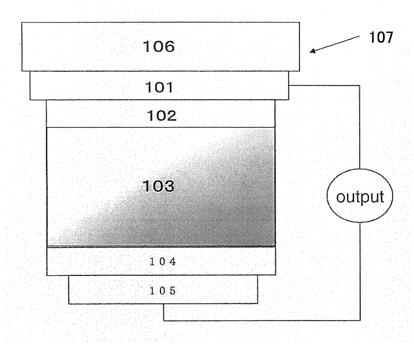


Fig. 1

## Description

[TECHNICAL FIELD]

The present invention relates to a photoelectric conversion element in which the active layer contains a novel copolymer having a repeating unit of a specific structure, while the electron extraction layer contains a specific compound, and also relates to a solar cell and a solar cell module using this element.

[BACKGROUND ART]

Pi-conjugated polymers have been applied as semiconductor materials in organic EL elements, organic thin-film transistors, organic luminescence sensors and other devices, and their application to polymer organic solar cells is of particularly interest. Improvements in the absorption efficiency of solar light are desirable in organic solar cells in particular, and development of polymers capable of absorbing light at long wavelengths (600 nm or more) is important. Several examples have been reported in which a copolymer of a donor monomer and an acceptor monomer (hereunder also called a copolymer) is used in a photoelectric conversion element with the aim of increasing the absorption wavelength.

For example, according to Non-Patent Document 1 a copolymer having an imidothiophene structure and a benzothiophene structure introduced into the principal chain absorbed light at a wavelength of about 700 nm, and the photoelectric conversion efficiency of a photoelectric conversion element using this copolymer was about 6.8%.
According to Non-Patent Document 2, a copolymer having an imidothiophene structure and a dithienocyclopentadiene structure introduced into the main chain absorbed light at a wavelength of about 700 nm, and the photoelectric conversion efficiency of a photoelectric conversion element using this copolymer was about 3.1%.

According to Patent Document 1, the photoelectric conversion efficiency of a photoelectric conversion element using a copolymer having a dithienosilole structure and a benzothiadiazole structure, imidobenzene structure or other monomer introduced into the main chain was about 0.7%.
According to Patent Document 2, a copolymer having a diethienosilole structure and a benzothiadiazole structure or the like introduced into the principal chain absorbed light at a wavelength of about 750 nm, and the photoelectric conversion efficiency of a photoelectric conversion element using this copolymer was about 3.5%.

Patent Document 3 describes a photoelectric conversion element using a copolymer containing a biphenyl derivative structure and a thiophene structure having a substituent.
Non-Patent Document 3 describes photoelectric conversion elements using a copolymer having an imidothiophene structure and a dithienocyclopentadiene structure introduced into the main chain, a copolymer containing an imidothiophene structure and a dithienosilole structure, and a copolymer having an imidothiophene structure and a dithienopyrrole structure introduced into the main chain.

[Citation List]

[Patent Document]

Patent Document 1: Japanese Patent Application Publication No. 2010-507233
Patent Document 2: WO 2010/022058
Patent Document 3: Japanese Patent Application Publication No. 2006-063334

[Non-Patent Document]

Non-Patent Document 1: J. Am. Chem. Soc. 2010, 132, 7595-7597
Non-Patent Document 2: Xugang Guo and 5 others, Thieno[3,4-c]pyrrole-4,6-dione-Based Donor-Acceptor Conjugated Polymers for Solar Cells, [on line], Macromolecules, [searched on 21 January, 2011], internet <URL: http://pubs.acs.org/doi/pdfplus/10.1021/ma101878w>
Non-Patent Document 3: J. Mater. Chem. 2011, 21, 3895-3902

[SUMMARY OF INVENTION]

[Technical Problem]

The investigations of the inventors of the present application have shown that in the photoelectric conversion elements described in the documents described above, there is a need for increased photoelectric conversion efficiency for practical applications, and further improvements are required.

[Solution to Problem]

The inventors discovered as a result of exhaustive research aimed at solving these problems that a photoelectric conversion element with high photoelectric conversion efficiency could be obtained by combining an active layer having a copolymer containing a repeating unit comprising an imidothiophene structure and a dithienosilole structure with an electron extraction layer having a specific compound, thereby achieving the present invention. That is, the substance of the present invention is as follows.

[1] A photoelectric conversion element, comprising a pair of electrodes, an active layer disposed between the electrodes, and an electron extraction layer disposed between at least one of the electrodes and the active layer, wherein the active layer contains a copolymer having a repeating unit represented by General Formula (1) below, and the electron extraction layer contains a compound represented by General Formula (E1) below:

[Chemical Formula 1-1]

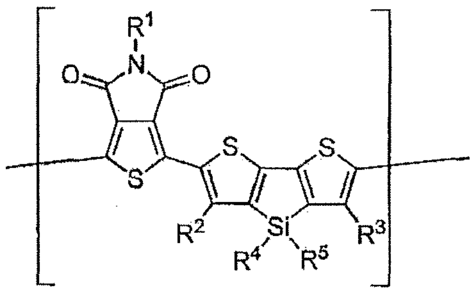

(1)

(in Formula (1), $R^1$ represents an optionally substituted alkyl group, optionally substituted alkenyl group or optionally substituted aryl group, and $R^2$ to $R^5$ each independently represent a hydrogen atom, halogen atom, optionally substituted alkyl group, optionally substituted alkenyl group or optionally substituted aryl group);

[Chemical Formula 1-2]

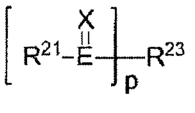

(E1)

(in Formula (E1), E represents $PR^{22}$, S, S(=O) or C; p represents an integer of 1 or greater, $R^{21}$ and $R^{22}$ each independently represent an arbitrary substituent, and $R^{21}$ and $R^{22}$ may bind to each other to form a ring; when p is 2 or greater, a plurality of $R^{21}$ and a plurality of $R^{22}$ may each independently be different, and any two or more of the plurality of $R^{21}$ and the plurality of $R^{22}$ may bind to each other to form a ring; $R^{23}$ represents an optionally substituted p-valent hydrocarbon group, an optionally substituted p-valent heterocyclic group, or a p-valent group with at least one of an optionally substituted hydrocarbon group and an optionally substituted heterocyclic group linked thereto; and X represents an atom selected from group 16 of the periodic table).

[2] The photoelectric conversion element according to [1], wherein the compound represented by General Formula (E1) above is a compound represented by General Formula (P1) below:

[Chemical Formula 1-3]

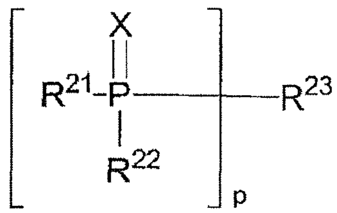

(P1)

(in Formula (P1), represents an integer of 1 or greater, $R^{21}$ and $R^{22}$ each independently represent an arbitrary substituent, and $R^{21}$ and $R^{22}$ may bind to each other to form a ring; when p is 2 or greater, a plurality of $R^{21}$ and a plurality of $R^{22}$ may each independently be different, and any two or more of the plurality of $R^{21}$ and the plurality of $R^{22}$ may bind to each other to form a ring; $R^{23}$ represents an optionally substituted p-valent hydrocarbon group, an optionally substituted p-valent heterocyclic group, or a p-valent group with at least one of an optionally substituted hydrocarbon group and an optionally substituted heterocyclic group linked thereto; and X represents an atom selected from group 16 of the periodic table).

[3] The photoelectric conversion element according to [1] or [2], wherein $R^{21}$ and $R^{22}$ each independently represent an optionally substituted hydrocarbon group, optionally substituted alkoxy group or optionally substituted heterocyclic group.

[4] The photoelectric conversion element according to any of [1] to [3], wherein the active layer also contains at least one kind of n-type semiconductor compound selected from the group consisting of fullerene compounds, borane derivatives, thiazole derivatives, benzothiazole derivatives, benzothiadiazole derivatives, N-alkyl substituted naphthalene tetracarboxylic diimides, N-alkyl substituted perylene diimide derivatives and n-type polymer semiconductor compounds.

[5] The photoelectric conversion element according to any of [1] to [4], which is a solar cell.

[6] A solar cell module comprising the photoelectric conversion element according to [5].

[Advantageous Effects of Invention]

A photoelectric conversion element, a solar cell and a solar cell module with improved photoelectric conversion efficiency can be provided by the present invention.

[Brief Description of Drawings]

Fig. 1 is a cross-section schematically illustrating the configuration of a photoelectric conversion element as one embodiment of the present invention.

Fig. 2 is a cross-section schematically illustrating the configuration of a solar cell as one embodiment of the present invention.

Fig. 3 is a cross-section schematically illustrating the configuration of a solar cell module as one embodiment of the present invention.

Fig. 4 shows the absorption spectra of a copolymer A1, a copolymer A2, a copolymer A3 and a copolymer B.

Fig. 5 shows the absorption spectra of the copolymer A2 and a copolymer C.

Fig. 6 shows the X-ray diffraction spectrum of the copolymer A2.

[Description of Embodiments]

Embodiments of the present invention are explained in detail below.
The following explanations of constituent elements pertain only to examples (typical examples) of embodiments of the present invention, and the present invention is not limited thereby as long as its intent is not exceeded.

[1-1. Copolymer having repeating units represented by General Formula (1)]

The copolymer of the present invention has a repeating unit represented by General Formula (1) below, or in other words a repeating unit comprising an imidothiophene structure and a dithienosilole structure. Because the copolymer of the present invention has a repeating unit having such structures, it has the advantages of a light-absorbing wavelength range that extends into longer wavelengths, and good light absorbing properties.

[Chemical Formula 2]

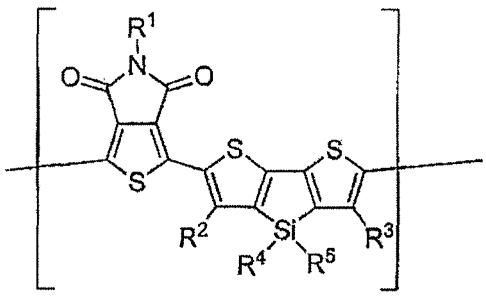

(1)

In Formula (1), $R^1$ represents an optionally substituted alkyl group, optionally substituted alkenyl group or optionally substituted aryl group, and $R^2$ to $R^5$ each independently represent a hydrogen atom, halogen atom, optionally substituted alkyl group, optionally substituted alkenyl group or optionally substituted aryl group.

The groups and atoms in the definitions of $R^1$ to $R^5$ in Formula (1) are explained in detail below. $R^1$ is an optionally substituted alkyl group, optionally substituted alkenyl group or optionally substituted aryl group.

The number of carbon atoms in $R^1$ is normally at least 1, or preferably at least 3, or more preferably at least 4, and is normally 20 or less, or preferably 16 or less, or more preferably 12 or less, or still more preferably 10 or less.

Examples of such alkyl groups include methyl, ethyl, n-propyl, iso-propyl, cyclopropyl, n-butyl, iso-butyl, tert-butyl, 3-methylbutyl, cyclobutyl, pentyl, cyclopentyl, hexyl, 2-ethylhexyl, cyclohexyl, heptyl, cycloheptyl, octyl, cyclooctyl, nonyl, cyclononyl, decyl, cyclodecyl, lauryl and cyclolauryl groups and the like. Of these, an n-propyl, iso-propyl, cyclopropyl, n-butyl, iso-butyl, tert-butyl, 3-methylbutyl, cyclobutyl, pentyl, cyclopentyl, hexyl, 2-ethylhexyl, cyclohexyl, heptyl, cycloheptyl, octyl, cyclooctyl, nonyl, cyclononyl, decyl, cyclodecyl, lauryl or cyclolauryl group is preferred, and a butyl, pentyl, hexyl, 2-ethylhexyl, cyclooctyl, nonyl, cyclononyl, decyl or cyclodecyl group is more preferred.

The alkenyl group has normally at least 2, or preferably at least 3, or more preferably at least 4 carbon atoms, and has normally no more than 20, or preferably no more than 16, or more preferably no more than 12, or still more preferably no more than 10 carbon atoms. Examples of such alkenyl groups include vinyl, propenyl, butenyl, pentenyl, hexenyl, heptenyl, octenyl, nonenyl, decenyl, undecenyl, dodecenyl, tridecenyl, tetradecenyl, pentadecenyl, hexadecenyl, heptadecenyl, octadecenyl, nonadecenyl, icosenyl and geranyl groups and the like. A propenyl, butenyl, pentenyl, hexenyl, heptenyl, octenyl, nonenyl, decenyl, undecenyl or dodecenyl group is preferred, and a butenyl, pentenyl, hexenyl, heptenyl, octenyl, nonenyl or decenyl group is more preferred.

The aryl group has normally at least 2 and normally no more than 60, or preferably no more than 20, or more preferably no more than 14 carbon atoms. Examples of such aryl groups include phenyl, naphthyl, indanyl, indenyl, fluorenyl, anthracenyl, azulenyl and other aromatic hydrocarbon groups; and thienyl, furyl, pyridyl, pyrimidyl, thiazolyl, oxazolyl, triazolyl, benzothienyl, benzofuryl, dibenzothienyl, benzothiazolyl, benzoxazolyl, benzotriazolyl and other aromatic heterocyclic groups and the like. Of these, a phenyl, naphthyl, thienyl, pyridyl, pyrimidyl, thiazolyl or oxazolyl group is preferred.

The optional substituent of the alkyl group, alkenyl group or aryl group is not particularly limited, but specific examples include halogen atoms and hydroxyl, cyano, amino, ester, alkylcarbonyl, acetyl, sulfonyl, silyl, boryl, nitryl, alkyl, alkenyl, alkynyl, alkoxy, aromatic hydrocarbon and aromatic heterocyclic groups. These may also form rings by linkage of adjacent substituents. A $C_{1-12}$ alkoxy group or $C_{1-12}$ alkyl group is desirable as an optional substituent of an aryl group in particular. Examples of halogen atoms include fluorine, chlorine, bromine and iodine atoms. Of these, a fluorine atom is preferred.

As discussed above, $R^1$ in Formula (1) is an optionally substituted alkyl group, optionally substituted alkenyl group or optionally substituted aryl group. Having these groups as $R^1$ is desirable for providing excellent solubility of the copolymer in organic solvents, and is also advantageous from the standpoint of the coating and film-forming processes. More preferably, $R^1$ is an optionally substituted alkyl group or optionally substituted aryl group. The alkyl group is a linear, branched or cyclic alkyl group. Of these, a linear or branched alkyl group is preferred. A linear alkyl group is desirable because it can improve the crystallinity of the polymer and thereby provide greater mobility, while a branched alkyl group is desirable for improving the solubility of the polymer. An optionally substituted aryl group is desirable as $R^1$ because it gives the copolymer the ability to absorb light at longer wavelengths. An optionally substituted aryl group

is also desirable as $R^1$ because it can improve the crystallinity of the polymer and thereby provide greater mobility.

$R^2$ to $R^5$ each independently represent a hydrogen atom, halogen atom, optionally substituted alkyl group, optionally substituted alkenyl group or optionally substituted aryl group. Groups similar to those described above with reference to $R^1$ can be used for the optionally substituted alkyl group, optionally substituted alkenyl group and optionally substituted aryl group. Moreover, substituents similar to those described above with reference to $R^1$ can be used for the optional substituents of the alkyl group, alkenyl group and aryl group. Examples of halogen atoms include fluorine, chlorine, bromine or iodine atoms. Of these, a fluorine atom is preferred. $R^2$ to $R^5$ may also form a ring by linkage of adjacent groups.

Of these, it is desirable that at least one of $R^2$ and $R^3$ be a halogen atom. This is desirable for improving the heat resistance, weather resistance, chemical resistance or water- and oil-repellency or the like of the copolymer.

At least one of $R^4$ and $R^5$ is preferably an optionally substituted alkyl group or aryl group, and it is particularly desirable that both $R^4$ and $R^5$ be optionally substituted alkyl or aryl groups. The reason that an alkyl group is desirable is that a linear alkyl group can give the polymer greater crystallinity, thereby improving mobility, while a branched alkyl group is desirable because it improves the solubility of the polymer, thereby facilitating film formation by a coating process. An alkyl group is desirable for at least one of $R^4$ and $R^5$ because it allows the copolymer to absorb light at longer wavelengths. For these reasons, at least one of $R^4$ and $R^5$ is preferably a $C_{1-20}$ alkyl group, and more preferably an $C_{6-20}$ alkyl group. On the other hand, an aryl group is desirable because it improves intermolecular interaction by interaction between pi-electrons, which tends to increase mobility, and because it tends to increase the stability of the dithienosilole structure.

From the standpoint of improving the durability of the copolymer by increasing steric hindrance around the silicon atoms, $R^4$ and $R^5$ are preferably optionally substituted alkyl groups, optionally substituted alkenyl groups or optionally substituted aryl groups.

From the standpoint of improving the solubility of the copolymer, $R^1$ and $R^4$ and/or $R^5$ are preferably linear or branched alkyl groups, or more preferably $R^1$, $R^4$ and $R^5$ are all linear or branched alkyl groups, or still more preferably $R^1$, $R^4$ and $R^5$ are all branched alkyl groups. A branched alkyl group here is preferably a $C_{3-20}$ alkyl group, or more preferably a $C_{6-20}$ alkyl group.

From the standpoint of strengthening interactions between copolymer molecules, $R^1$ and $R^4$ and/or $R^5$ are preferably linear alkyl groups or aryl groups, and more preferably $R^1$, $R^4$ and $R^5$ are all linear alkyl groups or aryl groups. Having $R^1$, $R^4$ and $R^5$ be aryl groups is especially desirable for improving mobility, and having $R^1$, $R^4$ and $R^5$ be linear alkyl groups is especially desirable because it may allow the copolymer to absorb light at longer wavelengths. A linear alkyl group here is preferably a $C_{1-20}$ alkyl group, or more preferably a $C_{6-20}$ alkyl group.

The copolymer of the present invention may contain one kind or two or more kinds of the repeating unit represented by Formula (1). In this case, the number of kinds of repeating units is not particularly limited, but is normally 8 or less, or preferably 5 or less. Another repeating unit may also be included as long as it does not detract from the effects of the present invention.

Preferred specific examples of the copolymer of the present invention are given here, but the present invention is not limited to these examples. $C_8H_{17}$, $C_6H_{13}$ and $C_4H_9$ are linear alkyl groups with specific numbers of carbon atoms. When the copolymer of the present invention has a plurality of repeating units, the ratios of the plurality of repeating units are optional.

[Chemical Formula 3]

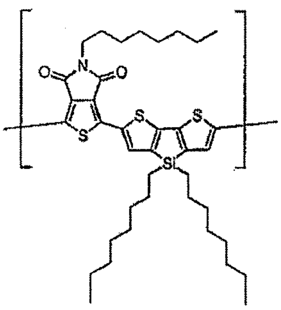
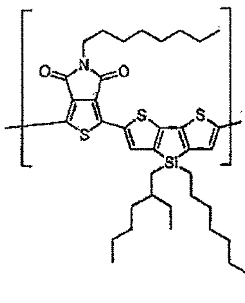
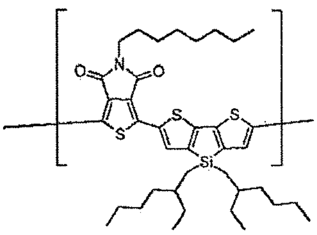
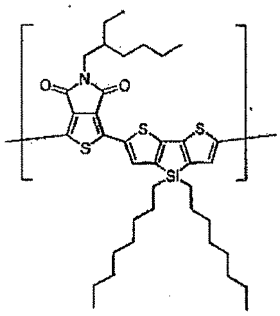
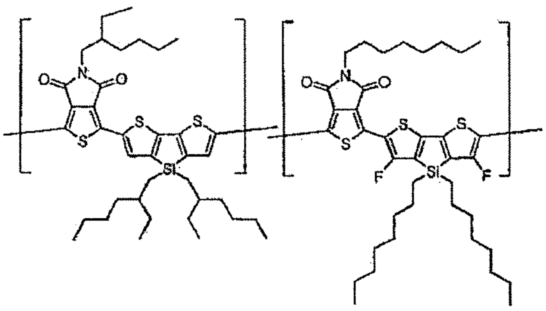
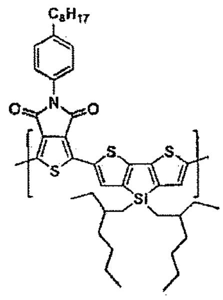
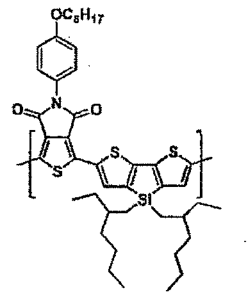

[Chemical Formula 4-1]

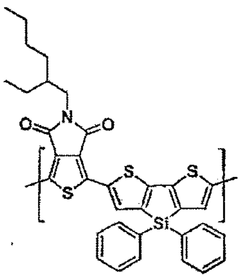
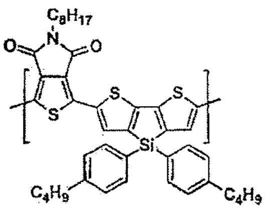
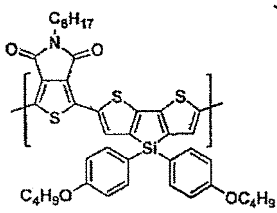
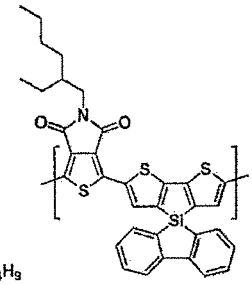
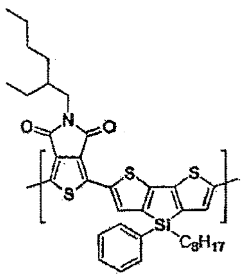
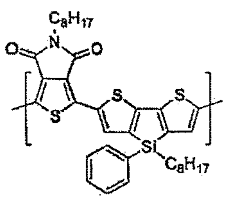
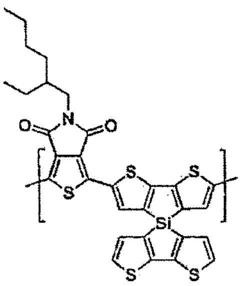
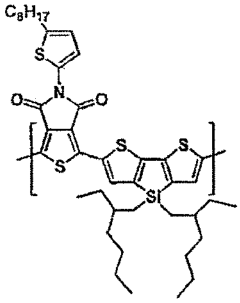

[Chemical Formula 4-2]

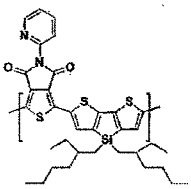
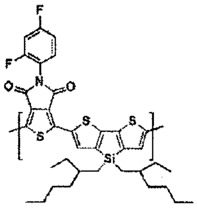
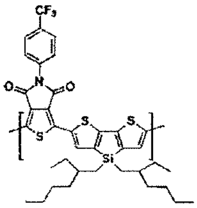
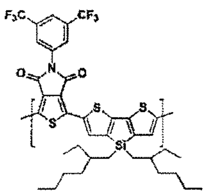
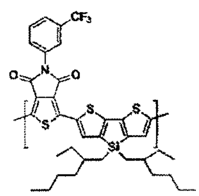

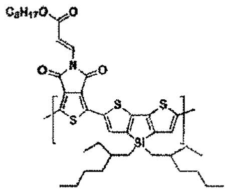
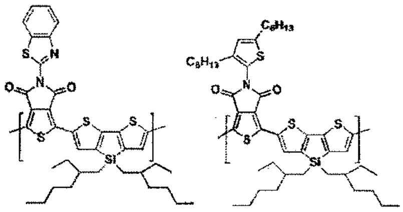
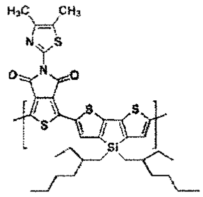
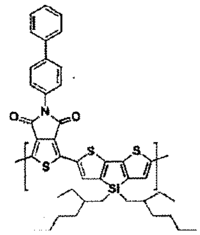

[Chemical Formula 4-3]

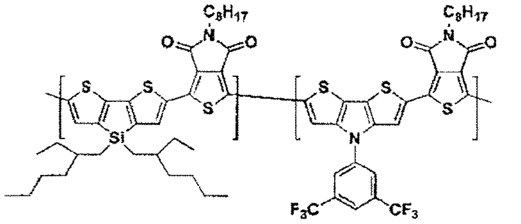
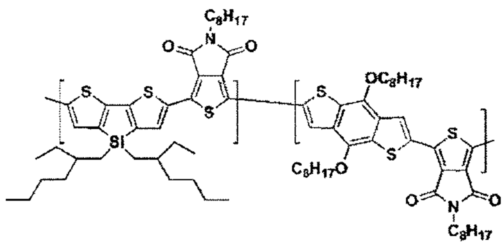

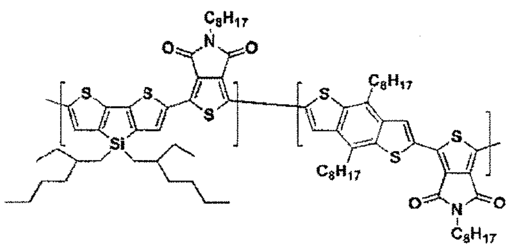
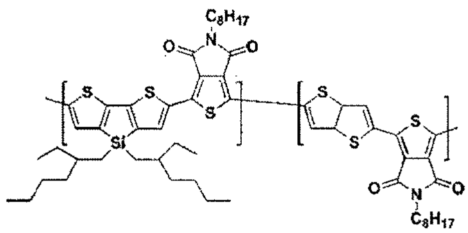

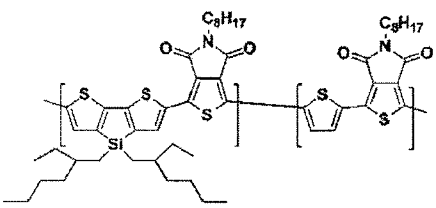
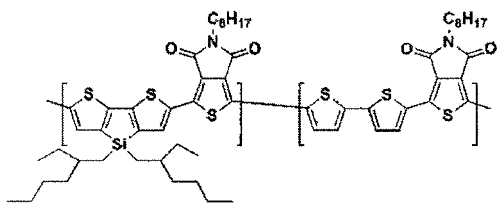

[Chemical Formula 4-4]

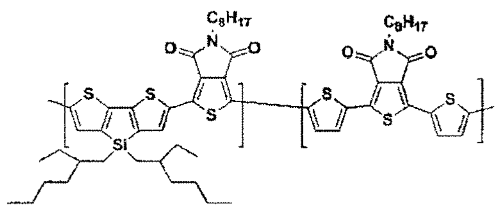

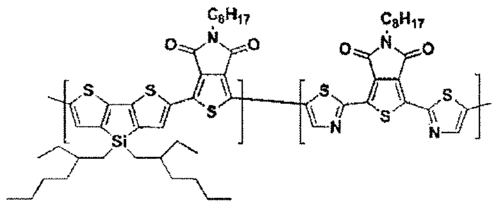

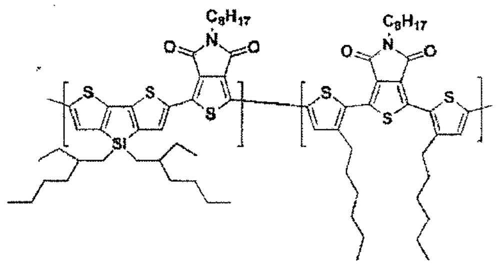

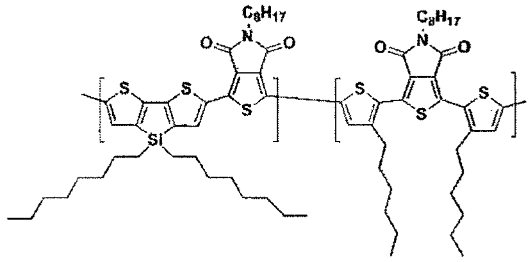

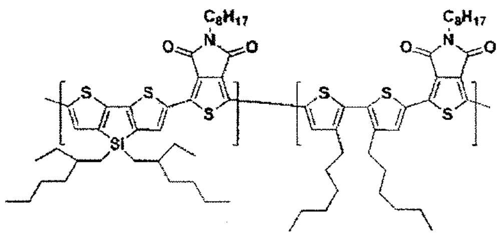

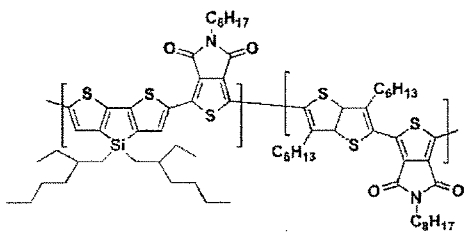

[Chemical Formula 4-5]

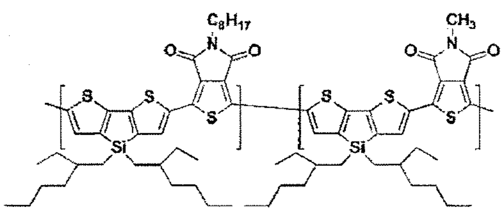

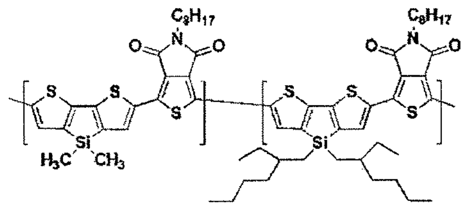

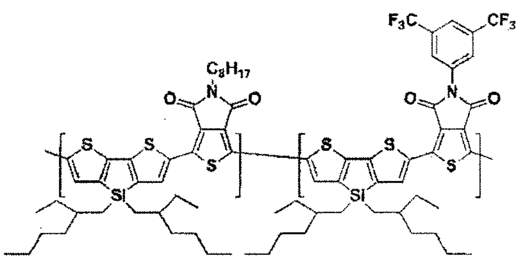

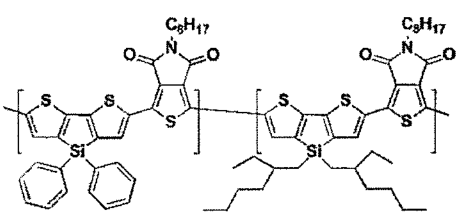

[Chemical Formula 4-6]

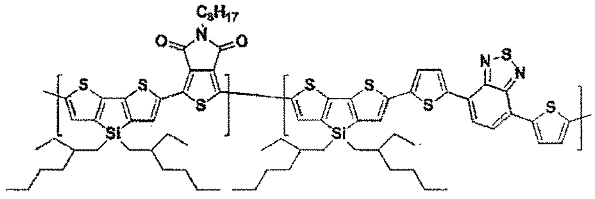
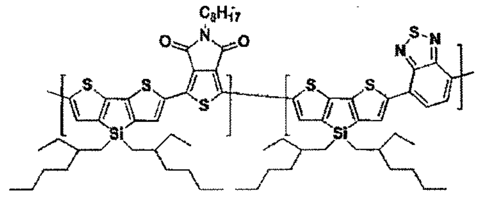
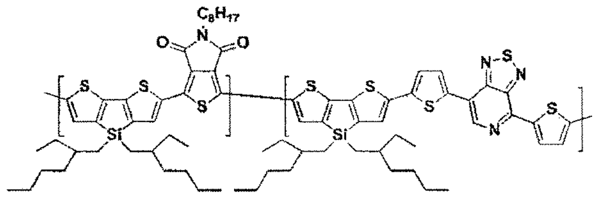
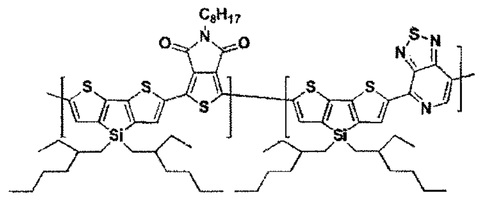

[Chemical Formula 4-7]

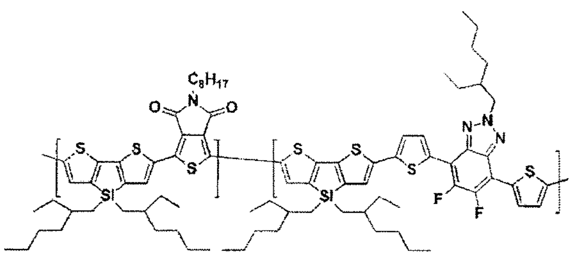
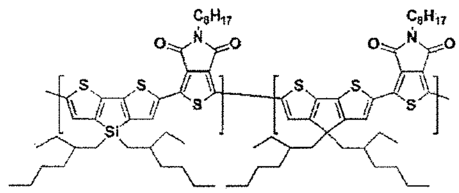
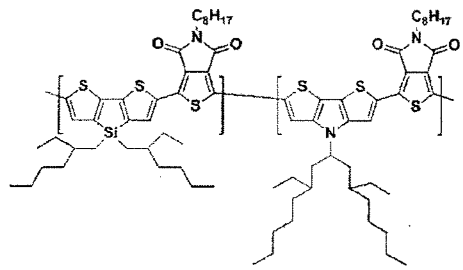
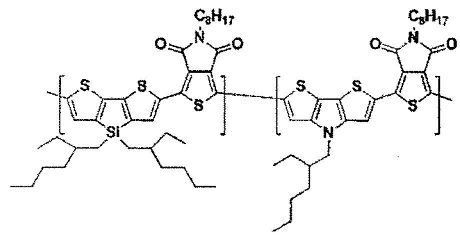

Because the copolymer of the present invention explained above has absorption in the long wavelength range (600 nm or above) and exhibits high open voltage (Voc), it has the advantage of superior photoelectric conversion properties, and exhibits particularly good solar cell properties when applied to a solar cell in combination with a fullerene compound. Other advantages are a low HOMO level and resistance to oxidation.

The copolymer of the present invention also has the advantage of high solubility. It can improve the film quality of the formed organic semiconductor layer because it has high solvent solubility during coating and film formation and/or a wider range of possible solvents, thereby making it possible to use a solvent suited to the coating and film-forming conditions. It is thought that this is one reason why a solar cell using this copolymer exhibits superior solar cell properties.

The weight-average molecular weight (Mw) of the copolymer of the present invention (polystyrene conversion) is normally at least $2 \times 10^3$, or preferably at least $5 \times 10^3$, or more preferably at least $1 \times 10^4$, or still more preferably at least $2 \times 10^4$, or yet more preferably at least $3.0 \times 10^4$, or especially at least $4.0 \times 10^4$. Moreover, it is preferably $1 \times 10^7$ or less, or more preferably $1 \times 10^6$ or less, or still more preferably $9 \times 10^5$ or less, or yet more preferably $5 \times 10^5$ or less, or especially $1 \times 10^5$ or less, or most preferably $8 \times 10^4$ or less, or ideally $6 \times 10^4$ or less. This range is desirable for achieving longer light absorption wavelengths and higher absorbancy.

The weight-average molecular weight of the copolymer of the present invention (polystyrene conversion) can be determined by gel permeation chromatography (GPC). Specifically, it can be measured using Shim-pack columns (Shimadzu Corporation: GPC-803, GPC-804, inner diameter 8.0 mm, length 30 cm) connected one by one in a series, with a LC-10AT pump, a CTO-10A oven, and a refractive index detector (Shimadzu Corporation: RID-10A) and a UV-vis detector (Shimadzu Corporation: SPD-10A) as the detecting equipment. The copolymer to be measured is dissolved in tetrahydrofuran (THF), and 5 $\mu$L of the resulting solution is injected into a column. Using THF as the mobile phase, measurement is performed at a flow rate of 1.0 mL/min. LC-Solution (Shimadzu Corporation) is used for analysis.

The number-average molecular weight (Mn) of the copolymer of the present invention is normally at least $1.0 \times 10^3$, or preferably at least $3.0 \times 10^3$, or more preferably at least $5.0 \times 10^3$, or still more preferably at least $1.0 \times 10^4$, or yet more preferably at least $1.5 \times 10^4$, or especially at least $2.0 \times 10^4$, or most preferably at least $2.5 \times 10^4$. Moreover, it is preferably $1 \times 10^8$ or less, or more preferably $1 \times 10^7$ or less, or still more preferably $9 \times 10^6$ or less. A number-average molecular weight within this range is desirable from the standpoint of increasing the light absorption wavelengths, and for achieving a higher absorbancy. The number-average molecular weight of the copolymer of the present invention can be measured by methods similar to those used for measuring weight-average molecular weight above.

The molecular weight distribution of the copolymer of the present invention (PDI: weight-average molecular weight/number-average molecular weight (Mw/Mn)) is normally at least 1.0, or preferably at least 1.1, or more preferably at least 1.2, or still more preferably at least 1.3. Moreover, it is preferably 20.0 or less, or more preferably 15.0 or less, or still more preferably 10.0 or less. A molecular weight distribution within this range is desirable because within this range, the solubility of the copolymer may be within a range suited to coating. The molecular weight distribution of the copolymer of the present invention can be measured by methods similar to those used for measuring weight-average molecular weight above.

The maximum absorption wavelength ($\lambda_{max}$) of the copolymer of the present invention is normally at least 470 nm, or preferably at least 480 nm, and is normally 1,200 nm or less, or preferably 1,000 nm or less, or more preferably 900 nm or less. The half-value width is normally at least 10 nm, or preferably at least 20 nm, and is normally 300 nm or less. When the copolymer of the present invention is used for a solar cell application, the absorption wavelength range of the copolymer preferably matches the absorption wavelength range of sunlight as closely as possible.

The solubility of the copolymer of the present invention is not particularly limited, but its solubility in chlorobenzene at 25° is normally at least 0.1 wt%, or preferably at least 0.5 wt%, or more preferably at least 1 wt%, and is normally 30 wt% or less, or preferably 20 wt% or less. A higher degree of solubility is desirable because it allows a film to be formed with a greater thickness.

Solvents that can be used in film formation as discussed below are not particularly limited as long as they can uniformly dissolve or disperse the copolymer, but examples include aliphatic hydrocarbons such as hexane, heptane, octane, isooctane, nonane or decane; aromatic hydrocarbons such as toluene, xylene, chlorobenzene or o-dichlorobenzene; lower alcohols such as methanol, ethanol or propanol; ketones such as acetone, methyl ethyl ketone, cyclopentanone or cyclohexanone; esters such as ethyl acetate, butyl acetate or methyl lactate; halogen hydrocarbons such as chloroform, methylene chloride, dichloroethane, trichloroethane or trichloroethylene; ethers such as ethyl ether, tetrahydrofuran or dioxane; and amides such as dimethylformamide or dimethylacetamide and the like. Of these, an aromatic hydrocarbon such as toluene, xylene, chlorobenzene or o-dichlorobenzene or a halogen hydrocarbon such as chloroform, methylene chloride, dichloroethane, trichloroethane or trichloroethylene is preferred.

The copolymer of the present invention is one in which there are intermolecular interactions. In this Description, intermolecular interactions means that the distance between polymer chains is reduced by pi-pi stacking interactions and the like between molecules. Stronger interactions tend to produce greater mobility and/or crystallinity. That is, it is thought that because electron movement between molecules is more likely to occur in a copolymer with intermolecular interactions, the holes generated in active layer 103 at the boundary with a mixed layer of a p-type semiconductor and a n-type semiconductor can be transported efficiently to the electrode (anode) 101 when this copolymer is used in the active layer 103 in the photoelectric conversion element discussed below.

One method of measuring crystallinity is by X-ray diffraction (XRD). Having crystallinity in this Description means that the X-ray diffraction spectrum obtained by XRD has a diffraction peak. A copolymer having a diffraction peak near $2\theta = 4.8°$ ($4.8° \pm 1.5°$) is preferred.

Having crystallinity here is thought to mean that the molecules align with each other to form layered structures, which is desirable because it may make it possible to increase the film thickness of the active layer. XRD may be performed based on the methods described in known literature (A Practical Guide for X-ray Crystal Structure Analysis (Applied Physics Library Vol. 4)).

The hole mobility of the copolymer of the present invention (sometimes called hole mobility) is normally at least $1.0 \times 10^{-7}$ $cm^2/Vs$, or preferably at least $1.0 \times 10^{-6}$ $cm^2/Vs$, or more preferably at least $1.0 \times 10^{-5}$ $cm^2/Vs$, or still more preferably at least $1.0 \times 10^{-4}$ $cm^2/Vs$. Also, the hole mobility of the copolymer of the present invention is normally $1.0 \times 10^4$ $cm^2/Vs$ or less, or preferably $1.0 \times 10^3$ $cm^2/Vs$ or less, or more preferably $1.0 \times 10^2$ $cm^2/Vs$ or less, or especially $1.0 \times 10$ $cm^2/Vs$ or less. The balance between the mobility of the n-type semiconductor compound and the mobility of the copolymer is important for obtaining high conversion efficiency. The hole mobility of the copolymer of the present invention is preferably within this range in order to bring the hole mobility of the copolymer of the present invention (which is used as a p-type semiconductor compound) closer to the hole mobility of the n-type semiconductor compound. One way of measuring hole mobility is by the FET method. The FET method may be carried out by methods described in

known literature (Japanese Patent Application Publication No. 2010-045186).

The copolymer of the present invention preferably contains as few impurities as possible. In particularly, if palladium, copper and other transition metal catalysts remain in the copolymer they may inhibit charge movement by causing exciton traps due to the heavy atom effect of the transition metal, thereby reducing the photoelectric conversion efficiency when the copolymer is used in a photoelectric conversion element. The concentration of transition metal catalysts is normally 1,000 ppm or less, or preferably 500 ppm or less, or more preferably 100 ppm or less per 1 g of copolymer. However, it is normally greater than 0 ppm, or preferably at least 1 ppm, or more preferably at least 3 ppm.

In the copolymer, the residual amount of the constituent atoms of terminal residues (X and Y in Formulae (2) and (3) below) is not particularly limited, but is normally 6,000 ppm or less or preferably 4,000 ppm or less or more preferably 3,000 ppm or less or still more preferably 2,000 ppm or less or yet more preferably 1,000 ppm or less or especially 500 ppm or less or most preferably 200 ppm or less per 1 g of the copolymer. On the other hand, it is normally greater than 0 ppm, or preferably 1 ppm or more, or more preferably 3 ppm or more.

In particular, the residual amount of Sn atoms in the copolymer is normally 5,000 ppm or less, or preferably 4,000 ppm or less, or more preferably 2,500 ppm or less, or still more preferably 1,000 ppm or less, or yet more preferably 750 ppm or less, or especially 500 ppm or less, or most preferably 100 ppm or less per 1 g of the copolymer. On the other hand, it is normally more than 0 ppm, or preferably at least 1 ppm, or more preferably at least 3 ppm. A residual amount of 5,000 ppm or less of Sn atoms is desirable because the residual amount of Sn atoms in alkylstannyl groups (which are vulnerable to thermal decomposition) is reduced, resulting in superior performance from the standpoint of stability.

The residual amount of halogen atoms per 1 g of copolymer is normally 5,000 ppm or less, or preferably 4,000 ppm or less, or more preferably 2,500 ppm or less, or still more preferably 1,000 ppm or less, or yet more preferably 750 ppm or less, or especially 500 ppm or less, or most preferably 100 ppm or less. On the other hand, it is normally more than 0 ppm, or preferably at least 1 ppm, or more preferably at least 3 ppm. A residual amount of 5,000 ppm or less of halogen atoms is desirable because it tends to improve the photoelectrical conversion efficiency, durability and other properties of the copolymer.

The residual amount of constituent atoms of terminal residues (X and Y below) in the copolymer can be determined by measuring the amount of elements other than carbon, hydrogen and nitrogen. As a measurement method, elemental analysis of the resulting polymers can be performed by ICP mass spectrometry for Pd and Sn, and also by ICP mass spectrometry for boron ions ($Br^-$) and iodine ions ($I^-$).

ICP mass spectrometry can be performed by the methods described in known literature ("Inductively Coupled Plasma Mass Spectrometry" (Gakkai Shuppan Center)). Specifically, Pd and Sn can be measured subjecting a sample to wet decomposition, and assaying the Pd and Sn in the decomposition liquid by a calibration curve method using an ICP mass spectrometer (Agilent Technologies, Inc. 7500ce ICP mass spectrometer). Meanwhile, $Br^-$ and $I^-$ can be measured by burning a sample in a sample burner (MITSUBISHI CHEMICAL ANALYTECH CO., LTD. QF-02 sample burner), absorbing the combustion gas with an alkali absorbing solution containing a reducing agent, and assaying the $Br^-$ and $I^-$ in the absorbing solution by a calibration curve method using an ICP mass spectrometer (Agilent Technologies, Inc. 7500ce ICP mass spectrometer).

[1-2. Method of producing copolymer of the present invention]

The method of producing the copolymer of the present invention is not particularly limited, and it can be produced by known methods using an imidothiophene derivative and a dithienosilole derivative for example. An example of a preferred method is a method of polymerizing the imidothiophene derivative compound represented by General Formula (2) below and the dithienosilole compound represented by General Formula (3) below in the presence of a suitable catalyst as necessary.

[Chemical Formula 5]

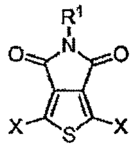
(2)

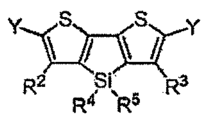
(3)

In Formula (2), $R^1$ is defined as before, while in Formula (3), $R^2$ to $R^5$ are defined as before.
X and Y each independently represent a halogen atom, alkylstannyl group, alkylsulfo group, arylsulfo group, arylalkylsulfo

group, boric acid ester residue, sulfonium methyl group, phosphonium methyl group, phosphonate methyl group, monohalogenated methyl group, boric acid residue ($-B(OH)_2$), formyl group, alkenyl group or alkynyl group. For purposes of synthesizing the compounds represented by Formulae (2) and (3) above and for ease of the reaction, X and Y are preferably each independently a halogen atom, alkylstannyl group, or boric acid residue ($-B(OH)_2$). In X and Y, a halogen atom is preferably a bromine atom or iodine atom.

Examples of boric acid ester residues include the groups represented by the following formulae for example:

[Chemical Formula 6]

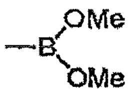 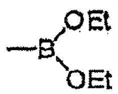 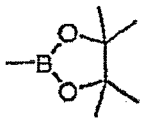 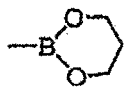 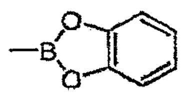

(in the formulae, Me represents a methyl group and Et represents an ethyl group).
Examples of alkylstannyl groups include the groups represented by the following formulae and the like:

[Chemical Formula 7-1]

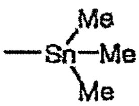 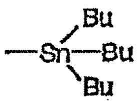

Examples of alkenyl groups include $C_{2-12}$ alkenyl groups for example.
Reaction methods used for polymerizing the copolymer of the present invention include the Suzuki-Miyaura cross-coupling reaction method, the Stille coupling reaction method, the Yamamoto coupling reaction method, the Grignard reaction method, the Heck reaction method, the Sonogashira reaction method, reaction methods using $FeCl_3$ and other oxidizing agents, methods using electrochemical oxidation reactions, and reaction methods by decomposition of intermediate compounds having suitable leaving groups. Of these, the Suzuki-Miyaura cross-coupling reaction method, Stille coupling reaction method, Yamamoto coupling reaction method and Grignard reaction method are preferred for ease of structural control. In particular, the Suzuki-Miyaura cross-coupling reaction method, Stille coupling reaction method and Grignard reaction method are preferred from the standpoint of availability of materials and simplicity of the reaction operations. These reactions can be carried out in accordance with the methods described in known literature, such as "CROSS-COUPLING REACTIONS: BASIC CHEMSTRY AND INDUSTRIAL APPLICATIONS" (CMC Publishing CO., LTD.), "Yuukigousei no tame no senikinzokusyokubaihannou (Transition Metal Catalyst Reactions for Organic Synthesis)" (Tsuji Jiro, The Society of Synthetic Organic Chemistry, Japan), and "Yuukigousei no tame no syokubaihannou (Catalyst Reactions for Organic Synthesis) 103" (Hiyama Temjiro, Tokyo Kagaku Dojin Co., Ltd.) and the like. The Stille coupling reaction method is discussed below.

When using the Stille coupling reaction method, X is preferably a halogen atom while Y is an alkylstannyl group, or X is preferably an alkylstannyl group while Y is a halogen atom in General Formula (2) and General Formula (3) above.

The imidothiophene derivative (imidothiophene monomer) of Formula (2), which is used as a raw material in the polymerization reaction, can be manufactured according to the methods described in J. Am. Chem. Soc., 2010, 132 (22), 7595-7597. The dithienosilole derivative (dithienosilole monomer) of Formula (3) can be manufactured according to the methods described in J. Mater. Chem., 2011, 21, 3895 and J. Am. Chem. Soc. 2008, 130, 16144-16145.

The ratio of the amount of the dithienosilole derivative represented by Formula (3) to the imidothiophene derivative represented by Formula (2) (molar ratio conversion) is normally at least 0.90, or preferably at least 0.95, and is normally 1.3 or less, or preferably 1.2 or less. This range is desirable for providing a polymeric product with a higher yield.

Because the device characteristics are better if the copolymer is highly pure when the copolymer of the present invention is used as a material of an organic photoelectric conversion element, a coupling reaction is preferably performed after the monomers before polymerization (the imidothiophene derivative compound represented by General Formula (2) and the dithienosilole derivative represented by General Formula (3)) have been purified by a method such as distillation, sublimation, column chromatography or recrystallization.

When the copolymer of the present invention is used as a material of an organic photoelectric conversion element, the purity of the monomers is normally at least 90%, or preferably at least 95%. The higher the purity of the monomers, the better the device characteristics of the photoelectric conversion element containing the copolymer of the

present invention.

For the polymerization, a transition metal catalyst or the like is added to accelerate the polymerization. The transition metal catalyst can be selected according to the type of polymerization, but is preferably one that dissolves thoroughly in the solvent used in the polymerization reaction.

The transition metal catalyst may be a palladium (Pd) catalyst such as tetrakis(triphenylphosphine)palladium ($Pd(PPh_3)_4$), tris(dibenzylideneacetone)dipalladium ($Pd_2(dba)_3$) or another 0-valent palladium catalyst or bis(triphenylphosphine)palladium chloride ($PdCl_2((PPh_3))_2$), palladium acetate or another bivalent palladium catalyst or the like; a nickel catalyst such as $Ni(dppp)Cl_2$ or $Ni(dppe)Cl_2$; an iron catalyst such as iron chloride; or an iodine catalyst such as copper iodide or the like.

When a Pd complex is used as a 0-valent Pd catalyst, specific examples include $Pd(PPh_3)_4$, $Pd(P(o\text{-tolyl})_3)_4$, $Pd(PCy_3)_2$, $Pd_2(dba)_3$, $PdCl_2(PPh_3)_2$ and the like (in the formulae, Ph represents a phenyl group, Cy represents a cyclohexyl group, and o-tolyl represents a 2-tolyl group). When a bivalent Pd complex such as $PdCl_2(PPh_3)_2$ or palladium acetate is used, it is preferably used in combination with an organic ligand such as $PPh_3$ or $P(o\text{-tolyl})_3$.

For the transition metal catalyst, normally at least $1 \times 10^{-4}$ mol%, or preferably at least $1 \times 10^{-3}$ mol%, or more preferably at least $1 \times 10^{-2}$ mol%, and is normally $1 \times 10^{2}$ mol% or less, or preferably 5 mol% or less of palladium complex is used relative to the total of the imidothiophene derivative represented by Formula (2) and the dithienosilole derivative represented by Formula (3). An amount of catalyst within this range is desirable from the standpoint of low cost and high efficiency, and for obtaining a copolymer with a higher molecular weight.

When using a transition metal catalyst, an alkali, co-catalyst or phase transfer catalyst may also be used.

Examples of alkalis include potassium carbonate, sodium carbonate, cesium carbonate and other inorganic bases and triethylamine and other organic bases.

Examples of co-catalysts include cesium fluoride, copper oxide, copper halide or other inorganic salts. The amount of the co-catalyst used is normally at least $1 \times 10^{-4}$ mol%, or preferably at least $1 \times 10^{-3}$ mol%, or more preferably at least $1 \times 10^{-2}$ mol%, and is normally $1 \times 10^{4}$ mol% or less, or preferably $1 \times 10^{3}$ mol% or less, or more preferably $1.5 \times 10^{2}$ mol% or less of the imidothiophene derivative represented by Formula (2). An amount of co-catalyst within this range is desirable for obtaining a copolymer with a lower cost and higher yield.

Examples of phase transfer catalysts include tetraethyl ammonium hydroxide, Aliquat 336 (Aldrich) and the like. The amount of the phase transfer catalyst used is normally at least $1 \times 10^{-4}$ mol%, or preferably at least $1 \times 10^{-3}$ mol%, or more preferably at least $1 \times 10^{-2}$ mol% and is normally 5 mol% or less or preferably 3 mol% or less of the imidothiophene derivative represented by Formula (2). An amount of phase transfer catalyst within this range is desirable for obtaining a copolymer with a lower cost and higher yield.

Examples of the solvent used in the polymerization reaction include saturated hydrocarbons such as pentane, hexane, heptane, octane or cyclohexane; aromatic hydrocarbons such as benzene, toluene, ethylbenzene or xylene; halogenated aromatic hydrocarbons such as chlorobenzene, dichlorobenzene or trichlorobenzene; alcohols such as methanol, ethanol, propanol, isopropanol, butanol or t-butyl alcohol; water; ethers such as dimethyl ether, diethyl ether, methyl-t-butyl ether, tetrahydrofuran, tetrahydropyran or dioxane; and aprotic organic solvents such as DMF and the like. One kind of solvent may be used, or two or more may be combined.

The amount of the solvent used is normally at least $1 \times 10^{-2}$ mL or preferably at least $1 \times 10^{-1}$ mL or more preferably at least 1 mL and is normally $1 \times 10^{5}$ mL or less or preferably $1 \times 10^{3}$ mL or less or more preferably $2 \times 10^{2}$ mL or less per 1 g of the total of the imidothiophene derivative represented by Formula (2) and the diethenosilole derivative represented by Formula (3).

The reaction temperature is normally at least 0°C or preferably at least 20°C or more preferably at least 40°C or still more preferably at least 60°C. Moreover, it is normally 300°C or less, or preferably 250°C or less, or more preferably 200°C or less, or still more preferably 180°C or less, or most preferably 160°C or less. The heating method is not particularly limited, but may be oil bath heating, thermocouple heating, infrared heating or microwave heating, or heating by contact using an IH heater. The reaction time is normally at least 1 minute, or preferably at least 10 minutes, and is normally 160 hours or less, or preferably 120 hours or less, or more preferably 100 hours or less. The reaction is preferably performed in a nitrogen ($N_2$) or argon (Ar) atmosphere. The copolymer can be obtained more in a shorter time and with a higher yield by performing the reaction under these conditions.

There are no particular limitations on what steps are performed following the polymerization reaction, as long as they include a copolymer separation step. When the copolymer is subjected to terminal treatment, a copolymer separation step is preferably performed after terminal treatment, and more preferably copolymer terminal treatment, copolymer separation and copolymer purification are performed in that order after the polymerization reaction. Additional copolymer separation and purification can also be performed as necessary before copolymer terminal treatment.

Methods of copolymer separation include for example a method of mixing the reaction solution with a weak solvent and precipitating the copolymer, or a method of first quenching the active species in the reaction system with water or hydrochloric acid, and then extracting with an organic solvent and distilling away the organic solvent.

Methods of purifying the copolymer include known methods such as re-precipitation purification, soxhlet extraction, gel

permeation chromatography, metal removal with a scavenger or the like.

After the polymerization reaction, the copolymer is preferably subjected to terminal treatment. By terminal treating the copolymer, it is possible to reduce the residual amounts of bromine (Br), iodine (I) and other halogen atoms and alkylstannyl groups and other terminal residues (X and Y above) in the copolymer. This terminal treatment is desirable because it can provide a polymer with enhanced performance in terms of efficiency and durability.

The method of terminally treating the unpurified copolymer after the polymerization reaction is not particularly limited, but may be the following method. When the copolymer is polymerized by the Stille coupling method, the boron (Br), iodine (I) and other halogen atoms and alkylstannyl groups present in the termini of the copolymer can be subjected to terminal treatment.

As a method of terminally treating the halogen atoms of the copolymer, an aryl trialkyltin can be added as a terminal treatment agent to the reaction system, which is then heated and agitated to perform the reaction. The aryl trialkyltin may be phenyl trimethyltin, thienyl trimethyltin or the like. The added amount of the terminal treatment agent is not particularly limited, but is normally at least $1.0 \times 10^{-2}$ equivalents, or preferably at least 0.1 equivalents, or more preferably at least 1 equivalent of the monomers with the terminal-added halogen atoms. Also, it is normally 50 equivalents or less, or preferably 20 equivalents or less, or more preferably 10 equivalents or less.

The reaction temperature for the terminal treatment of the halogen atoms in the copolymer is normally at least 0°C, or preferably at least 20°C, or more preferably at least 40°C, or still more preferably at least 60°C. Moreover, it is normally 300°C or less, or preferably 250°C or less, or more preferably 200°C or less, or still more preferably 180°C or less, or most preferably 160°C or less. The heating method is not particularly limited, but may be oil bath heating, thermocouple heating, infrared heating or microwave heating, or heating by contact using an IH heater or the like.

The reaction time for terminal treatment of the halogen atoms in the copolymer is not particularly limited, but it is normally at least 30 minutes, or preferably at least 1 hour, and is normally 50 hours or less, or preferably 20 hours or less. Terminal treatment can be accomplished in a short time and with a high conversion rate when the reaction is performed under these conditions.

Terminally treating the halogen atoms of the copolymer is desirable because aryl groups are substituted for the termini, thereby making the copolymer more stable by the conjugation stabilization effect.

The method of terminally treating the alkylstannyl groups of the copolymer may be a method of first adding an aryl halide as a terminal treatment agent to the reaction system, which is then heated and agitated to perform the reaction. The aryl halide may be iodothiophene, iodobenzene, bromothiophene or bromobenzene for example. The added amount of the terminal treatment agent is not particularly limited, but is normally at least $1.0 \times 10^{-2}$ equivalents, or preferably at least 0.1 equivalents, or more preferably at least 1 equivalent, and is normally no more than 50 equivalents, or preferably no more than 20 equivalents, or more preferably no more than 10 equivalents of the monomers with the terminal-added alkylstannyl groups. The reaction temperature or reaction conditions for the alkylstannyl groups of the copolymer are similar to the terminal treatment conditions for the halogen atoms of the copolymer. Terminal treatment can be accomplished in a short time and with high conversion efficiency by performing the reaction under these conditions.

When the alkylstannyl groups of the copolymer are terminal treated and aryl groups are substituted at the termini, the Sn atoms of the alkylstannyl groups (which are vulnerable to thermal decomposition) are no longer present in the polymer, and it should thus be possible to control deterioration of the copolymer over time. The reason why aryl groups are substituted at the termini is that this is desirable for obtaining greater stability of the copolymer by the conjugation stabilization effect.

The terminal treatment operations described above are preferably performed independently, although this is not a limitation. The operating procedures for each kind of terminal treatment are not particularly limited, and may be selected appropriately.

The terminal treatment operations may be performed either before copolymer purification or after copolymer purification.

When terminal treatment is performed after copolymer purification, the copolymer and one of the terminal treatment agents (aryl halide or aryl trimethyltin) can be dissolved in an organic solvent, after which a palladium catalyst or other transition metal catalyst is added, heating and agitation are performed under nitrogen conditions, the other terminal treatment agent (aryl triemthyltin or aryl halide) is added, and the mixture is heated and agitated to perform treatment. This treatment is desirable because it can efficiently remove the terminal residues in a short time.

The added amount of the palladium catalyst or other transition metal catalyst is not particularly limited, but is normally at least $5.0 \times 10^{-3}$ equivalents, or preferably at least $1.0 \times 10^{-2}$ equivalents, and is normally no more than $1.0 \times 10^{-1}$ or preferably no more than $5.0 \times 10^{-2}$ equivalents of the copolymer. Termination treatment can be accomplished at a lower cost and with a higher conversion efficiency if the added amount of the catalyst is within this range.

The added amount of the terminal treatment agent for the alkylstannyl groups of the purified copolymer is not particularly limited, but is normally at least $1.0 \times 10^{-2}$ or preferably at least $1.0 \times 10^{-1}$ or more preferably at least 1 equivalent, and is normally no more than 50 equivalents or preferably no more than 20 equivalents or more preferably no more than 10 equivalents of the monomers having terminal-added alkylstannyl groups. Termination treatment can be accomplished at a lower cost and with a higher conversion efficiency if the added amount of the terminal treatment agent is within this

range.

The added amount of the terminal treatment agent for the halogen groups of the purified copolymer is not particularly limited, but is normally at least $1.0 \times 10^{-2}$ or preferably at least $1.0 \times 10^{-1}$ or more preferably at least 1 equivalent, and is normally no more than 50 equivalents or preferably no more than 20 equivalents or more preferably no more than 10 equivalents of the monomers having terminal-added halogen groups. Termination treatment can be accomplished at a lower cost and with a higher conversion efficiency if the added amount of the terminal treatment agent is within this range.

The reaction time is not particularly limited, but is normally at least 30 minutes, or preferably at least 1 hour, and is normally 25 hours or less, or preferably 10 hours or less.

As discussed above, the method of purifying the copolymer after terminal treatment may be soxhlet extraction, gel permeation chromatography, metal removal with a scavenger or the like.

When the copolymer is polymerized by the Suzuki-Miyaura cross-coupling reaction method, the terminal treatment method may be one involving heating and agitation after addition of arylboronic acid.

[1-3. Organic semiconductor material containing copolymer having repeating units represented by General Formula (1)]

The copolymer of the present invention is suitable as an organic semiconductor material because of its high solvent solubility and high light absorption in long wavelength regions.

The organic semiconductor material of the present invention contains at least the aforementioned copolymer. One kind of the copolymer of the present invention may be included alone, or any combination of two or more kinds may be included. The material may consist of the copolymer of the present invention alone, or may also contain other components (for example, other polymers or monomers or various additives or the like).

The organic semiconductor material of the present invention is suitable for the organic semiconductor layer or organic active layer of the organic electronic device discussed below. In this case the organic semiconductor material is preferably formed as a film, and the aforementioned solubility in organic solvents, excellent workability and other physical properties discussed above can be used to advantage. The specifics regarding the use of the material in the organic semiconductor layer of an organic electronic device are discussed below.

The organic semiconductor material of the present invention is satisfactory by itself as the material of the organic semiconductor layer of an organic electronic device, but it can also be mixed and/or laminated with other organic semiconductor materials. Examples of other organic semiconductor materials that can be used in combination with the organic semiconductor material of the present invention include poly(3-hexylthiophene) (P3HT), poly[2,6-(4,4-bis-[2-ethylhexyl]-4H-cyclopenta[2,1-b:3,4-b']dithiophene)-alt-4,7-(2,1,3-benzothiadiazole)] (PCPDTBT), benzoporphyrin (BP) and pentacene, the known n-type semiconductor compound perylenebisimide, [6,6]-phenyl-$C_{61}$-butyric acid methyl ester ([60]PCBM) or PCBM having $C_{70}$ and other larger fullerenes, [6,6]-phenyl-$C_{61}$-butyric acid n-butyl ester ([60]PCBNB) or PCBNB having $C_{70}$ and other larger fullerenes, other fullerene derivatives, and other known organic semiconductor materials and the like, without any particular limitations.

The organic semiconductor material of the present invention exhibits semiconductor properties, and for example in field-effect mobility measurement its hole mobility is normally at least $1.0 \times 10^{-7}$ $cm^2/Vs$, or preferably at least $1.0 \times 10^{-6}$ $cm^2/Vs$, or more preferably at least $1.0 \times 10^{-5}$ $cm^2/Vs$, or still more preferably at least $1.0 \times 10^{-4}$ $cm^2/Vs$, while at the same time the hole mobility is normally $1.0 \times 10^{4}$ $cm^2/Vs$ or less, or preferably $1.0 \times 10^{3}$ $cm^2/Vs$ or less, or more preferably $1.0 \times 10^{2}$ $cm^2/Vs$ or less, or especially $1.0 \times 10$ $cm^2/Vs$ or less. Hole mobility may be measured by the FET method. The FET method can be carried out by the methods described in known literature (Japanese Patent Application Publication No. 2010-045186).

[1-4. Organic electronic device using the organic semiconductor material]

The organic electronic device of the present invention is explained below.

The organic electronic device of the present invention is formed using the organic semiconductor material of the present invention explained above. The type of organic electronic device is not particularly limited as long as the organic semiconductor material of the present invention is applicable thereto. Examples include light-emitting elements, switching elements, photoelectric conversion elements, optical sensors using photoconductivity and the like.

Examples of light-emitting elements include various light-emitting elements used in display devices. Specific examples include liquid crystal display elements, polymer-dispersed liquid crystal display elements, electronic portal imaging devices, electroluminescent elements, electrochromic elements and the like.

Specific examples of switching devices include diodes (pn junction diodes, Schottky diodes, MOS diodes, etc.), transistors (bipolar transistors, field effect transistors (FET), etc.), thyristors, and composite elements (such as TTL) and the like.

Specific examples of photoelectric conversion elements include thin-film solar cells, charge coupled devices (CCD), photomultiplier tubes, photocouplers and the like. Examples of optical sensors using photoconductivity include

optical sensors using these photoelectric conversion elements.

The organic semiconductor material of the present invention can be used in any part of an organic electronic device, without any particular limitations. In the case of a photoelectric conversion element in particular, an organic semiconductor layer containing the organic semiconductor material of the present invention is normally used in the organic active layer of an organic electronic device.

[2. Photoelectric conversion element]

The photoelectric conversion element of the present invention is a photoelectric conversion element, comprising a pair of electrodes, an active layer disposed between the electrodes, and an electron extraction layer disposed between at least one of the electrodes and the active layer, wherein the active layer contains a copolymer (copolymer of the present invention) having a repeating unit represented by General Formula (1) below:

[Chemical Formula 7-2]

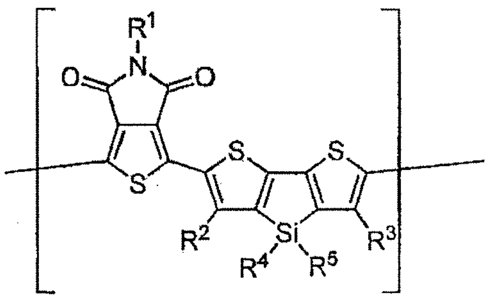

(1)

(in Formula (1), $R^1$ represents an optionally substituted alkyl group, optionally substituted alkenyl group or optionally substituted aryl group, and $R^2$ to $R^5$ each independently represent a hydrogen atom, halogen atom, optionally substituted alkyl group, optionally substituted alkenyl group or optionally substituted aryl group).

Moreover, in the photoelectric conversion element of the present invention the electron extraction layer contains a compound having an E=X group, which is represented by General Formula (E1) as explained below, and preferably contains a phosphine compound represented by General Formula (P1) having a double bond between a phosphorus atom and an atom selected from group 16 of the periodic table:

[Chemical Formula 7-3]

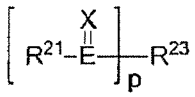

(E1)

(in Formula (E1), E represents $PR^{22}$, S, S(=O) or C; p represents an integer of 1 or greater, $R^{21}$ and $R^{22}$ each independently represent an arbitrary substituent, and $R^{21}$ and $R^{22}$ may bind to each other to form a ring; when p is 2 or greater, a plurality of $R^{21}$ and a plurality of $R^{22}$ may each independently be different, and any two or more of the plurality of $R^{21}$ and the plurality of $R^{22}$ may bind to each other to form a ring; $R^{23}$ represents an optionally substituted p-valent hydrocarbon group, an optionally substituted p-valent heterocyclic group, or a p-valent group with at least one of an optionally substituted hydrocarbon group and an optionally substituted heterocyclic group linked thereto; and X represents an atom selected from group 16 of the periodic table);

[Chemical Formula 7-4]

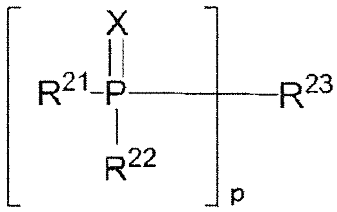

(P1)

(in Formula (P1), p represents an integer of 1 or greater, $R^{21}$ and $R^{22}$ each independently represent an arbitrary substituent, and $R^{21}$ and $R^{22}$ may bind to each other to form a ring; when p is 2 or greater, a plurality of $R^{21}$ and a plurality of $R^{22}$ may each independently be different, and any two or more of the plurality of $R^{21}$ and the plurality of $R^{22}$ may bind to each other to form a ring; $R^{23}$ represents an optionally substituted p-valent hydrocarbon group, an optionally substituted p-valent heterocyclic group, or a p-valent group with at least one of an optionally substituted hydrocarbon group and an optionally substituted heterocyclic group linked thereto; and X represents an atom selected from group 16 of the periodic table).

In this Description, the periodic table is that given in the Recommendations of IUPAC 2005.

More preferably, $R^{21}$ and $R^{22}$ are each independently an optionally substituted hydrocarbon group, optionally substituted alkoxy group or optionally substituted heterocyclic group.

In the photoelectric conversion element of the present invention, although the exact mechanism is unknown, it is thought that because the E=X group in the compound represented by General Formula (E1) in the electron extraction layer is polar, the active layer and electron extraction layer adhere more closely to each other at the boundary of the active layer by means of van der Waals force or other intermolecular force and/or dipolar interactions with polar sites of the carbonyl groups, thiophene rings or the like on the copolymer of the present invention.

It is thought that this has the effect of improving the conversion efficiency of the photoelectric conversion element.

[2-2. Structure of photoelectric conversion element]

Fig. 1 shows a photoelectric conversion element for use in an ordinary organic thin-film solar cell, but this example is not limiting. A photoelectric conversion element 107 of one embodiment of the present invention has a layered structure comprising a substrate 106, an anode 101, a hole extraction layer 102, an organic active layer 103 (mixed layer of a p-type semiconductor compound and an n-type semiconductor compound), an electron extraction layer 104 and a cathode 105, formed in that order. Other layers can be inserted between the various layers as long as this does not affect that various layer functions described below.

<2-2-1. Active layer 103>

In the photoelectric conversion element of the present invention, the active layer 103 is the layer where photoelectric conversion occurs, and contains a p-type semiconductor compound and an n-type semiconductor compound. When the photoelectric conversion element 107 receives light, the light is absorbed by the active layer 103, electricity is generated at the boundary between the p-type semiconductor compound and the n-type semiconductor compound, and the generated electricity is extracted from the electrodes 101 and 105.

The active layer 103 may use either an inorganic compound or an organic compound, but is preferably a layer than can be formed by a simple coating process. More preferably, the active layer 103 is an organic active layer consisting of an organic compound. The active layer 103 is explained as an organic active layer below.

The organic active layer may be constituted as a thin-film laminated layer comprising a p-type semiconductor compound laminated with a n-type semiconductor compound, or as a bulk heterojunction layer comprising a mixture of a p-type semiconductor compound and a n-type semiconductor compound.

In the bulk heterojunction type, as long as there is a layer comprising a mixture of p-type and n-type semiconductor compounds, there may also be another layer containing only a p-type semiconductor compound or only an n-type semiconductor compound. From the standpoint of photoelectric conversion efficiency, the active layer is preferably of the bulk heterojunction type.

(Thin-film laminated active layer)

An active layer of the thin-film laminated type has a structure comprising a p-type semiconductor layer containing a p-type semiconductor compound, laminated with an n-type semiconductor layer containing an n-type semiconductor compound. An active layer of the thin-film laminated type may be prepared by forming a p-type semiconductor layer and an n-type semiconductor layer, respectively. The p-type semiconductor layer and n-type semiconductor layer may be

formed by different methods.

(p-type semiconductor layer)

A p-type semiconductor layer is a layer containing the copolymer discussed above and/or the p-type semiconductor compound discussed below. The film thickness of the p-type semiconductor layer is not limited, but is normally at least 5 nm, or preferably at least 10 nm, and is normally 500 nm or less, or preferably 200 nm or less. A film thickness of 500 nm or less of the p-type semiconductor layer is desirable for lowering serial resistance. A film thickness of 5 nm or more of the p-type semiconductor layer is desirable because more light can be absorbed.

The p-type semiconductor layer can be formed by any method including coating methods and vapor deposition methods, but a coating method and particularly a wet coating method is preferred for forming the p-type semiconductor layer more easily. Because the copolymer of the present invention dissolves easily in solvents, it has excellent coated film-forming properties.

To prepare the p-type semiconductor layer by a coating method, it is sufficient to prepare coating solution containing the p-type semiconductor, and then coat this coating solution. Any method can be used as the coating method, but examples include spin coating, inkjet methods, doctor blade methods, drop casting methods, reverse roll coating, gravure coating, kiss coating, roll brushing methods, spray coating, air knife coating, wire bar coating, pipe doctor methods, impregnation and coating methods, curtain coating and the like. After the coating solution is coated, it can be dried by heating or the like.

The copolymer described above constitutes normally at least 50 wt% or preferably at least 70 wt% or more preferably at least 90 wt% of the p-type semiconductor compound. Because this copolymer has desirable properties as a p-type semiconductor compound, it is particularly desirable that the p-type semiconductor layer contain only the copolymer described above as a p-type semiconductor compound.

(n-type semiconductor layer)

The n-type semiconductor layer is a layer containing the n-type semiconductor compound discussed below. The film thickness of the n-type semiconductor layer is not particularly limited, but is normally at least 5 nm or preferably at least 10 nm, and is normally 500 nm or less or preferably 200 nm or less. A film thickness of 500 nm or less of the n-type semiconductor layer is desirable for lowering serial resistance. A film thickness of 5 nm or more of the n-type semiconductor layer is desirable because more light can be absorbed.

The n-type semiconductor layer can be formed by any method including coating methods and vapor deposition methods, but a coating method is preferred because it allows the n-type semiconductor layer to be formed more easily.

To prepare the n-type semiconductor layer by a coating method, it is sufficient to prepare coating solution containing the n-type semiconductor compound, and then coat this coating solution. Any method can be used as the coating method, and examples include the methods used for forming the p-type semiconductor layer. After the coating solution is coated, it can be dried by heating or the like.

(Bulk heterojunction-type active layer)

A bulk heterojunction-type active layer has a layer (i-layer) comprising a mixture of the p-type semiconductor compound and n-type semiconductor compound discussed below. The p-type semiconductor compound and n-type semiconductor compound are phase separated in the structure of the i-layer, so that carrier separation occurs at the phase interface, and the resulting carriers (holes and electrons) are transported to the electrodes.

The copolymer described above constitutes normally at least 50 wt% or preferably at least 70 wt% or more preferably at least 90 wt% of the p-type semiconductor compound contained in the i-layer. Because this copolymer has desirable properties as a p-type semiconductor compound, it is particularly desirable that the i-layer contain only the copolymer described above as a p-type semiconductor compound.

The film thickness of the i-layer is not limited. However, it is normally at least 5 nm, or preferably at least 10 nm, and is normally 500 nm or less, or preferably 200 nm or less. A film thickness of 500 nm or less of the i-layer is desirable for lowering serial resistance. A film thickness of 5 nm or more of the i-layer is desirable because more light can be absorbed.

The i-layer can be formed by any method including coating methods and vapor deposition methods (co-evaporation for example), but a coating method is preferred because it allows the i-layer to be formed more easily. Because the copolymer of the present invention dissolves easily in solvents, it has superior coated film-forming properties.

To prepare the i-layer by a coating method, it is sufficient to prepare a coating solution containing the p-type semiconductor compound and the n-type semiconductor compound, and then coat this coating solution. The coating solution containing the p-type semiconductor compound and the n-type semiconductor compound can be prepared by preparing a solution

containing the p-type semiconductor compound and a solution containing the n-type semiconductor compound and then mixing the two, and may also be prepared by dissolving the p-type semiconductor compound and the n-type semiconductor compound in the solvent discussed below. As discussed below, moreover, the i-layer may also be formed by preparing a coating solution containing a p-type semiconductor compound precursor and the n-type semiconductor compound, coating this coating solution, and then converting the p-type semiconductor compound precursor into the p-type semiconductor compound. Any method can be used as the coating method, and examples include the methods used for forming the p-type semiconductor layer. After the coating solution is coated, it can be dried by heating or the like.

When forming a bulk heterojunction-type active layer by a coating method, an additive may also be added to the coating solution containing the p-type semiconductor compound and the n-type semiconductor compound. The phase-separated structure of the p-type semiconductor compound and n-type semiconductor compound in the bulk heterojunction-type active layer affects the light absorption process, exciton diffusion process, exciton dissociation (carrier separation) process, carrier transport process and the like. Thus, it is thought that good photoelectric conversion efficiency can be achieved by optimizing the phase separation structure. It is desirable to include an additive because when the coating liquid contains an additive having different volatility from the solvent, a desirable phase separation structure is then formed during organic active layer formation, thereby improving photoelectric conversion efficiency.

Examples of additives include the compounds described in WO 2008/066933 and the like. More specific examples of additives include substituted alkanes or substituted naphthalenes and other aromatic compounds and the like. Examples of substituents include aldehyde, oxo, hydroxy, alkoxy, thiole, thioalkyl, carboxyl, ester, amine, amide, fluoro, chloro, bromo, iodo, halogen, nitrile and epoxy groups, aromatic groups and arylalkyl groups and the like. The number of substituents may be 1 or more, such as 2 for example. A substituent of an alkane is preferably a thiole group or iodo group. A substituent of a naphthalene or other aromatic compound is preferably a bromo group or chloro group.

An additive with a high boiling point is preferred, and the number of carbon atoms in an aliphatic hydrocarbon used as an additive is preferably at least 6, or more preferably at least 8. Because the additive is preferably a liquid at room temperature, the number of carbon atoms in the aliphatic hydrocarbon is preferably 14 or less, or more preferably 12 or less. For similar reasons, the number of carbon atoms in an aromatic hydrocarbon used as an additive is normally at least 6, or preferably at least 8, or more preferably at least 10, and is normally 50 or less, or preferably 30 or less, or more preferably 20 or less. The number of carbon atoms in an aromatic heterocycle used as an additive is normally at least 2, or preferably at least 3, or more preferably at least 6, and is normally 50 or less, or preferably 30 or less, or more preferably 20 or less. The boiling point of the additive is normally at least 100°C, or preferably at least 200°C, and is normally 600°C or less, or more preferably 500°C or less at normal pressure (one atmosphere).

The amount of the additive contained in the coating solution containing the p-type semiconductor compound and the n-type semiconductor compound is preferably at least 0.1 wt%, or more preferably at least 0.5 wt% of the total of the coating solution. It is also preferably 10 wt% or less, or more preferably 3 wt% or less of the total of the coating solution. If the amount of the additive is within this range, it is possible to obtain a desirable phase-separated structure while reducing the amount of the additive remaining in the organic active layer. It is thus possible to form a bulk heterojunction-type active layer by coating a coating solution (ink) containing a p-type semiconductor compound and an n-type semiconductor compound together with an additive as necessary.

(Coating solution solvent)

The solvent in the coating solution containing the p-type semiconductor compound, the coating solution containing the n-type semiconductor compound and the coating solution containing the p-type semiconductor compound and the n-type semiconductor compound is not particularly limited as long as it can uniformly dissolve the p-type semiconductor compound and/or the n-type semiconductor compound, but examples include aliphatic hydrocarbons such as hexane, heptane, octane, isooctane, nonane or decane; aromatic hydrocarbons such as toluene, xylene, mesitylene, cyclohexylbenzene, chlorobenzene or o-dichlorobenzene; alicyclic hydrocarbons such as cyclopentane, cyclohexane, methylcyclohexane, cycloheptane, cyclooctane, tetralin or decalin; lower alcohols such a methanol, ethanol or propanol; aliphatic ketones such as acetone, methyl ethyl ketone, cyclopentanone or cyclohexanone; aromatic ketones such as acetophenone or propiophenone; esters such as ethyl acetate, butyl acetate or methyl lactate; halogen hydrocarbons such as chloroform, methylene chloride, dichloroethane, trichloroethane or trichloroethylene; ethers such as ethyl ether, tetrahydrofuran or dioxane; or amides such as dimethyl formamide or dimethylacetamide.

Of these, an aromatic hydrocarbon such as toluene, xylene, mesitylene, cyclohexylbenzene, chlorobenzene or o-dichlorobenzene; an alicyclic hydrocarbon such as cyclopentane, cyclohexane, methylcyclohexane, cycloheptane, cyclooctane, tetralin or decalin; a ketone such as acetone, methyl ethyl ketone, cyclopentanone or cyclohexanone; a halogen hydrocarbon such as chloroform, methylene chloride, dichloroethane, trichloroethane or trichloroethylene; or an ether such as ethyl ether, tetrahydrofuran or dioxane is preferred. More preferred is a halogen-free aromatic hydrocarbon such as toluene, xylene, mesitylene or cyclohexylbenzene; a halogen-free ketone such as cyclopentanone or cyclohexanone; an aromatic ketone such as acetophenone or propiophenone; an alicyclic hydrocarbon such as tetrahydrofuran, cyclopentane, cyclohexane, methylcyclohexane, cycloheptane, cyclooctane, tetralin or decalin; a ketone such as acetone, methyl ethyl ketone, cyclopentanone or cyclohexanone; or a halogen-free aliphatic ether such as 1,4-dioxane or the like. Most preferred are halogen-free aromatic hydrocarbons such as toluene, xylene, mesitylene or cyclohexylbenzene.

One kind of solvent may be used alone as the solvent, or any two or more kinds of solvents may be combined in any proportions. When combining two or more kinds of solvents, it is desirable to combine a low boiling point solvent having a boiling point of 60°C to 150°C with a high boiling point solvent having a boiling point of 180°C to 250°C. Examples of combinations of a low boiling point solvent with a high boiling point solvent include a halogen-free aromatic hydrocarbon and an alicyclic hydrocarbon, a halogen-free aromatic hydrocarbon and an aromatic ketone, an ether and an alicyclic hydrocarbon, an ether and an aromatic ketone, an aliphatic ketone and an alicyclic hydrocarbon, or an aliphatic ketone and an aromatic ketone or the like. Examples of desirable combinations include toluene and tetralin, xylene and tetralin, toluene and acetophenone, xylene and acetophenone, tetrahydrofuran and tetralin, tetrahydrofuran and acetophenone, methyl ethyl ketone and tetralin, methyl ethyl ketone and acetophenone and the like.

<2-2-2. p-type semiconductor compound>

The p-type semiconductor compound of the present invention contains at least the copolymer of the present invention, but this may also be combined with another organic semiconductor material by mixing and/or lamination. Organic semiconductor materials that may be combined, such as polymeric organic semiconductor compounds and low-molecular-weight organic semiconductor compounds, are explained below.

(Polymeric organic semiconductor compounds)

There are no particular limitations on what polymeric organic semiconductor compounds can be combined in the present invention, and specific examples include polythiophene, polyfluorene, polyphenylenevinylene, polythienylenevinylene, polyacetylene or polyaniline and other conjugated copolymer semiconductor compounds, oligothiophenes substituted with alkyl groups and other substituents, and other copolymer semiconductor compounds. Other examples include copolymer semiconductor compounds obtained by copolymerizing two or more kinds of monomer units. The copolymers and derivatives thereof described in known literature such as the Handbook of Conducting Polymers, 3rd Ed. (2 volumes), 2007; Materials Science and Engineering, 2001, 32, 1-40; Pure Appl. Chem. 2002, 74, 2031-3044; and the Handbook of THIOPHENE-BASED MATERIALS (2 volumes), 2009 and the like and copolymers that can be synthesized by combining these described polymers can be used as conjugated copolymers.

One kind of compound or a mixture of a plurality of kinds may be used. Specific examples of polymeric organic semiconductor compounds that can be combined with the copolymer of the present invention include, but are not limited to, the following.

[Chemical Formula 8]

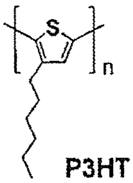

P3HT

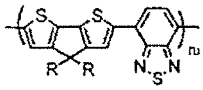

R=2-ethylhexyl

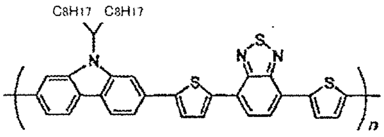

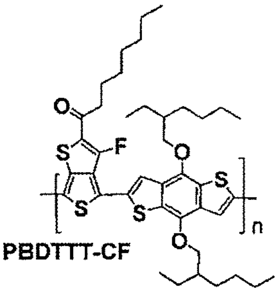

PBDTTT-CF

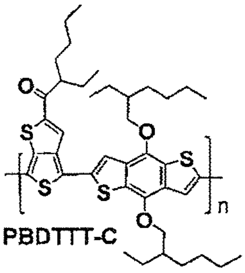

PBDTTT-C

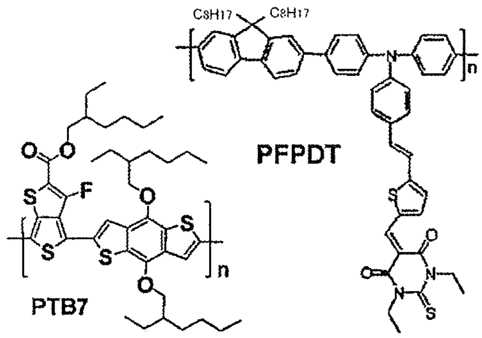

PTB7

PFPDT

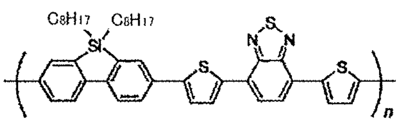

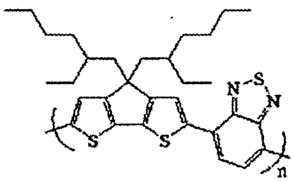

PCPDTBT

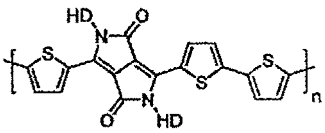

PDPP3T

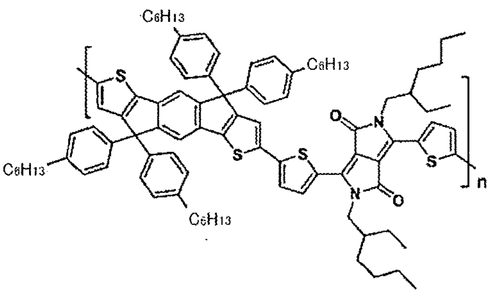

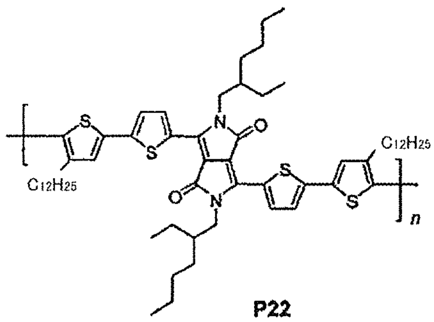

P22

[Chemical Formula 9]

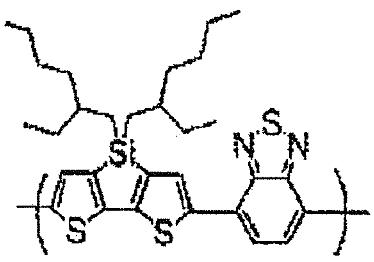

PSBTBT

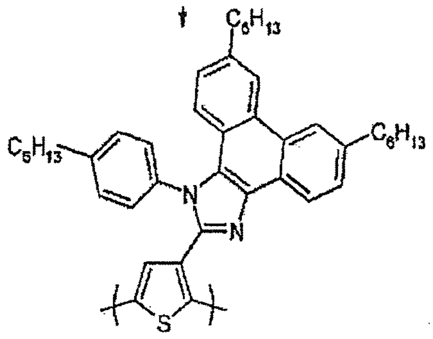

PHPIT

(Low-molecular-weight semiconductor compounds)

There are no particular limitations on what low-molecular-weight organic semiconductor compounds can be combined in the present invention, and specific examples include condensed aromatic hydrocarbons such as naphthalene, pentacene or pyrene; alpha-sexithiophene and other oligothiophenes containing 4 or more thiophene rings; those comprising a total of 4 or more linked rings of at least one kind selected from the thiophene, benzene, fluorene, naphthalene, anthracene, thiazole, thiadiazole and benzothiazole rings; and phthalocyanine compounds and metal complexes thereof, tetrabenzoporphyrin and other porphyrin compounds and metal complexes thereof, and other macrocyclic compounds and the like. Phthalocyanine compounds and metal complexes thereof or porphyrin compounds and metal complexes thereof are preferred.

Compounds having structures such as the following are examples of porphyrin compounds and metal complexes thereof (with Q being CH in the figures) and phthalocyanine compounds and metal complexes thereof (with Q being N).

[Chemical Formula 10]

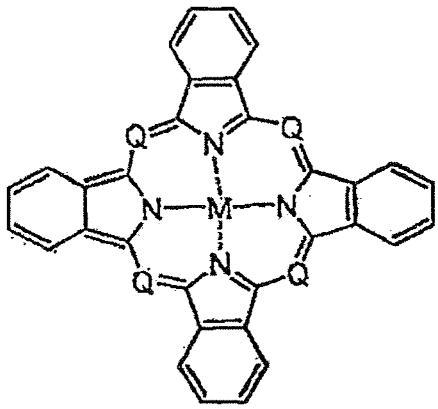

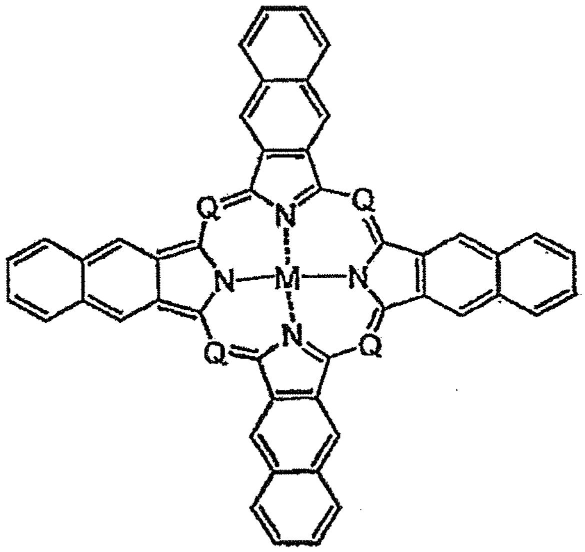

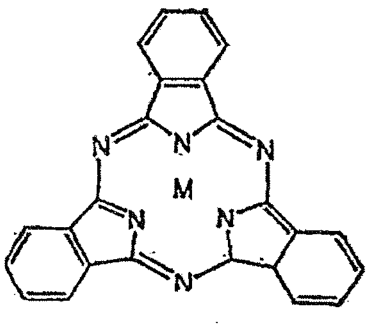

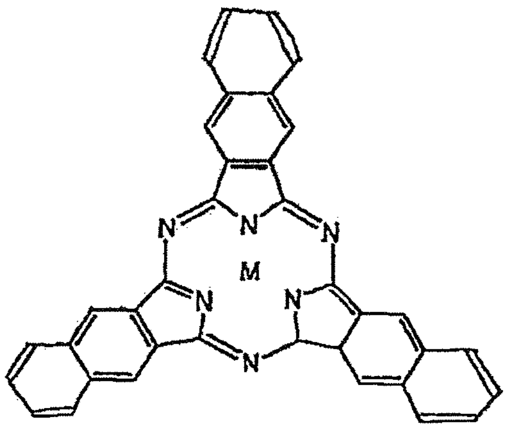

[Chemical Formula 11]

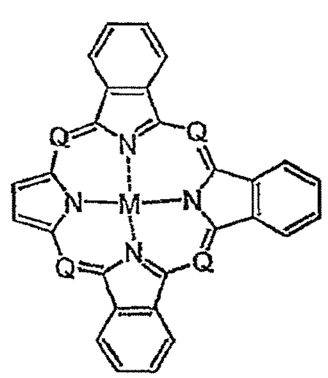
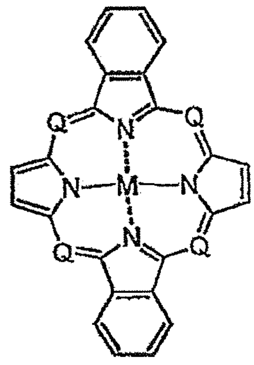

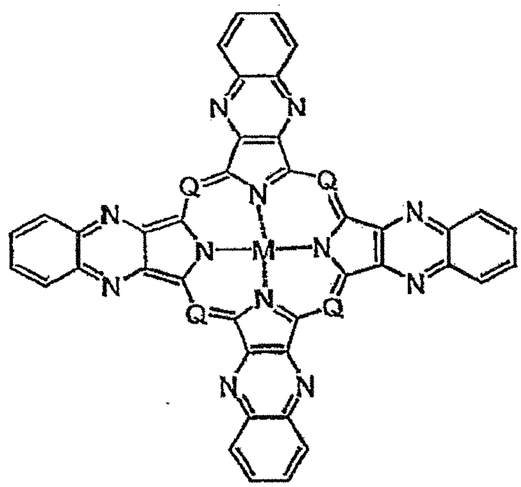

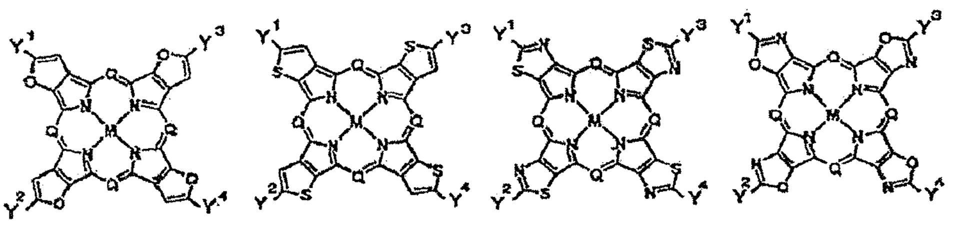

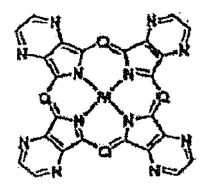
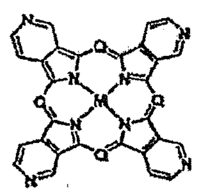
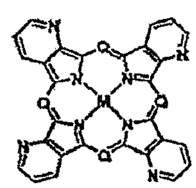

M here represents a metal or two hydrogen atoms, with the metal being Cu, Zn, Pb, Mg, Co, Ni or another bivalent metal, or a trivalent or higher metal having an axial ligand, such as TiO, VO, $SnCl_2$, AlCl, InCl, Si or the like. $Y^1$ to $Y^4$ are each independently a hydrogen atom or $C_{1-24}$ alkyl group. A $C_{1-24}$ alkyl group is a $C_{1-24}$ saturated or unsaturated chain hydrocarbon group or a $C_{3-24}$ saturated or unsaturated cyclic hydrocarbon. Of these, a $C_{1-12}$ saturated or unsaturated chain hydrocarbon group or a $C_{3-12}$ saturated or unsaturated cyclic hydrocarbon is preferred.

Of the phthalocyanine compounds and metal complexes thereof, a 29H,31H-phthalocyanine, copper phthalocyanine complex, zinc phthalocyanine complex, magnesium phthalocyanine complex, lead phthalocyanine complex, titanium phthalocyanine oxide complex, vanadium phthalocyanine oxide complex, indium phthalocyanine halogen complex, gallium phthalocyanine halogen complex, aluminum phthalocyanine halogen complex, tin phthalocyanine halogen complex, silicon phthalocyanine halogen complex, or copper 4,4',4'',4'''-tetraaza-,29H,31H-pthalocyanine complex is preferred, and a titanium phthalocyanine oxide complex, vanadium phthalocyanine oxide complex, indium phthalocyanine chloro complex or aluminum phthalocyanine chloro complex is preferred. One of these compounds or a mixture of two or more kinds may be used.

Of the porphyrin compounds and metal complexes thereof, 5,10,15,20-tetraphenyl-21H,23H-porphine, 5,10,15,20-tetraphenyl-21H,23H-porphine cobalt (II), 5,10,15,20-tetraphenyl-21H,23H-porphine copper (II), 5,10,15,20-tetraphenyl-21H,23H-porphine zinc (II), 5,10,15,20-tetraphenyl-21H,23H-porphine nickel (II), 5,10,15,20-tetraphenyl-21H,23H-porphine vanadium (IV) oxide, 5,10,15,20-tetra(4-pyridyl)-21H,23H-porphine, 29H,31H-tetrabenzo[b,g,l,q]porphine, 29H,31H-tetrabenzo[b,g,l,q]porphine cobalt (II), 29H, 31H-tetrabenzo[b,g,l,q]porphine copper (II), 29H,31H-tetrabenzo[b,g,l,q]porphine zinc (II), 29H,31H-tetrabenzo[b,g,l,q]porphine nickel (II) or 29H,31H-tetrabenzo[b,g,l,q]porphine vanadium (IV) oxide is preferred, and 5,10,15,20-tetraphenyl-21H,23H-porphine or 29H,31H-tetrabenzo[b,g,l,q] porphine is more preferred. One of these compounds or a mixture of two or more kinds may be used.

The method used to form a film of the low-molecular-weight organic semiconductor compound may be a method of film formation by vapor deposition, or a method of film formation by first coating a low-molecular-weight organic semiconductor compound precursor, and then converting it to the low-molecular-weight organic semiconductor compound. The latter is preferred because of the process advantages of coated film formation.

A low-molecular-weight organic semiconductor compound precursor is a substance that changes its chemical structure and is converted to a low-molecular-weight organic semiconductor compound in response to an external stimulus such as heat or light exposure. The low-molecular-weight organic semiconductor compound precursor of the present invention preferably has excellent film-forming properties. In particular, for coating methods to be applicable it is desirable that the precursor itself be one that can be coated in a liquid state, or that the precursor be highly soluble in some solvent so that it can be coated in a solution. To this end, the solubility of the low-molecular-weight organic semiconductor compound precursor in a solvent is normally at least 0.1 wt%, or preferably at least 0.5 wt%, or more preferably at least 1 wt%. The upper limit is not specified but is normally 50 wt% or less, or preferably 40 wt% or less.

The type of solvent is not particularly limited as long as it can uniformly dissolve or disperse the semiconductor compound precursor, but examples include aliphatic hydrocarbons such as hexane, heptane, octane, isooctane, nonane or decane; aromatic hydrocarbons such as toluene, xylene, cyclohexylbenzene, chlorobenzene or o-dichlorobenzene; lower alcohols such as methanol, ethanol or propanol; ketones such as acetone, methyl ethyl ketone, cyclopentanone or cyclohexanone; esters such as ethyl acetate, butyl acetate or methyl lactate; halogen hydrocarbons such as chloroform, methylene chloride, dichloroethane, trichloroethane or trichloroethylene; ethers such as ethyl ether, tetrahydrofuran or dioxane; and amides such as dimethylformamide or dimethylacetamide and the like. Of these, an aromatic hydrocarbon such as toluene, xylene, cyclohexylbenzene, chlorobenzene or o-dichlorobenzene; a ketone such as acetone, methyl ethyl ketone, cyclopentanone or cyclohexanone; a halogen hydrocarbon such as chloroform, methylene chloride, dichloroethane, trichloroethane or trichloroethylene; or an ether such as ethyl ether, tetrahydrofuran or dioxane is preferred. More preferred is a halogen-free aromatic hydrocarbon such as toluene, xylene or cyclohexylbenzene; a halogen-free ketone such as cyclopentanone or cyclohexanone; or a halogen-free aliphatic ether such as tetrahydrofuran or 1,4-dioxane. A halogen-free aromatic hydrocarbon such as toluene, xylene or cyclohexylbenzene is especially desirable. One kind of solvent may be used alone, or any two or more kinds may be combined in any proportions.

The low-molecular-weight organic semiconductor compound precursor is preferably one that can be easily converted into a semiconductor compound. Any kind of external stimulus may be applied to the semiconductor compound precursor in the process of converting the low-molecular-weight organic semiconductor compound precursor into a semiconductor compound, but normally heat treatment, light treatment or the like is performed. Heat treatment is preferred. In this case, a group that has affinity for a specific solvent and can be disassociated by a reverse Diels-Alder reaction is preferably present in part of the structure of the low-molecular-weight organic semiconductor compound precursor.

The low-molecular-weight organic semiconductor compound precursor is preferably converted to a semiconductor compound with high yield via a conversion process. The yield of the semiconductor compound obtained by conversion from the low-molecular-weight organic semiconductor compound precursor is not limited as long as it does not detract from the performance of the organic photoelectric conversion element, but the yield of a low-molecular-weight organic semiconductor compound obtained from the low-molecular-weight organic semiconductor compound precursor is normally at least 90 mol%, or preferably at least 95 mol%, or more preferably at least 99 mol%.

The low-molecular-weight organic semiconductor compound precursor is not particular limited as long as it has the aforementioned properties, but specifically the compounds described in Japanese Patent Application Publication No. 2007-324587 or the like can be used. Of these, desirable examples include compounds represented by Formula (A1) below:

[Chemical Formula 12]

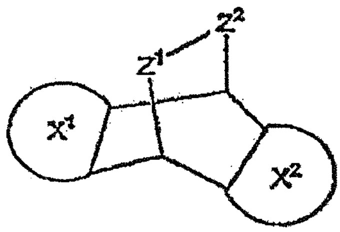

(A1)

(in Formula (A1), at least one of $X^1$ and $X^2$ represents a group that forms a pi-conjugated bivalent aromatic ring, $Z^1$-$Z^2$ are groups that can be dissociated by heat or light, and a pi-conjugated compound obtained by dissociation of $Z^1$-$Z^2$ is a pigment molecule; moreover, the group out of $X^1$ and $X^2$ that does not form a pi-conjugated bivalent aromatic ring is a substituted or unsubstituted ethenylene group).

In the compound represented by Formula (A1), $Z^1$-$Z^2$ are dissociated by heat or light as shown by the following chemical reaction formula to produce a highly planar pi-conjugated compound. The resulting pi-conjugated compound is the semiconductor compound of the present invention. In the present invention, this semiconductor compound preferably exhibits semiconductor properties.

[Chemical Formula 13]

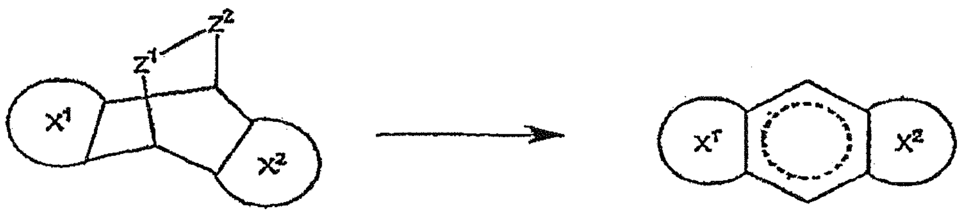

pi-conjugated compound

The following are examples of the compound represented by Formula (A1). t-Bu represents a t-butyl group. M represents a bivalent metal atom or an atom group comprising a trivalent or higher metal bound with another atom.

[Chemical Formula 14]

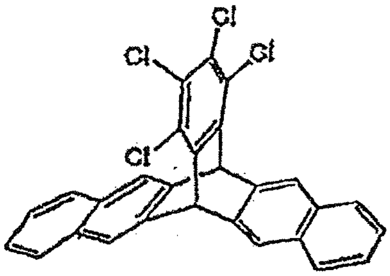

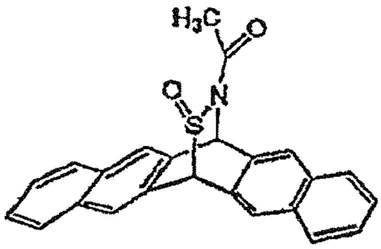

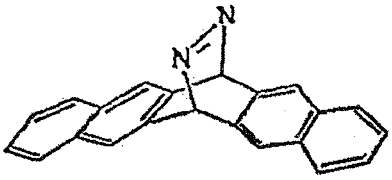

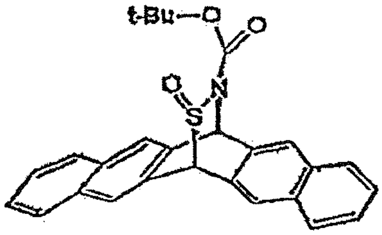

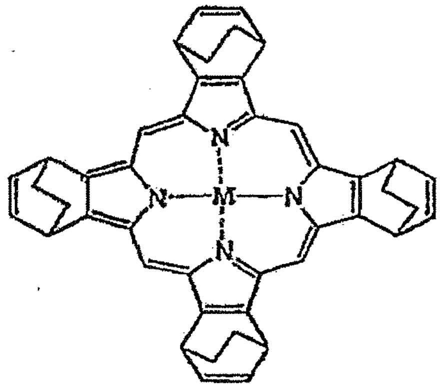

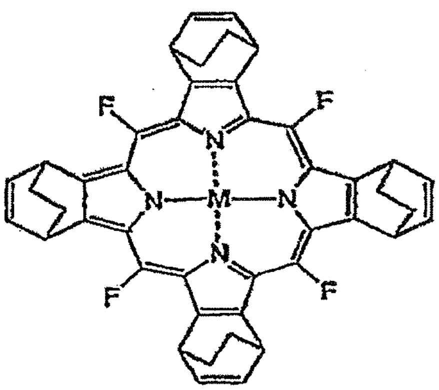

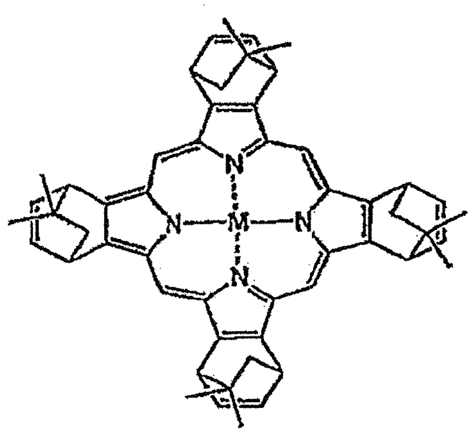

[Chemical Formula 15]

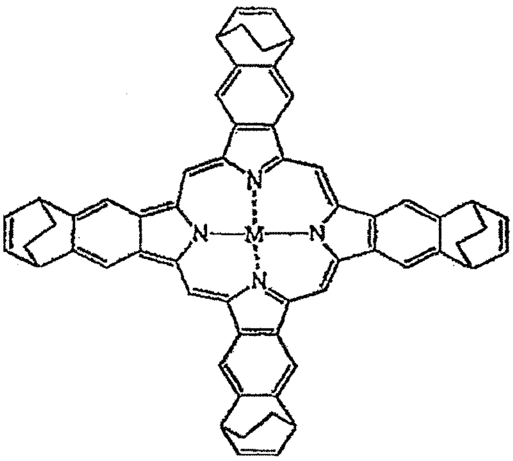

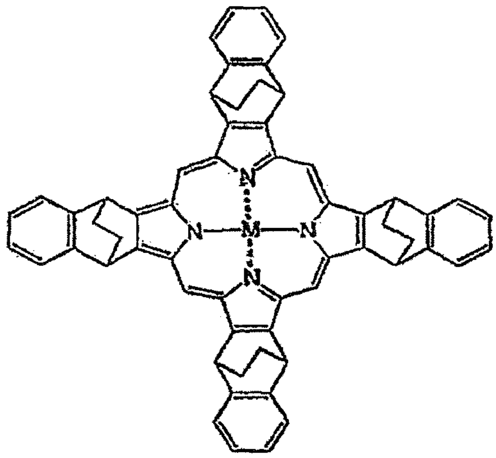

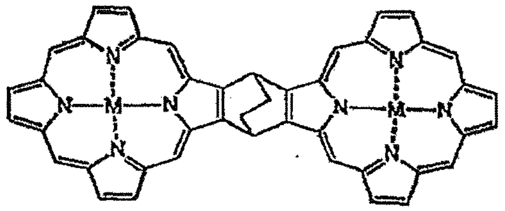

A known method may be used as the method of converting the low-molecular-weight organic semiconductor compound precursor to the semiconductor compound.

The low-molecular-weight organic semiconductor compound precursor represented by Formula (A1) may have a structure with position isomers, and in this case it may consist of a mixture of a plurality of position isomers. A low-molecular-weight organic semiconductor compound precursor consisting of a plurality of position isomers is desirable because it has improved solubility in solvents in comparison with a low-molecular-weight organic semiconductor compound precursor consisting of a single isomer component, thereby facilitating coated film formation. The detailed mechanism whereby solubility is improved with a mixture of a plurality of position isomers is not entirely clear, but it is hypothesized that regular three-dimensional intermolecular interactions become more difficult when a mixture of a plurality of isomers is present in a solution while the latent crystallinity of the compound itself is maintained. In the present invention, the solubility of a precursor mixture comprising a plurality of isomer compounds in a halogen-free solvent is normally at least 0.1 wt%, or preferably at least 1 wt%, or more preferably at least 5 wt%. There is no upper limit, but 50 wt% or less is normal, and 40 wt% or less is preferred.

Of the p-type semiconductor compounds that can be combined with the copolymer of the present invention, a polythiophene or other conjugated copolymer semiconductor compound is preferred as a polymeric organic semiconductor compound, while a condensed aromatic hydrocarbon such as naphthalene, pentacene or pyrene, a phthalocyanine compound or metal complex thereof, or a tetrabenzoporphyrine (BP) or other porphyrine compound or metal complex thereof is preferred as a low-molecular-weight organic semiconductor compound. One of these compounds or a mixture of a plurality of kinds of compounds may be used.

When the p-type semiconductor compound is formed as a film, it may have some kind of self-organized structure, or may be in an amorphous state.

The HOMO level of the p-type semiconductor compound is not particularly limited, and may be selected according to the kind of n-type semiconductor compound as discussed below, but in particular the HOMO level of a p-type semiconductor that will be combined with a fullerene compound is normally at least -5.7 eV, or preferably at least -5.5 eV, and is normally -4.6 eV or less, or preferably -4.8 eV or less. Giving the p-type semiconductor compound a HOMO level of at least -5.7 eV has the effect of improving the properties of the p-type semiconductor, while giving the p-type semiconductor a HOMO level of -4.6 eV or less has the effect of improving the stability of the compound and increasing the open voltage (Voc). The LUMO level of the p-type semiconductor compound is not particularly limited, and can be selected according to the kind of n-type semiconductor compound as discussed below, but in particular the LUMO level of a p-type semiconductor that will be combined with a fullerene compound is normally at least -3.7 eV, or preferably at least -3.6 eV, and is normally -2.5 eV or less, or preferably -2.7 eV or less. Giving the p-type semiconductor a LUMO level of -2.5 eV or less allows it to effectively absorb light energy at long wavelengths with an adjusted bandgap, and serves to improve short-circuit current density. Giving the p-type semiconductor compound a LUMO level of -3.7

eV or more has the effect of facilitating electron movement to the n-type semiconductor compound and improving short-circuit current density.

<2-2-3. n-type semiconductor compound>

The n-type semiconductor compound is not particular limited, but specific examples include fullerene compounds, 8-hydroxyquinoline aluminum and other quinolinol derivative metal complexes; condensed ring tetracarboxylic diimides such as naphthalene tetracarboxylic diimide or perylene tetracarboxylic diimide; perylene diimide derivatives, terpyridine metal complexes, tropolone metal complexes, flavonol metal complexes, perinone derivatives, benzimidazole derivatives, benzoxazole derivatives, thiazole derivatives, benzthiazole derivatives, benzthiadiazole derivatives, oxadiazole derivatives, thiadiazole derivatives, triazole derivatives, aldazine derivatives, bisstyryl derivatives, pyrazine derivatives, phenanthroline derivatives, quinoxaline derivatives, benzoquinoline derivative, bipyridine derivatives, borane derivatives, anthracene, pyrene, napthacene, pentacene and other total fluorides of condensed polycyclic aromatic hydrocarbons; and monolayer carbon nanotubes, n-type polymers (n-type polymer semiconductor compounds) and the like.

Of these a fullerene compound, borane derivative, thiazole derivative, benzothiazole derivative, benzothiadiazole derivative, N-alkyl substituted naphthalene tetracraboxylic diimide or N-alkyl substituted perylene diimide derivative is preferred, and a fullerene compound, N-alkyl substituted perylene diimide derivative, N-alkyl substituted naphthalene tetracarboxylic diimide or n-type polymer semiconductor compound is more preferred. One of these compounds or two or more kinds may be used.

The value of the lowest unoccupied molecular orbital (LUMO) of the n-type semiconductor compound is not particularly limited, but for example the value relative to the vacuum level calculated by the cyclic voltammogram measurement method is normally at least -3.85 eV, or preferably at least -3.80 eV. The mutual relationship between the lowest unoccupied molecular orbitals (LUMOs) of the materials used in each electron donor layer and electron acceptor layer is important for achieving efficient electron movement to the electron acceptor layer (n-type semiconductor layer) from the electron donor layer (p-type semiconductor layer). Specifically, it is desirable that the LUMO of the material of the electron donor layer be higher than the LUMO of the material of the electron acceptor layer by a specific energy, or in other words, that the electron affinity of the electron acceptor be greater than the electron affinity of the electron donor by a specific energy. Because the open voltage (Voc) is determined by the difference between the highest occupied molecular orbital (HOMO) of the material of the electron donor layer and the LUMO of the material of the electron acceptor layer, raising the LUMO of the electron acceptor tends to increase the Voc. The LUMO value is normally -1.0 eV or less, or preferably -2.0 eV or less, or more preferably -3.0 eV or less, or still more preferably -3.3 eV or less. Lowering the LUMO of the electron acceptor tends to facilitate electron movement and increase the short-circuit current (Jsc).

The method of calculating the LUMO value of the n-type semiconductor compound may be a method of calculating a theoretical value or a method of measuring the actual value. Methods of calculating the theoretical value are the semiempirical molecular orbital method and the non-empirical molecular orbital method. Methods of actual measurement are ultraviolet-visible absorption spectrum measurement and cyclic voltammogram measurement. Of these, the cyclic voltammogram measurement method is preferred. Specifically, measurement can be performed by methods described in known literature (WO 2011/016430).

The HOMO value of the n-type semiconductor compound is not particularly limited, but is normally -5.0 eV or less, or preferably -5.5 eV or less. However, it is normally at least -7.0 eV, or preferably at least -6.6 eV. A HOMO value of at least -7.0 eV of the n-type semiconductor compound is desirable so that the absorption of the n-type material can also be used for power generation. A HOMO value of -5.0 eV or less of the n-type semiconductor compound is desirable for preventing reverse hole transfer.

The electron mobility of the n-type semiconductor compound is not particularly limited, but is normally at least $1.0 \times 10^{-6}$ $cm^2/Vs$, or preferably at least $1.0 \times 10^{-5}$ $cm^2/Vs$, or more preferably at least $5.0 \times 10^{-5}$ $cm^2/Vs$, or still more preferably at least $1.0 \times 10^{-4}$ $cm^2/Vs$. Also, it is normally $1.0 \times 10^{3}$ $cm^2/Vs$ or less, or preferably $1.0 \times 10^{2}$ $cm^2/Vs$ or less, or more preferably $5.0 \times 10^{1}$ $cm^2/Vs$ or less. An electron mobility of at least $1.0 \times 10^{-6}$ $cm^2/Vs$ is desirable because the effects of increasing the electron diffusion rate of the photoelectric conversion element, increasing the short-circuit current, and improving conversion efficiency and the like tend to be greater.

Measurement may be by the FET method, which can be accomplished by the methods described in known literature (Japanese Patent Application Publication No. 2010-045186).

The solubility of the n-type semiconductor compound in toluene at 25°C is normally at least 0.5 wt%, or preferably at least 0.6 wt%, or more preferably at least 0.7 wt%. Also, it is normally 90 wt% or less, or preferably 80 wt% or less, or more preferably 70 wt% or less. Giving the compound a solubility of 0.5 wt% or more in toluene at 25°C is desirable for improving the dispersion stability of the n-type semiconductor compound in the solvent and suppressing coagulation, precipitation, separation and the like.

These desirable n-type semiconductor compounds are explained below.

(Fullerene compounds)

The fullerene compounds of the present invention preferably have partial structures represented by General Formulae (n1), (n2), (n3) and (n4).

[Chemical Formula 16]

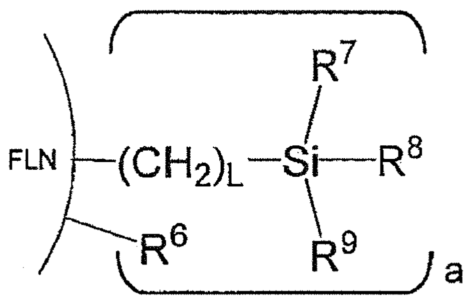

(n1)

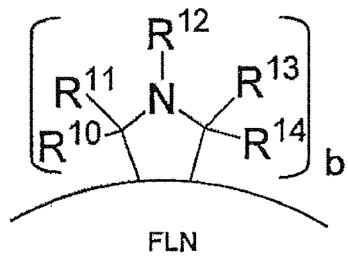

(n2)

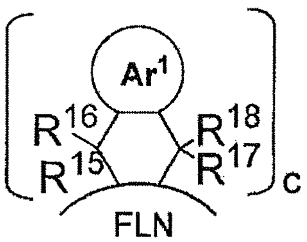

(n3)

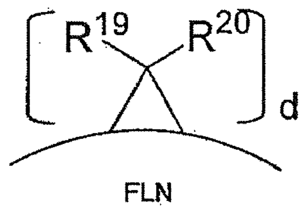

(n4)

In the formulae, FLN represents a fullerene, which is a carbon cluster having a closed-shell structure. The number of carbons in the fullerene may normally be any even number between 60 and 130. Examples of fullerenes include $C_{60}$, $C_{70}$, $C_{76}$, $C_{78}$, $C_{82}$, $C_{84}$, $C_{90}$, $C_{94}$. $C_{96}$ and higher-order carbon clusters having even more carbon atoms. Of these, $C_{60}$ or $C_{70}$ is preferred. A fullerene may be one in which the carbon-carbon bonds have been broken on part of the fullerene ring. Some of the carbon atoms may also be substituted with other atoms. A metal atom or non-metal atom or an atom group formed from these can also be enclosed inside the fullerene cage.

a, b, c and d are integers, and the total of a, b, c and d is normally 1 or more, but is normally no more than 5 or preferably no more than 3. The partial structures in (n1), (n2), (n3) and (n4) are added to the same 5-membered ring or 6-membered ring in the fullerene structure. In General Formula (n1), $-R^6$ and $-(CH_2)_L$ are added, respectively, to two adjacent carbon atoms on the same 5-member ring or 6-member ring of the fullerene structure. In General Formula (n2), $-C(R^{10})(R^{11})-N(R^{12})-C(R^{13})(R^{14})$ is added to two adjacent carbon atoms on the same 5-membered or 6-membered ring of the fullerene structure to form a 5-membered ring. In General Formula (n3), $-C(R^{15})(R^{16})-C-C-C(R^{17})(R^{18})$ is added to two adjacent carbon atoms on the same 5-membered or 6-membered ring of the fullerene structure to form a 6-membered ring. In General Formula (n4), $-C(R^{19})(R^{20})$ is added to two adjacent carbon atoms on the same 5-membered or 6-membered ring of the fullerene structure to form a 3-membered ring. L is an integer from 1 to 8. L is preferably an integer from 1 to 4, or more preferably 1 or 2.

$R^6$ in General Formula (n1) is an optionally substituted $C_{1-14}$ alkyl group, optionally substituted $C_{1-14}$ alkoxy group or optionally substituted aromatic group.
The alkyl group is preferably a $C_{1-10}$ alkyl group, and more preferably a methyl group, ethyl group, n-propyl group, isopropyl group, n-butyl group or isobutyl group, or still more preferably a methyl group or ethyl group.

The alkoxy group is preferably a $C_{1-10}$ alkoxy group, or more preferably a $C_{1-6}$ alkoxy group, or especially a methoxy or ethoxy group.
The aromatic group is preferably a $C_{6-20}$ aromatic hydrocarbon group or $C_{2-20}$ aromatic heterocyclic group, or more preferably a phenyl group, thienyl group, furyl group or pyridyl group, or still more preferably a phenyl or thienyl group.

An optional substituent of the aforementioned alkyl group, alkoxy group and aromatic group is preferably a

halogen atom or silyl group. A fluorine atom is preferred as a halogen atom. A diarylalkylsilyl group, dialkylarylsilyl group, triarylsilyl group or trialkylsilyl group is preferred as a silyl group, a dialkylarylsilyl group is more preferred, and a dimethylarylsilyl group is especially preferred.

$R^7$ to $R^9$ in General Formula (n1) each independently represent a substituent, which is a hydrogen atom, optionally substituted $C_{1-14}$ alkyl group or optionally substituted aromatic group.

A $C_{1-10}$ alkyl group is preferred as the alkyl group, and a methyl, ethyl, n-propyl, isopropyl, n-butyl, isobutyl, t-butyl or n-hexyl group is more preferred. The optional substituent of the alkyl group is preferably a halogen atom. A fluorine atom is preferred as the halogen atom. A perfluorooctyl group, perfluorohexyl group or perfluorobutyl group is preferred as an alkyl group substituted with a fluorine atom.

The aromatic group is preferably a $C_{6-20}$ aromatic hydrocarbon group or $C_{2-20}$ aromatic heterocyclic group, or more preferably a phenyl group, thienyl group, furyl group or pyridyl group, or still more preferably a phenyl or thienyl group. The optional substituent of the aromatic group is preferably a fluorine atom, $C_{1-14}$ alkyl group, $C_{1-14}$ alkyl fluoride group, $C_{1-14}$ alkoxy group or $C_{3-10}$ aromatic group, or more preferably a fluorine atom or a $C_{1-14}$ alkoxy group, or still more preferably a methoxy group, n-butoxy group or 2-ethylhexyloxy group. When the aromatic group has a substituent, the number thereof is not limited, but is preferably 1 to 3 or more preferably 1. When the aromatic group has a plurality of substituents, the substituents may be of different kinds but are preferably of the same kind.

$R^{10}$ to $R^{14}$ in General Formula (n2) are each independently an optionally substituted $C_{1-14}$ alkyl group or optionally substituted aromatic group. A methyl, ethyl, n-propyl, isopropyl, n-butyl, isobutyl, n-hexyl or octyl group is preferred as the alkyl group, and a methyl group is more preferred. The aromatic group is preferably a $C_{6-20}$ aromatic hydrocarbon group or $C_{2-20}$ aromatic heterocyclic group, and is more preferably a phenyl group or pyridyl group, or still more preferably a phenyl group.

A halogen atom is preferred as the optional substituent of the alkyl group. A fluorine group is preferred as the halogen atom. A perfluorooctyl group, perfluorohexyl group or perfluorobutyl group is preferred as the alkyl group substituted with the fluorine atom.

The optional substituent of the aromatic group is not particularly limited, but is preferably a fluorine atom, $C_{1-14}$ alkyl group or $C_{1-14}$ alkoxy group. The alkyl group may also be substituted with a fluorine atom. A $C_{1-14}$ alkoxy group is more preferred, and a methoxy group is still more preferred. When there is a substituent, the number thereof is not limited, but is preferably 1 to 3 or more preferably 1. The substituents may be of different kinds but are preferably of the same kind.

$Ar^1$ in General Formula (n3) is an optionally substituted $C_{6-20}$ aromatic hydrocarbon group or $C_{2-20}$ aromatic heterocyclic group, and is preferably a phenyl, naphthyl, biphenyl, thienyl, furyl, pyridyl, pyrimidyl, quinolyl or quinoxalyl group, or more preferably a phenyl, thienyl or furyl group. The optional substituent is not limited, but is preferably a fluorine atom, chlorine atom, hydroxyl group, cyano group, silyl group or boryl group, an amino group optionally substituted with an alkyl group, a $C_{1-14}$ alkyl group, a $C_{1-14}$ alkoxy group, a $C_{2-14}$ alkylcarbonyl group, a $C_{1-14}$ alkylthio group, a $C_{2-14}$ alkenyl group, a $C_{2-14}$ alkynyl group, a $C_{2-14}$ ester group, a $C_{3-20}$ arylcarbonyl group, a $C_{2-20}$ arylthio group, a $C_{2-20}$ aryloxy group, a $C_{6-20}$ aromatic hydrocarbon group or a $C_{2-20}$ heterocyclic group, or more preferably a fluorine atom, $C_{1-14}$ alkyl group, $C_{1-14}$ alkoxy group, $C_{2-14}$ ester group, $C_{214}$ alkylcarbonyl group or $C_{3-20}$ arylcarbonyl group. The $C_{1-14}$ alkyl group may be substituted with one or two or more fluorine atoms.

The $C_{1-14}$ alkyl group is preferably a methyl, ethyl or propyl group.

The $C_{1-14}$ alkoxy group is preferably a methoxy, ethoxy or propoxyl group.

The $C_{1-14}$ alkylcarbonyl group is preferably an acetyl group.

The $C_{2-14}$ ester group is preferably a methyl ester group or n-butyl ester group.

The $C_{3-20}$ arylcarbonyl group is preferably a benzoyl group.

When there is a substituent, the number thereof is not limited, but is preferably 1 to 4 or more preferably 1 to 3. When there are a plurality of substituents, they may be of different kinds but are preferably of the same kind.

$R^{15}$ to $R^{18}$ in General Formula (n3) are each independently a hydrogen atom, optionally substituted alkyl group, optionally substituted amino group, optionally substituted alkoxy group or optionally substituted alkylthio group. $R^{15}$ or $R^{16}$ may form a ring with either $R^{17}$ or $R^{18}$. When a ring is formed, its structure is represented for example by General Formula (n5), which is a bicyclo structure of condensed aromatic groups.

[Chemical Formula 17-1]

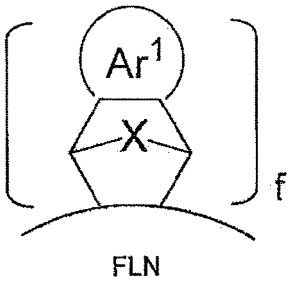

(n5)

In general Formula (n5), f is the same as c, and X is an oxygen atom, sulfur atom, amino group, alkylene group or arylene group. As an alkylene group, it preferably has 1 or 2 carbon atoms. As an arylene group, it preferably has 5 to 12 carbon atoms, and is a phenylene group for example. An amino group may be substituted with a methyl, ethyl or other $C_{1-6}$ alkyl group.

The alkylene group may be substituted with a methoxy group or other $C_{1-6}$ alkoxy group, a $C_{1-5}$ aliphatic hydrocarbon group, a $C_{6-20}$ aromatic hydrocarbon group or a $C_{2-20}$ aromatic heterocyclic group.

The arylene group may be substituted with a methoxy group or other $C_{1-6}$ alkoxy group, a $C_{1-5}$ aliphatic hydrocarbon group, a $C_{6-20}$ aromatic hydrocarbon group or a $C_{2-20}$ aromatic heterocyclic group.

The structure represented by Formula (n6) or (n7) below is particularly desirable as the structure of Formula (n5).

[Chemical Formula 17-2]

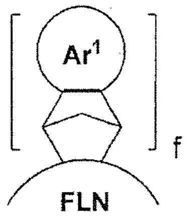

(n6)

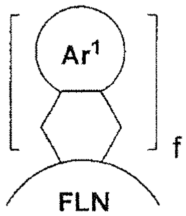

(n7)

$R^{19}$ and $R^{20}$ in General Formula (n4) are each independently a hydrogen atom, alkoxycarbonyl group, optionally substituted $C_{1-14}$ alkyl group or optionally substituted aromatic group.

The alkoxy group in the alkoxycarbonyl group is preferably a $C_{1-12}$ alkoxy group or $C_{1-12}$ alkoxy fluoride group, and more preferably a $C_{1-12}$ alkoxy group, and a methoxy, ethoxy, n-propoxy, isopropoxy, n-butoxy, isobutoxy, n-hexoxy, octoxy, 2-propylpentoxy, 2-ethylhexoxy, cyclohexylmethoxy or benzyloxy group is still more preferred, while a methoxy, ethoxy, isopropoxy, n-butoxy, isobutoxy or n-hexoxy group is especially desirable.

The alkyl group is preferably a $C_{1-8}$ linear alkyl group, and more preferably a n-propyl group. The optional substituent of the alkyl group is not particularly limited, but an alkoxycarbonyl group is preferred. The alkoxy group of the alkoxycarbonyl group is preferably a $C_{1-14}$ alkoxy group or alkoxy fluoride group, and more preferably a $C_{1-14}$ hydrocarbon group, and a methoxy, ethoxy, n-propoxy, isopropoxy, n-butoxy, isobutoxy, n-hexoxy, octoxy, 2-propylpentoxy, 2-ethylhexoxy, cyclohexylmethoxy or benzyloxy group is still more preferable, while a methoxy, or n-butoxy group is especially desirable.

The aromatic group is preferably a $C_{6-20}$ aromatic hydrocarbon or $C_{2-20}$ aromatic heterocyclic group, and a phenyl, biphenyl, thienyl, furyl or pyridyl group is preferred, while a phenyl group or thienyl group is especially preferred. The optional substituent of the aromatic group is preferably a $C_{1-14}$ alkyl group, $C_{1-14}$ alkyl fluoride group or $C_{1-14}$ alkoxy group, or more preferably a $C_{1-14}$ alkoxy group, or especially a methoxy or 2-ethylhexyloxy group. When there is a substituent, the number thereof is not limited, but is preferably 1 to 3 or more preferably 1. The substituents may be of the same or different kinds but are preferably of the same kind.

A structure in which $R^{19}$ and $R^{20}$ are both alkoxycarbonyl groups, or $R^{19}$ and $R^{20}$ are both aromatic groups, or $R^{19}$ is an aromatic group and $R^{20}$ is a 3-(alkoxycarbonyl)propyl group, is preferred as the structure of General Formula (n4).

The n-type semiconductor compound used in the present invention may be one kind of compound or a mixture of a plurality of kinds of compounds.

In order for a fullerene compound to be applicable to coating methods, preferably either the fullerene compound itself is coatable in a liquid state, or else the fullerene compound is highly soluble in some solvent so that it can be coated in a solution. A suitable range of solubility is a solubility of normally at least 0.1 wt%, or preferably at least 0.4 wt%, or

more preferably at least 0.7 wt% in toluene at 25°C. A solubility of at least 0.1 wt% of the fullerene compound is desirable for increasing the dispersion stability of the fullerene compound and suppressing coagulation, precipitation, separation and the like.

The solvent of the fullerene compound of the present invention is not particularly limited as long as it is a nonpolar organic solvent, but a halogen-free solvent is preferred. Dichlorobenzene and other halogen solvents are possible, but substitutes are desirable for environmental reasons and the like.

Examples of halogen-free solvents include halogen-free aromatic hydrocarbons for example. Of these, toluene, xylene or cyclohexylbenzene or the like is preferred.

(Fullerene compound production method)

The method of producing the fullerene compound of the present invention is not particularly limited, but a fullerene compound having the partial structure (n1) can be synthesized for example in accordance with known literature, as described in WO 2008/059771 and J. Am. Chem. Soc., 2008, 130(46), 15429-15436.

A fullerene compound having the partial structure (n2) can be synthesized for example in accordance with known literature, as described in J. Am. Chem. Soc. 1993, 115, 9798-9799, Chem. Mater. 2007, 19, 5363-5372 and Chem. Mater. 2007, 19, 5194-5199.

A fullerene compound having the partial structure (n3) can be synthesized in accordance with known literature, as described in Angew. Chem. Int. Ed. Engl. 1993, 32, 78-80, Tetrahedron Lett. 1997, 38, 285-288, WO 2008/018931 and WO 2009/086210.

A fullerene compound having the partial structure (n4) can be synthesized in accordance with known literature, as described in J. Chem. Soc., Perkin Trans. 1, 1997, 1595, Thin Solid Films 489(2005) 251-256, Adv. Funct. Mater. 2005, 15, 1979-1987 and J. Org. Chem. 1995, 60, 532-538.

Commercially available fullerene compounds such as PCBM (Frontier Carbon Ltd. Company), PCBNB (Frontier Carbon Ltd. Company) and the like can also be used favorably.

(N-alkyl substituted perylene diimide derivative)

The N-alkyl substituted perylene diimide derivative of the present invention is not particularly limited, but specific examples include compounds described in WO 2008/063609, WO 2009/115513, WO 2009/098250, WO 2009/000756 and WO 2009/091670. These are desirable for contributing to both charge transport and power generation because they have high electron mobility absorption in the visible range.

(Naphthalene tetracarboxylic diimide)

The naphthalene tetracarboxylic diimide of the present invention is not particularly limited, but specific examples include compounds described in WO 2008/063609, WO 2007/146250 and WO 2009/000756. These are desirable because they have high electron mobility and solubility and excellent coating properties.

(n-type polymeric semiconductor compound)

The n-type polymeric semiconductor compound of the present invention is not particularly limited, but may be an n-type polymeric semiconductor compound having at least one selected from the naphthalene tetracarboxylic diimides, perylene tetracarboxylic diimides and other condensed ring tetracarobxylic diimides, perylene diimide derivatives, benzoimidazole derivatives, benzoxazole derivatives, thiazole derivatives, benzothiazole derivatives, benzothiadiazole derivatives, oxadiazole derivatives, thiadiazole derivatives, triazole derivatives, pyrazine derivatives, phenanthroline derivatives, quinoxaline derivatives, bipyridine derivatives and borane derivatives as a constituent unit.

Of these, a polymer having at least one selected from the borane derivatives, thiazole derivatives, benzothiazole derivatives, benzothiadiazole derivatives, N-alkyl substituted naphthalene tetracarboxylic diimides and N-alkyl substituted perylene diimide derivatives as a constituent unit is preferred, and an n-type polymeric semiconductor compound having at least one selected from the N-alkyl substituted perylene diimide derivatives and N-alkyl substituted naphthalene tetracarboxylic diimides as a constituent unit is more preferred. One kind or two or more kinds of these compounds may be included.

Specific examples include the compounds described in WO 2009/098253, WO 2009/098250, WO 2010/012710 and WO 2009/098250. These are desirable because they have excellent viscosity and coating properties, and contribute to power generation because they have absorption in the visible range.

<2-2-4. Buffer layers (102, 104)>

In addition to the pair of electrodes (101, 105) and the organic active layer 103 disposed between the electrodes,

the photoelectric conversion element 107 of the present invention preferably has one or more buffer layers. The buffer layers can be classified into an electron extraction layer 104 and a hole extraction layer 102, each of which may be provided between the organic active layer 103 and the electrode (101, 105). The advantage of a buffer layer is that it serves to increase the electron and hole mobility between the active layer and the electrodes, and helps to prevent short circuits between the electrodes.

The electron extraction layer 104 and hole extraction layer 102 are disposed on either side of the organic active layer 103, between the pair of electrodes (101, 105). That is, when the photoelectric conversion element 107 of the present invention contains both an electron extraction layer 104 and a hole extraction layer 102, the electrode 101, hole extraction layer 102, organic active layer 103, electron extraction layer 104 and electrode 105 are disposed in that order. When the photoelectric conversion element 107 of the present invention contains an electron extraction layer 104 but no hole extraction layer 102, the electrode 101, organic active layer 103, electron extraction layer 104 and electrode 105 are disposed in that order. The layering sequence of the electron extraction layer 104 and the hole extraction layer 102 may be reversed, and one or both of the electron extraction layer 104 and the hole extraction layer 102 may be composed of a plurality of different films.

<2-2-5. Electron extraction layer 104>

The material of the electron extraction layer 104 contains a compound having an E=X group, which is represented by General Formula (E1) as explained below, and preferably contains a phosphine compound represented by General Formula (P1) having a double bond between a phosphorus atom and an atom selected from group 16 of the periodic table.

To improve the efficiency of electron extraction to the electrode 101 from the organic active layer 103 containing a p-type semiconductor compound and an n-type semiconductor compound, the electron extraction layer 104 may also have an inorganic compound or organic compound as a material. Examples of the inorganic compound material include salts of alkali metals such as Li, Na, K and Cs, and n-type semiconductor oxides such as titanium oxide (TiOx), zinc oxide (ZnO) and the like. The alkali metal salt is preferably a fluoride salt such as LiF, NaF, KF or CsF. The mechanism of action of such materials is unknown, but it may be that when combined with an Al or other electron extraction electrode (cathode 105), they reduce the work function of the cathode 105, thereby increasing the voltage applied inside the solar cell element.

Specific examples of the organic compound material include bathocuproine (BCP), bathophenanthroline (Bphen), (8-hydroxyquinolinato)aluminum (Alq3), boron compounds, oxadiazole compounds, benzoimidazole compounds, naphthalene tetracarboxylic anhydride (NTCDA), perylene tetracarboxylic anhydride (PTCDA) and the like.

The LUMO value of the material of the electron extraction layer 104 is not particularly limited, but is normally at least -4.0 eV, and preferably at least -3.9 eV, and is normally -1.9 eV or less, or preferably -2.0 eV or less. From the standpoint of promoting charge transfer, it is desirable that the material of the electron extraction layer 104 have a LUMO value of -1.9 eV or less. From the standpoint of preventing reverse electron transfer to the n-type material, it is desirable that the material of the electron extraction layer 104 have a LUMO value of at least -4.0 eV.

The LUMO value of the material of the electron extraction layer 104 can be calculated by the cyclic voltammogram measurement method. This can be done with reference to the methods described in known literature (WO 2011/016430).

The HOMO value of the material of the electron extraction layer 104 is not particularly limited, but is normally at least -9.0 eV, or preferably at least -8.0 eV, and is normally -5.0 eV or less, or preferably -5.5 eV or less. Giving the material of the electron extraction layer 104 a HOMO value of -5.0 eV or less is desirable from the standpoint of inhibiting incoming hole movement.

When the material of the electron extraction layer 104 is an organic compound, the glass transition temperature (hereunder sometimes called the Tg) of this compound according to DSC is not particularly limited, but is preferably either not observed, or at least 55°C. If no glass transition temperature is observed according to DSC, this means that there is no glass transition temperature. Specifically, this is determined according to whether or not there is a glass transition temperature at 400°C or less. A material for which no glass transition temperature is observed according to DSC is desirable because it is thermally extremely stable.

Of the materials having glass transition temperatures of 55°C or more according to DSC, one with a glass transition temperature of preferably at least 65°, more preferably at least 80°, still more preferably at least 110°C or especially at least 120°C is desirable. There is no particular upper limit to the glass transition temperature, but 400°C or less is normal, and 350°C or less or preferably 300°C or less is desirable. Moreover, the material of the electron extraction layer 104 is preferably one for which no glass transition temperature according to DSC is observed at temperatures 30°C or more and less than 55°C.

The glass transition temperature in this Description is the temperature at which local molecular movement is initiated by thermal energy in a solid of a compound in an amorphous state, and is defined as the point at which the specific heat changes. When the temperature continues to rise above the Tg, the solid structure changes and crystallization occurs (the temperature at this point is called the crystallization temperature (Tc)). If the temperature rises still further, the compound generally melts at the melting point (Tm), changing to a liquid state. However, these phase transitions may not occur if the molecules decompose or sublimate at high temperatures. The glass transition temperature can be measured by known methods, such as DSC.

The DSC method (differential scanning calorimetry) is a method of measuring thermophysical properties as defined in JIS K-0129 "General rules for thermal analysis". The glass transition temperature is the temperature at which molecular movement is initiated from the glass state, and is measured by DSC as the temperature at which the specific heat changes. To determine the glass transition temperature more exactly, it is preferably measured after the sample has been first heated to a temperature equal to or above the glass transition point and then cooled rapidly. This can be accomplished by the methods described in known literature (WO 2011/016430) for example.

If the glass transition temperature of a compound used in the electron extraction layer is at least 55°C, the compound is resistant to structural changes in response to external stress such as applied electrical fields, flowing current, bending and stress from temperature changes and the like, which is desirable from the standpoint of durability. Since a thin film of the compound is also less likely to crystallize, moreover, changes between amorphous state and crystal state are less likely in this compound at the operating temperature range, which is desirable for improving the stability and therefore the durability of the electron extraction layer. This effect is more conspicuous the higher the glass transition temperature of the material.

The film thickness of the electron extraction layer 104 is not particularly limited, but is normally at least 0.01 nm or preferably at least 0.1 nm or more preferably at least 0.5 nm, and is normally 40 nm or less or preferably 20 nm or less. When the film thickness of the electron extraction layer 104 is at least 0.01 nm it can function as a buffer material, while when the film thickness of the electron extraction layer 104 is 40 nm or less electrons are more easily extracted, and photoelectric conversion efficiency is improved.

(Compound having E=X group)

The compound represented by General Formula (E1), which contains an E=X group, is explained below.

[Chemical Formula 17-3]

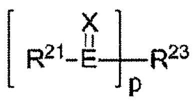

(E1)

In Formula (E1), E represents $PR^{22}$, S, S(=O) or C. If E is $PR^{22}$ the glass transition temperature is higher, which is desirable from the standpoint of reducing structural changes during use of the photoelectric conversion element. When E is $PR^{22}$, the compound of Formula (E1) is the phosphine compound represented by General Formula (P1) below, which contains a double bond between a phosphorus atom and an atom selected from group 16 of the periodic table. Using the compound represented by General Formula (P1) below as the material of the electron extraction layer 104 is desirable from the standpoint of improving photoelectric conversion efficiency and/or improving the durability of the photoelectric conversion element.

In Formulae (E1) and (P1), X represents an atom selected from group 16 of the period table. Specifically, it may be oxygen, sulfur or selenium. Of these, oxygen or sulfur is preferred, and oxygen is especially preferred. It is thought that with an atom selected from group 16 of the period table, the polarity in the compound molecules is increased, thereby strengthening the intermolecular interactions and providing the effects of the invention in terms of increasing the glass transition temperature of the compound and improving the solar cell properties.
More specific examples of E=X groups include $-P(=O)R^{22}-$, $-P(=S)R^{22}-$, $-S(=O)-$, $-S(=O)_2-$, $-C(=O)-$, $-C(=S)-$ and the like.

[Chemical Formula 18]

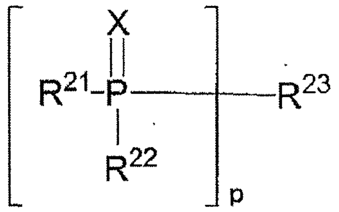

(P1)

In Formulae (E1) and (P1), p represents an integer of 1 or greater. This is normally 6 or less, or preferably 5 or less, or more preferably 3 or less, and 2 or less is preferred for improving solubility and facilitating film formation by coating, while 1 is preferred from the standpoint of effectively producing intermolecular interactions between different molecules.

$R^{21}$ and $R^{22}$ are each independently an arbitrary substituent. The kinds of substituents are not particularly limited as long as the functions of the electron extraction layer are obtained with the compounds represented by Formulae (E1) and (P1), but hydrocarbon groups, hydrocarbon groups that bind via oxygen atoms, heterocyclic groups or hydroxyl groups are preferred. The hydrocarbon groups, hydrocarbon groups that bind via oxygen atoms and heterocyclic groups may themselves have substituents.

Preferably, $R^{21}$ and $R^{22}$ are each independently an optionally substituted hydrocarbon group, optionally substituted alkoxy group or optionally substituted heterocyclic group.

Examples of hydrocarbon groups include aliphatic hydrocarbon groups and aromatic hydrocarbon groups. Examples of aliphatic hydrocarbon groups include saturated aliphatic hydrocarbon groups and unsaturated aliphatic hydrocarbon groups. Examples of saturated aliphatic hydrocarbon groups include alkyl and cycloalkyl groups and the like.

The alkyl group is preferably a $C_{1-20}$ alkyl group, such as a methyl, ethyl, i-propyl, t-butyl or hexyl group or the like.

The cycloalkyl group is preferably a $C_{3-20}$ cycloalkyl group, such as a cyclopropyl, cyclopentyl or cyclohexyl group or the like.

Examples of unsaturated aliphatic hydrocarbon groups include alkenyl, cycloalkenyl and alkynyl groups and the like.

The alkenyl group is preferably a $C_{2-20}$ alkenyl group, such as a vinyl or styryl group.

The cyclalkenyl group is preferably a $C_{3-20}$ cycloalkenyl group, such as a cyclopropenyl, cyclopentenyl or cyclohexenyl group or the like.

The alkynyl group is preferably a $C_{2-20}$ alkynyl group, such as a methylethynyl or trimethylsilylethynyl group or the like.

Of the aliphatic hydrocarbon groups, a saturated aliphatic hydrocarbon group is preferred, and an alkyl group is more preferred.

The aromatic hydrocarbon group preferably has 6 to 30 carbon atoms, and may be a phenyl, naphthyl, phenanthryl, biphenylenyl, triphenylenyl, anthryl, pyrenyl, fluorenyl, azulenyl, acenaphthenyl, fluoranthenyl, naphthacenyl, perylenyl, pentacenyl or quarterphenyl group or the like for example. Of these, a phenyl, naphthyl, phenanthryl, triphenylenyl, anthryl, pyrenyl, fluorenyl, acenaphthenyl, fluoranthenyl or perylenyl group is preferred.

The hydrocarbon group that binds via an oxygen atom may be an alkoxy group, aryloxy group or the like. Of these, an alkoxy group is preferred from the standpoint of solubility.

The alkoxy group preferably has 1 to 20 carbon atoms, and may be a methoxy, ethoxy, n-propoxy, i-propoxy, n-butoxy, i-butoxy, t-butoxy, benzyloxy, ethylhexyloxy or other linear or branched alkoxy group for example.

The aryloxy group preferably has 2 to 20 carbon atoms, and may be a phenoxy, naphthyloxy, pyridyloxy, thiazolyloxy, oxazolyloxy or imidazolyloxy group or the like for example. Of these, a phenoxy group or pyridyloxy group is preferred.

The heterocyclic group may be an aliphatic heterocyclic group or aromatic heterocyclic group.

The aliphatic heterocyclic group preferably has 2 to 30 carbon atoms, and may be a pyrrolidinyl, piperidinyl, piperadinyl, tetrahydrofuranyl, dioxanyl, morpholinyl or thiomorpholinyl group or the like for example. Of these, a pyrrolidinyl, piperidinyl or piperadinyl group is preferred.

The aromatic heterocyclic group preferably has 2 to 30 carbon atoms, and may be a pyridyl, thienyl, furyl, pyrrolyl, oxazolyl, thiazolyl, oxadiazolyl, thiadiazolyl, pyradinyl, pyrimidinyl, pyrazolyl, imidazolyl, benzothienyl, dibenzofuryl, dibenzothienyl, phenylcarbazolyl, phenoxathienyl, xanthenyl, benzofuranyl, thianthrenyl, indolidinyl, phenoxadinyl, phenothiadinyl, acrylidinyl, phenanthridinyl, phenanthrolinyl, quinolyl, isoquinolyl, indolyl or quinoxalinyl group or the like. Of these, a pyridyl, pyradinyl, pyrimidinyl, pyrazolyl, quinolyl, isoquinolyl, imidazolyl, acrydinyl, phenanthridinyl, phenanthrolinyl, quinoxalinyl, dibenzofuryl, dibenzothienyl, phenylcarbazolyl, xanthenyl or phenoxadinyl group is preferred.

The aromatic hydrocarbon group and aromatic heterocyclic group may also form a condensed polycyclic aromatic group. A ring forming the condensed polycyclic aromatic group may be an optionally substituted cyclic alkyl group, an optionally substituted aromatic hydrocarbon group or an optionally substituted aromatic heterocyclic group.

The cyclic alkyl group may be a cyclopentyl or cyclohexyl group for example.
The aromatic hydrocarbon group may be a phenyl group for example.

The aromatic heterocyclic group may be a pyridyl, thienyl, furyl, pyrrolyl, oxazolyl, thiazolyl, oxadiazolyl, thiadiazolyl, pyradinyl, pyrimidinyl, pyrazolyl or imidazolyl group for example. Of these, a pyridyl or thienyl group is preferred.

Examples of condensed polycyclic aromatic groups include condensed polycyclic aromatic hydrocarbon groups and condensed polycyclic aromatic heterocyclic groups. The number of rings in the condensed polycyclic aromatic group is normally 2 or more, or preferably 3 or more, and is normally 10 or less, or preferably 8 or less, or more preferably 6 or less. For achieving stronger interactions with the n-type semiconductor of the active layer, it is desirable that the number of rings in the condensed polycyclic aromatic compound be within this range.
Examples of condensed polycyclic aromatic hydrocarbon groups include phenanthryl, anthryl, pyrenyl, fluoranthenyl, naphthacenyl, perylenyl, pentacenyl and triphenylenyl groups and the like. Examples of condensed polycyclic aromatic heterocyclic groups include phenoxadinyl, phenothiadinyl, acrydinyl, phenanthridinyl and phenanthrolinyl groups and the like.

The condensed polycyclic aromatic group may be, but need not be, a group derived from the following condensed polycyclic aromatic compounds for example. In the following condensed polycyclic aromatic compounds, the position of the atom binding with E is not particularly limited.

[Chemical Formula 19]

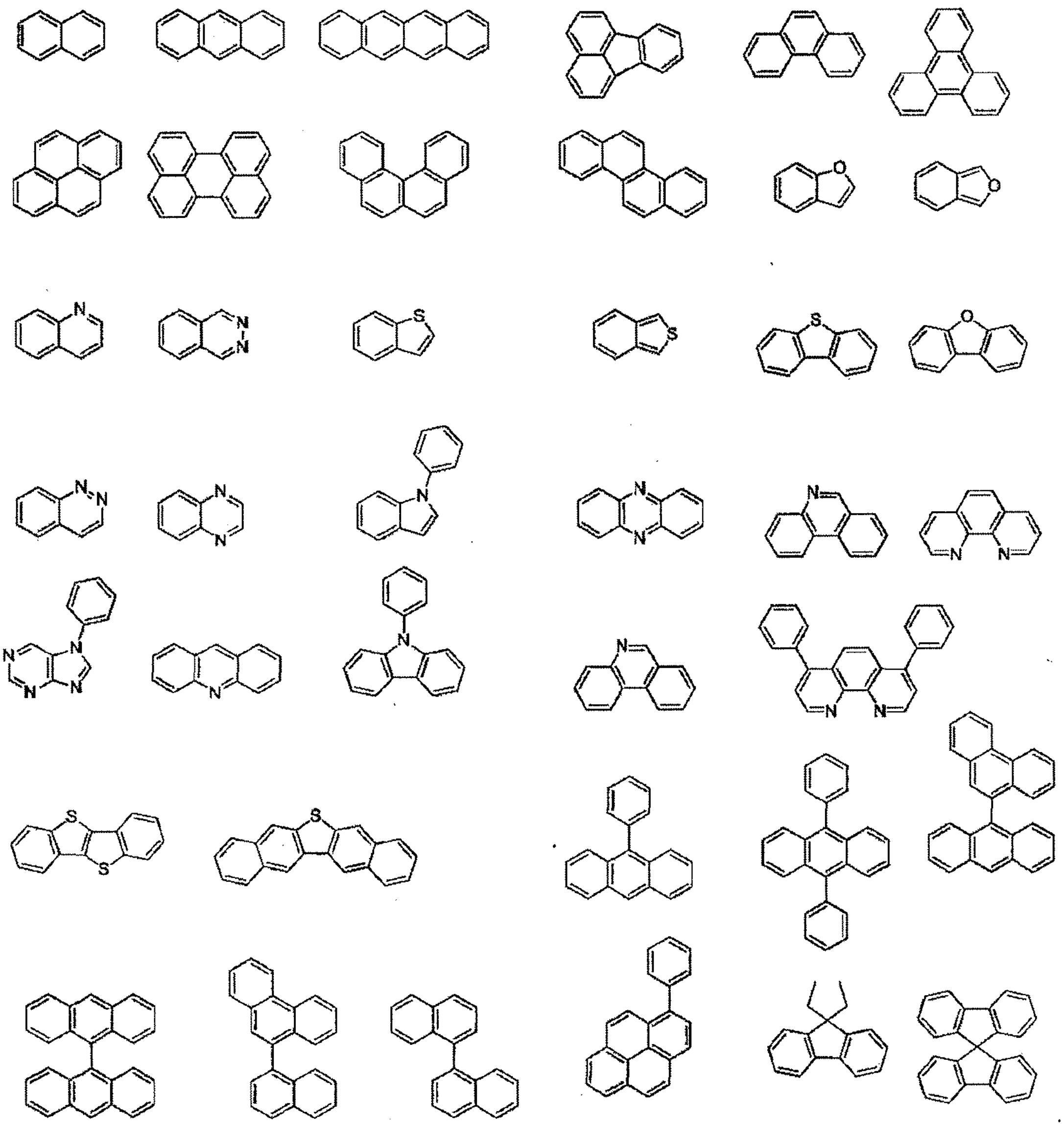

At least one of $R^{21}$ and $R^{22}$ is preferably an optionally substituted saturated aliphatic hydrocarbon group, optionally substituted aromatic hydrocarbon group or optionally substituted aromatic heterocyclic group.

For improving solubility and facilitating film formation by coating, it is desirable that at least one of $R^{21}$ and $R^{22}$ be a saturated aliphatic hydrocarbon group. From the standpoint of improving thermal stability, preferably at least one of $R^{21}$ and $R^{22}$ is an aromatic group, and more preferably at least one of $R^{21}$ and $R^{22}$ is a condensed polycyclic aromatic group.

Because aromatic groups are highly planar, moreover, it is thought that when at least one of $R^{21}$ and $R^{22}$ is an aromatic compound, the n-type semiconductor compound of the active layer 103 interacts more easily with the compound having an E=X group (or the phosphine compound). This is desirable because it facilitates charge transfer between the buffer layer and the active layer. Moreover, both $R^{21}$ and $R^{22}$ are preferably aromatic groups, and more preferably both $R^{21}$ and $R^{22}$ are identical aromatic groups, or still more preferably both $R^{21}$ and $R^{22}$ are identical condensed polycyclic aromatic groups, or most preferably both $R^{21}$ and $R^{22}$ are identical condensed polycyclic aromatic hydrocarbon groups. These effects are particularly noticeable when the n-type semiconductor compound is a fullerene compound because the pi-electrons of the fullerene compound and the pi-electrons of the aromatic compound ($R^{21}$ and/or $R^{22}$) are more likely to adjoin each other, and the effects are even more noticeable when the aromatic compound is a condensed polycyclic aromatic group.

$R^{21}$ and $R^{22}$ may also bind together to form a ring.

When p is 2 or more there are a plurality of $R^{21}$ groups and a plurality of $R^{22}$ groups, and the plurality of $R^{21}$ groups and the plurality of $R^{22}$ groups may be independently different from one another. Moreover, any two or more of the plurality of $R^{21}$ groups and the plurality of $R^{22}$ groups may bind together to form a ring.

In Formulae (E1) and (P1), $R^{23}$ represents an optionally substituted p-valent hydrocarbon group, optionally substituted p-valent heterocyclic group, or a p-valent group linked to at least one of an optionally substituted hydrocarbon group and an optionally substituted heterocyclic group. The p-valent group linked to at least one of an optionally substituted hydrocarbon group and an optionally substituted heterocyclic group is a p-valent group linked by a direct bond to an optionally substituted hydrocarbon group and/or optionally substituted heterocyclic group, or a p-valent group linked to an optionally substituted hydrocarbon group and/or optionally substituted heterocyclic group via an alkylene group, silylene group, amino group, oxygen atom, sulfur atom or the like.

Examples of hydrocarbon groups include the monovalent hydrocarbon groups explained above for $R^{21}$ and $R^{22}$, and corresponding bivalent and higher hydrocarbon groups. The hydrocarbon group is normally hexavalent or less, or preferably pentavalent or less, or more preferably trivalent or less. The hydrocarbon group may be similar in kind to the aliphatic hydrocarbon groups and aromatic hydrocarbon groups used for $R^{21}$ and $R^{22}$.

Examples of heterocyclic groups include the monovalent heterocyclic groups explained above for $R^{21}$ and $R^{22}$, and corresponding bivalent to hexavalent heterocyclic groups. The heterocyclic group may be similar in kind to the aliphatic heterocyclic groups and aromatic heterocyclic groups used for $R^{21}$ and $R^{22}$.

Moreover, the aromatic hydrocarbon group and aromatic heterocyclic group may form a condensed polycyclic aromatic group.

Examples of condensed polycyclic aromatic groups include the monovalent condensed polycyclic aromatic groups explained for $R^{21}$ and $R^{22}$, or their bivalent and higher condensed polycyclic aromatic groups. A condensed polycyclic aromatic group is normally hexavalent or less, or preferably pentavalent or less, or more preferably trivalent or less.

When $R^{23}$ is a bivalent group, specific examples include, but are not limited to, the following.

[Chemical Formula 20-1]

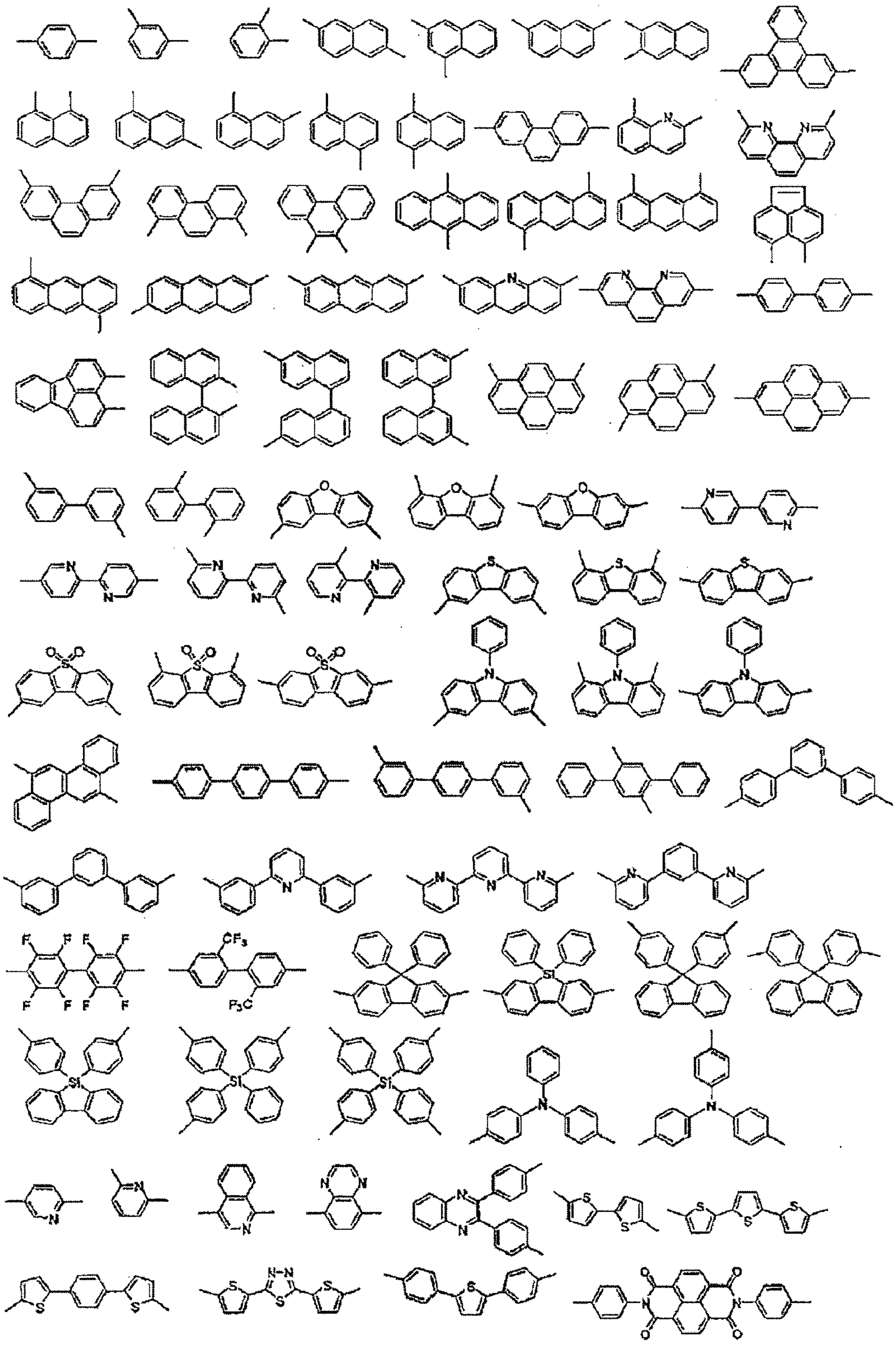

$R^{23}$ is preferably an optionally substituted p-valent aromatic group, and is more preferably an optionally substituted p-valent condensed polycyclic aromatic group.

The term "optionally substituted" in the explanations of $R^{21}$, $R^{22}$ and $R^{23}$ means optionally having one or more substituents. The substituents are not particularly limited, but examples include halogen atoms and hydroxyl, cyano, amino, carboxyl, carbonyl, acetyl, sulfonyl, silyl, boryl, nitryl, alkyl, alkenyl, alkynyl and alkoxy groups, and aromatic hydrocarbon and aromatic heterocyclic groups and the like.

A fluorine atom is preferred as the halogen atom.

The alkyl group preferably has 1 to 20 carbon atoms, and may be a methyl, ethyl, i-propyl, t-butyl or cyclohexyl

group for example.

The alkenyl group preferably has 2 to 20 carbon atoms, and may be a vinyl, styryl or diphenylvinyl group for example.

The alkynyl group preferably has 2 to 20 carbon atoms, and may be a methylethynyl, phenylethynyl or trimethylsilylethynyl group or the like for example.

The silyl group preferably has 2 to 20 carbon atoms, and may be a trimethylsilyl or triphenylsilyl group for example.

The boryl group may be a dimethylboryl group or other boryl group substituted with an aromatic group.

The alkoxy group preferably has 2 to 20 carbon atoms, and may be a methoxy, ethoxy, n-propoxy, i-propoxy, n-butoxy, i-butoxy, ethylhexyloxy, benzyloxy, t-butoxy or other linear or branched alkoxy group for example.

The amino group may be a diphenylamino, ditolylamino, carbazolyl or other amine substituted with an aromatic group.

Aromatic hydrocarbon groups having 6 to 20 carbon atoms are preferred, and are not limited to monocyclic groups, but may be either monocyclic aromatic hydrocarbon groups, condensed polycyclic aromatic hydrocarbon groups or linked-ring aromatic hydrocarbon groups.

An example of a monocyclic aromatic hydrocarbon group is a phenyl group. Examples of condensed polycyclic aromatic hydrocarbon groups include biphenyl, phenanthryl, naphthyl, anthryl, fluorenyl, pyrenyl and perylenyl groups. Examples of linked-ring aromatic hydrocarbon groups include biphenyl and terphenyl groups for example. Of these, a phenyl group or naphthyl group is preferred.

The aromatic heterocyclic group preferably has 5 to 20 carbon atoms, and may be a pyridyl, thienyl, furyl, oxazolyl, thiazolyl, oxadiazolyl, benzothienyl, dibenzofuryl, dibenzothienyl, pyradinyl, pyrimidinyl, pyrazolyl, imidazolyl or phenylcarbazolyl group for example. Of these, a pyridyl, thienyl, benzothienyl, dibenzofuryl, dibenzothienyl or phenanthryl group is preferred.

Of the compounds represented by Formula (P1), a phosphine compound substituted with an aryl group and having a double bond between a phosphorus atom and an atom selected from group 16 of the periodic table is more preferred. Examples include phosphine oxide compounds substituted with aryl groups and phosphine sulfide compounds substituted with aryl groups. More preferred examples include triaryl phosphine oxide compounds, triaryl phosphine sulfide compounds, aromatic hydrocarbon compounds having two or more diaryl phosphine oxide units, aromatic hydrocarbon compounds having two or more diaryl phosphine sulfide units, aromatic hydrocarbon compounds having two or more diaryl phosphine oxide units and the like. The aryl group may itself be substituted with a fluorine atom, a hydroxyl group or a perfluoroalkyl group or other alkyl group substituted with a fluorine atom or the like. The phosphine compound having a double bond between a phosphorus atom and an atom selected from group 16 of the periodic table may also be doped with an alkali metal or alkali earth metal.

Specific examples of compounds represented by Formulae (E1) and (P1) (in which X is oxygen, sulfur, selenium or another atom selected from group 16 of the period table) are given below.

[Chemical Formula 20-2]

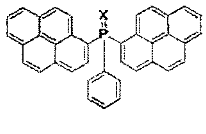 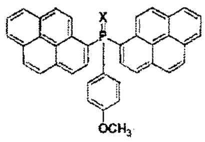 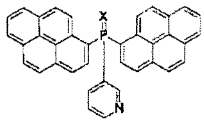 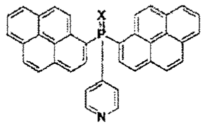 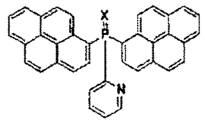

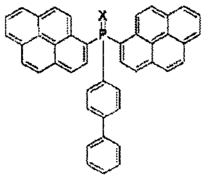 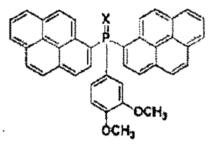 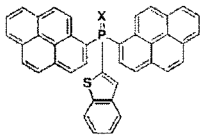 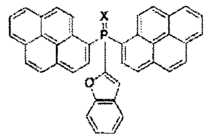 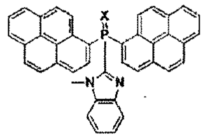

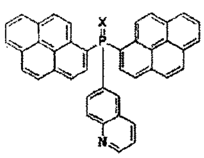 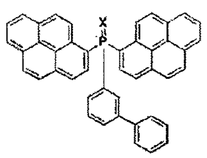 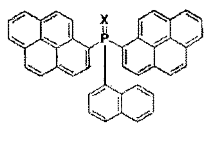 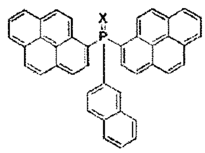 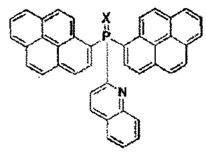

[Chemical Formula 20-3]

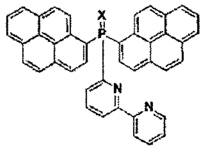
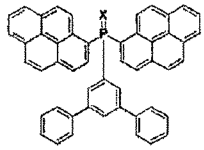
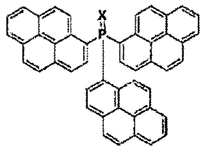
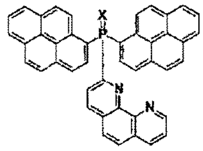
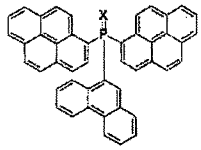
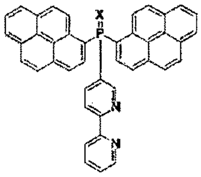
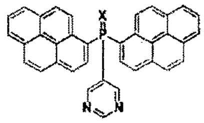
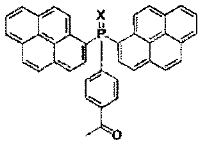
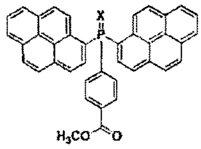
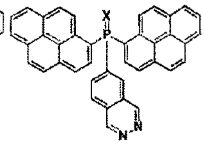
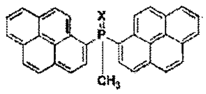
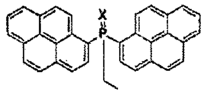
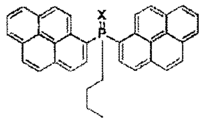
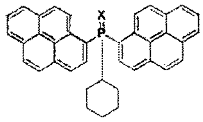
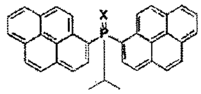

[Chemical Formula 20-4]

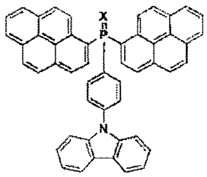
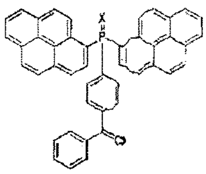
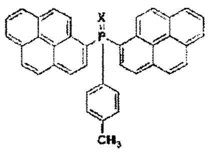
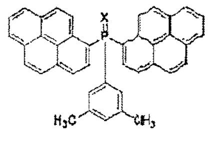
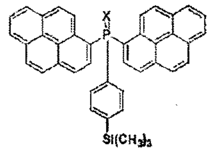
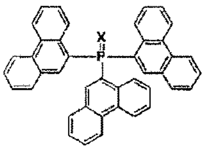
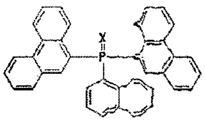
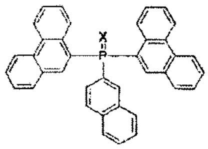
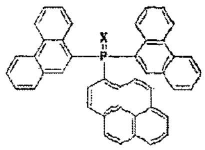
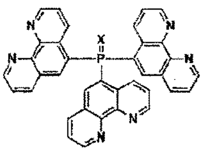
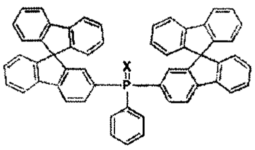
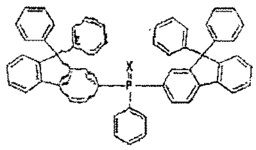
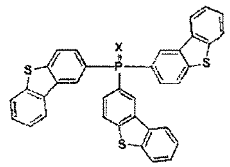
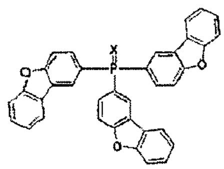

[Chemical Formula 20-5]

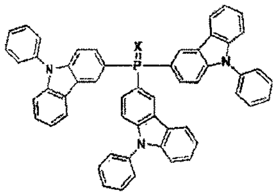
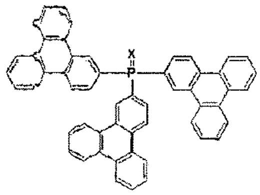
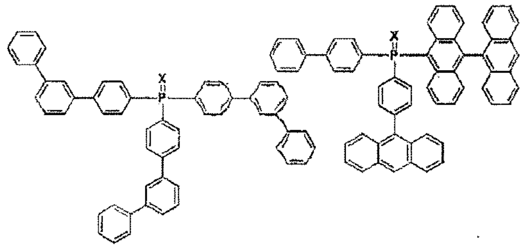
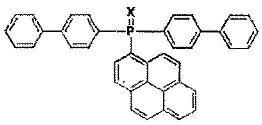
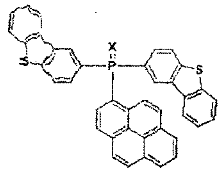
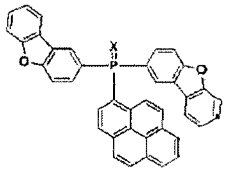
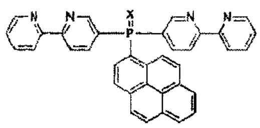

[Chemical Formula 20-6]

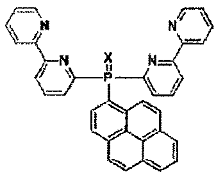
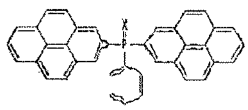
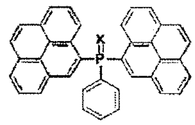
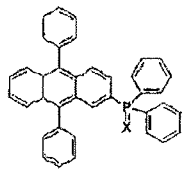
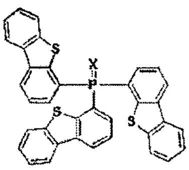
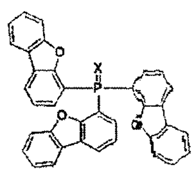
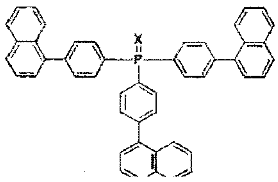
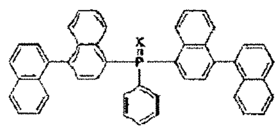

[Chemical Formula 20-7]

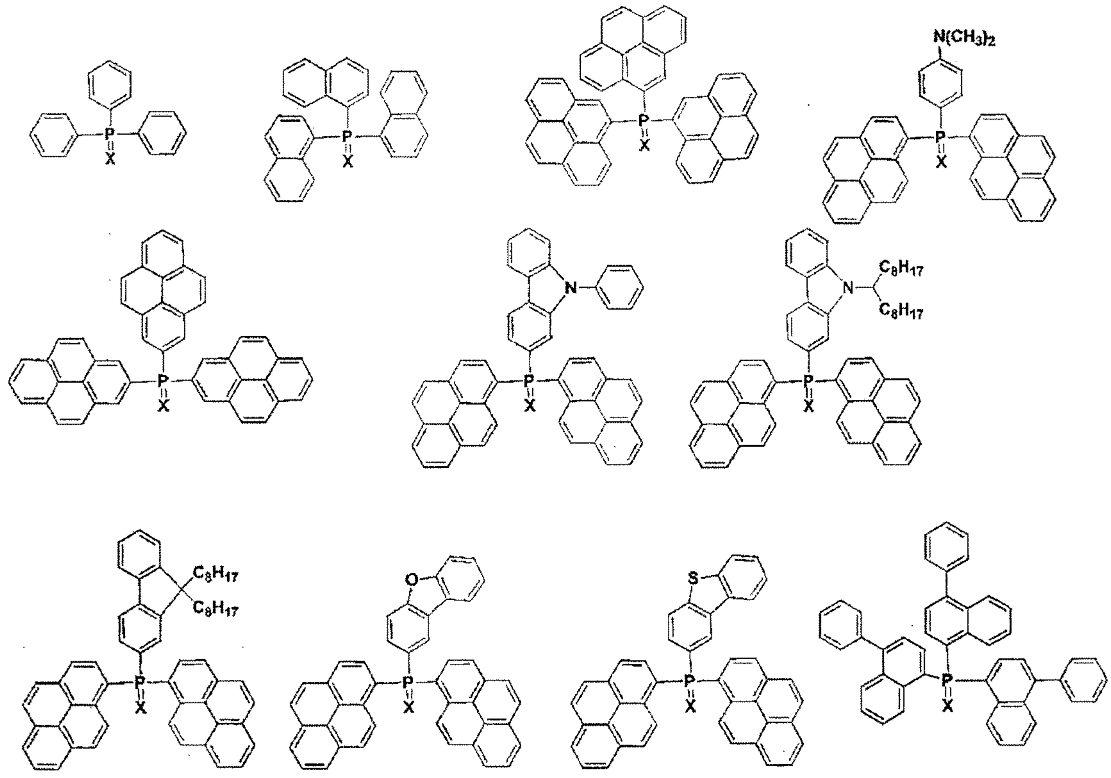

[Chemical Formula 20-8]

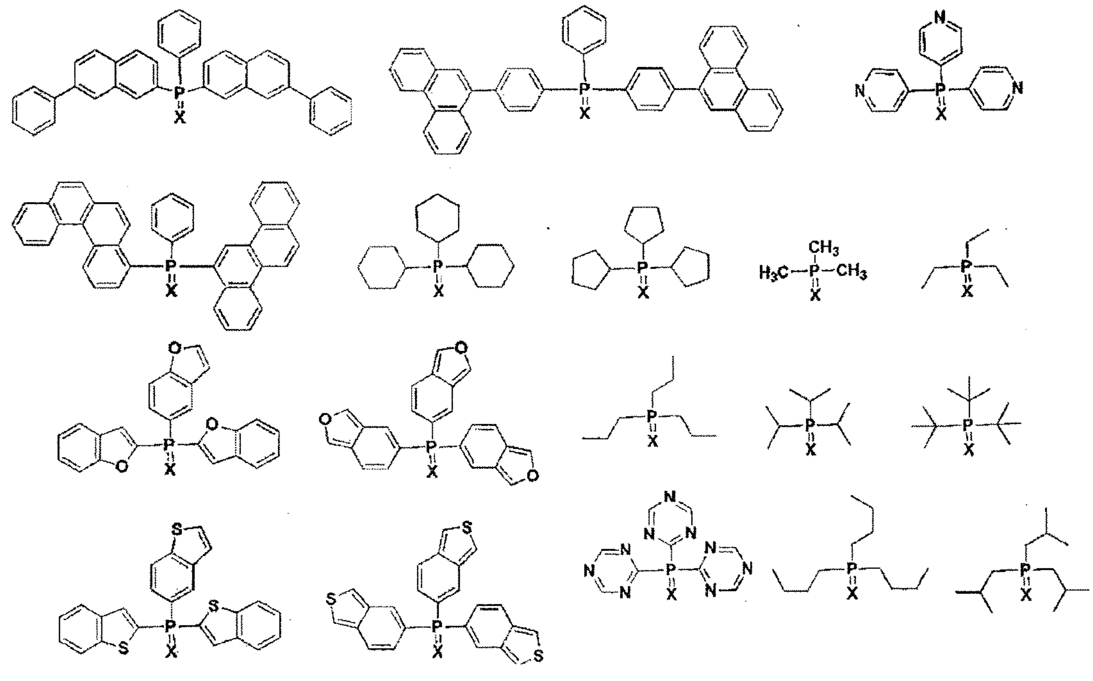

[Chemical Formula 20-9]

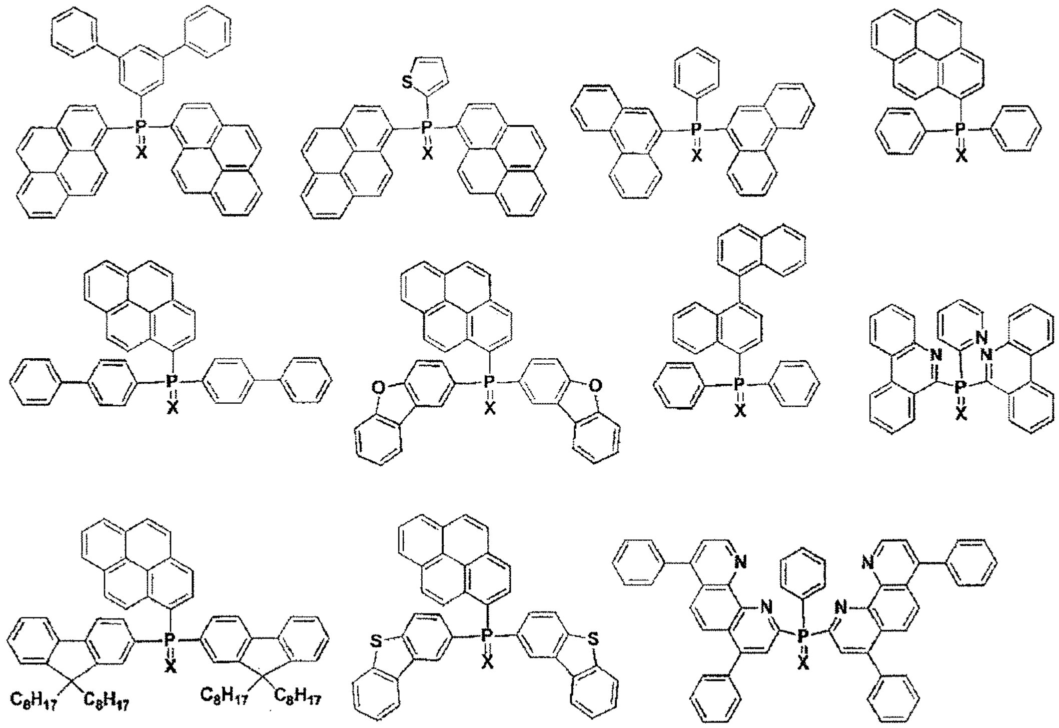

[Chemical Formula 20-10]

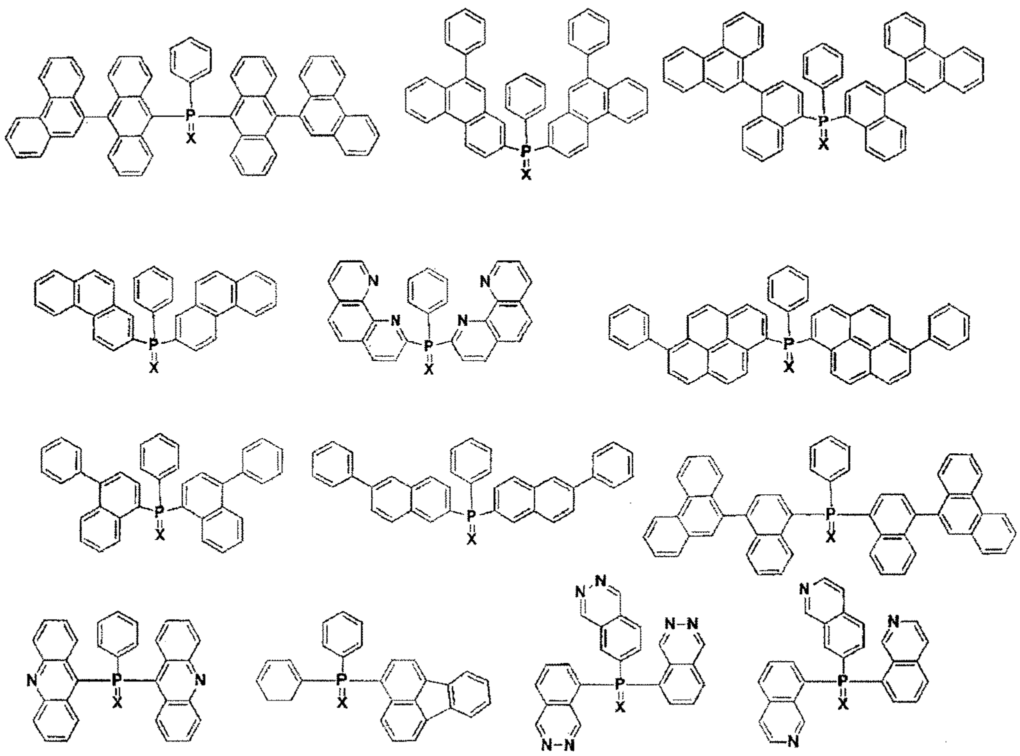

[Chemical Formula 20-11]

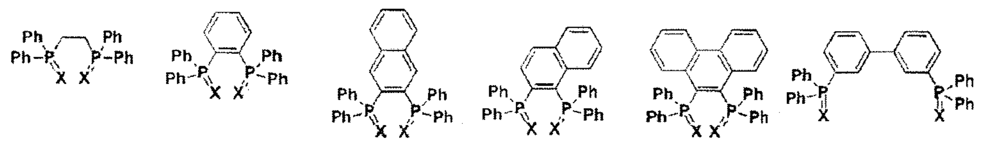

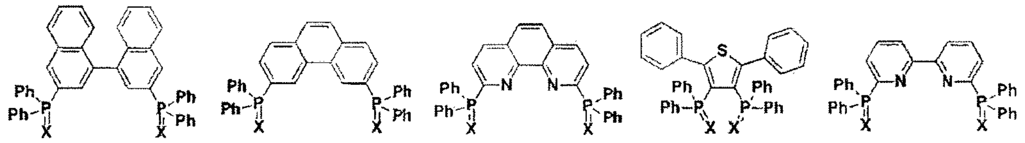

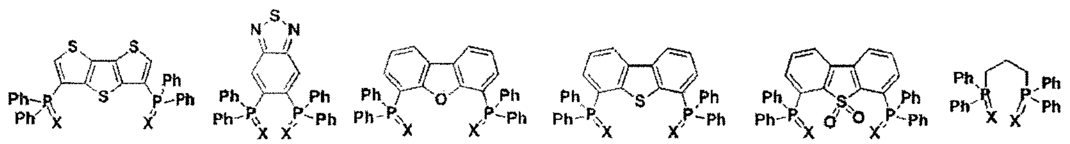

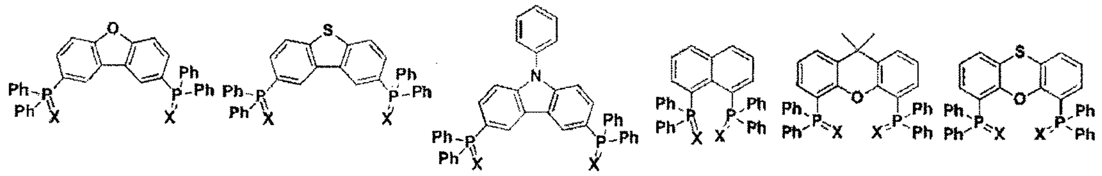

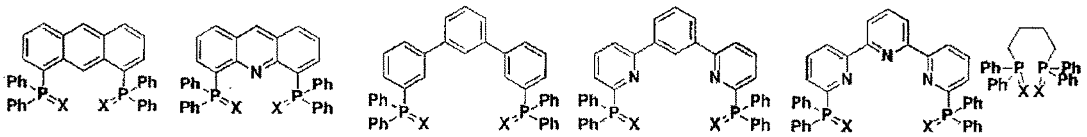

[Chemical Formula 20-12]

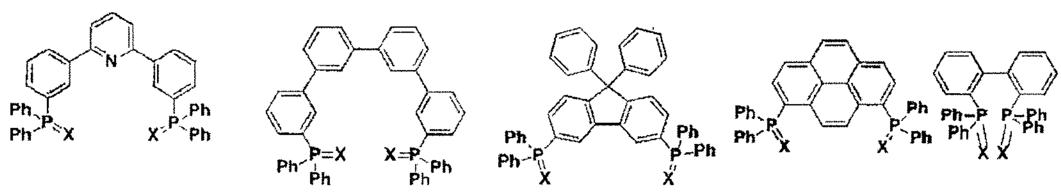

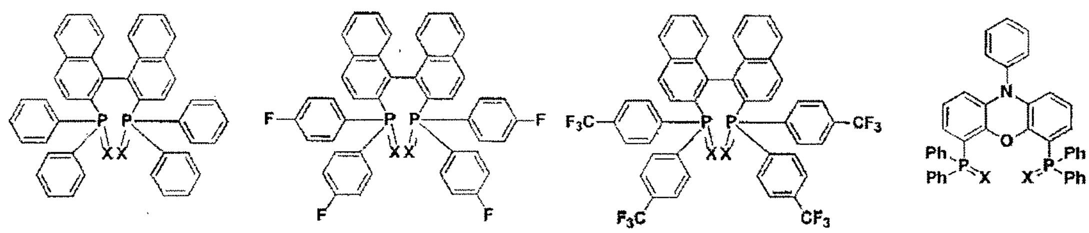

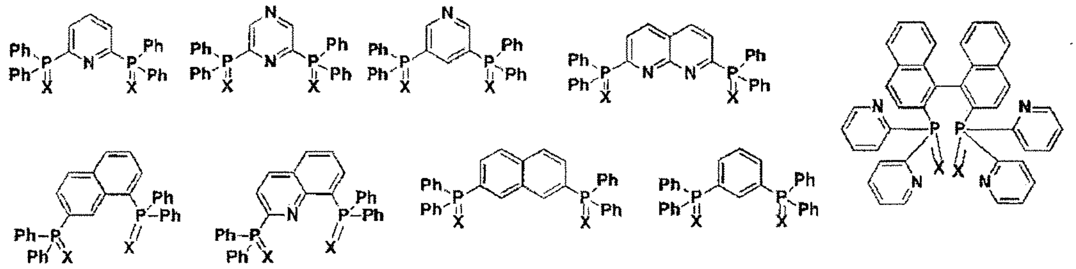

[Chemical Formula 20-13]

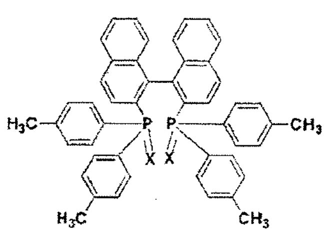
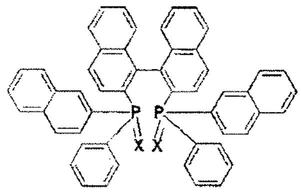
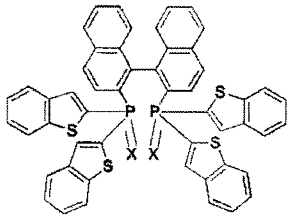
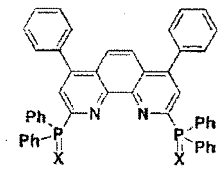
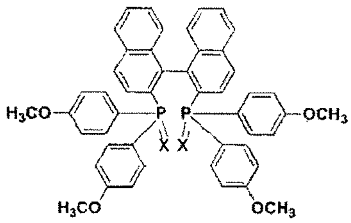
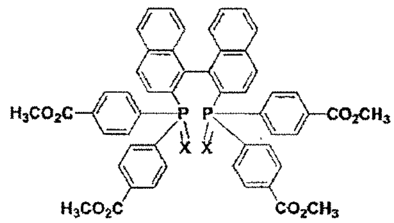
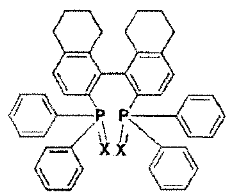
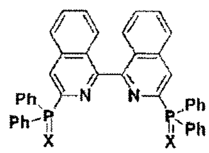
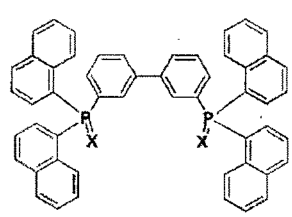
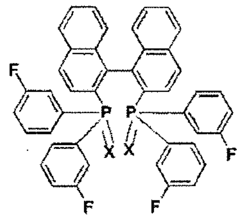

[Chemical Formula 20-14]

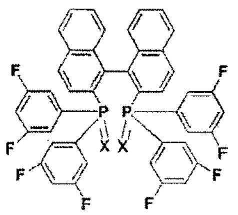
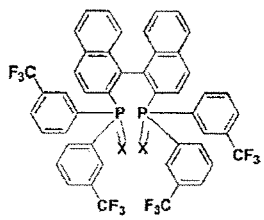
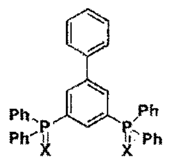
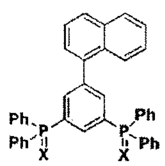
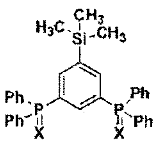
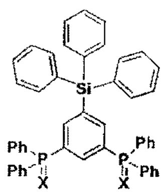
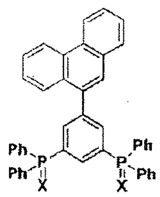
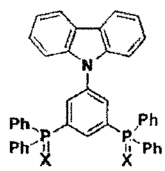
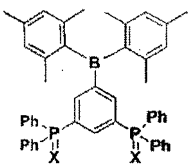
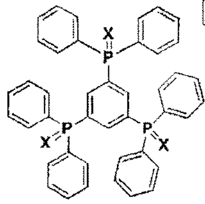
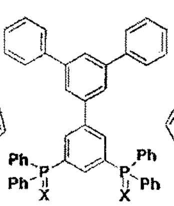
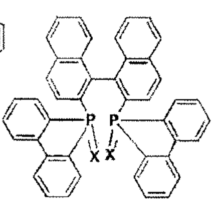
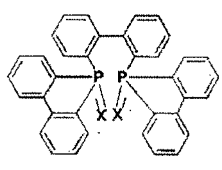
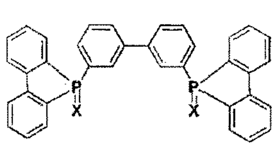

[Chemical Formula 20-15]

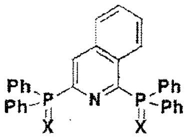
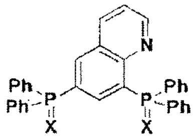
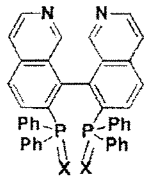
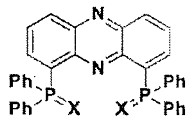
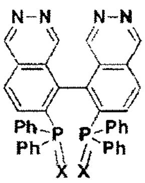
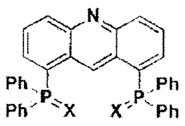
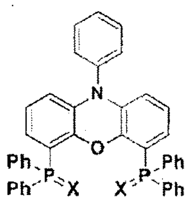
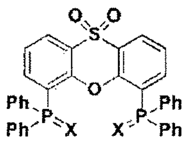
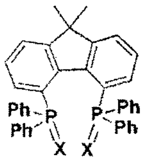
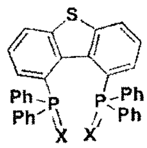
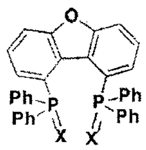
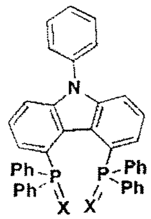
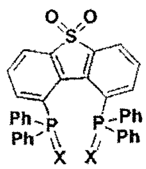
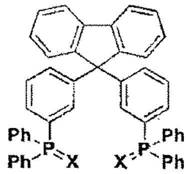
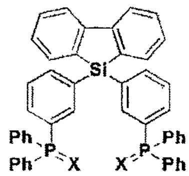

[Chemical Formula 20-16]

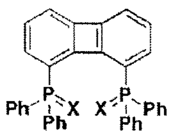
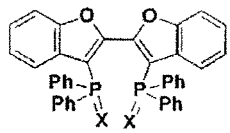
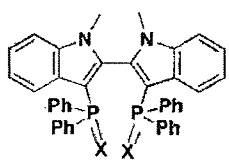
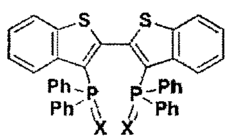
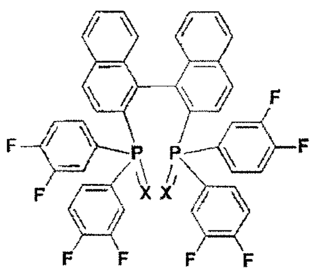
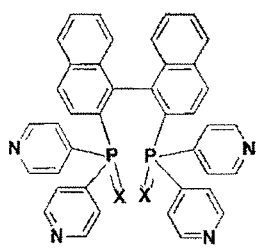
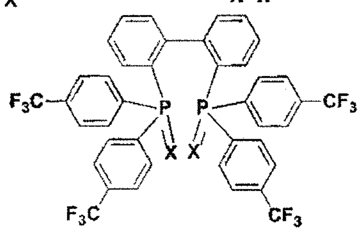
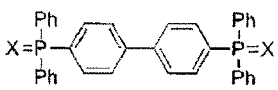
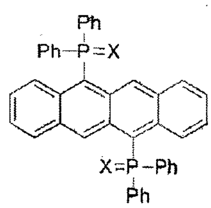
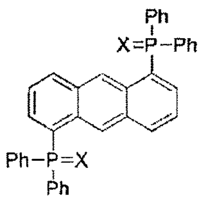
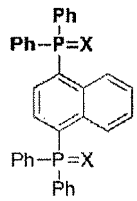
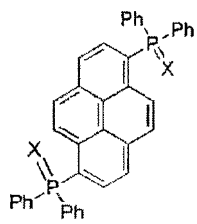
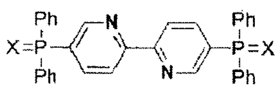
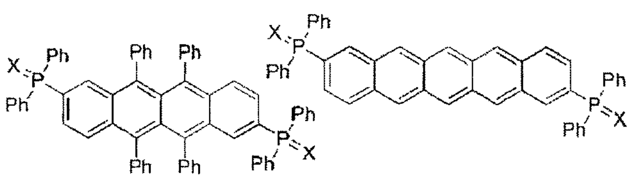
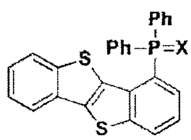
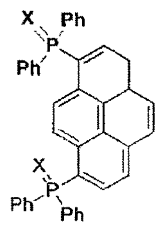

[Chemical Formula 20-17]

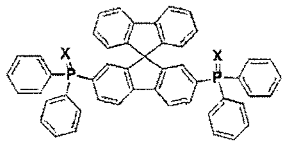
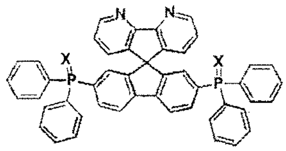
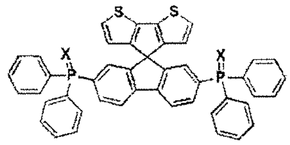
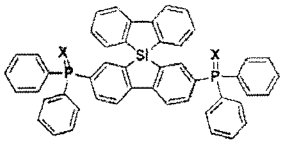
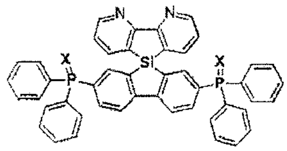
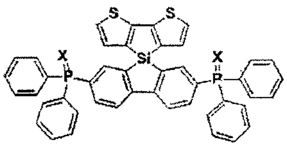
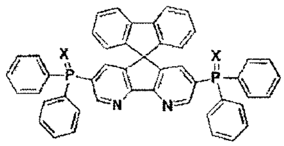
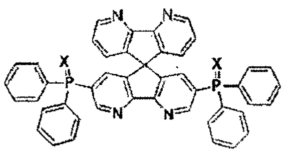
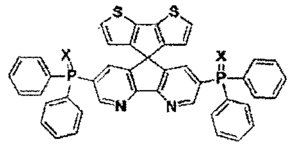
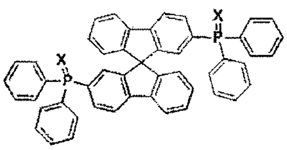
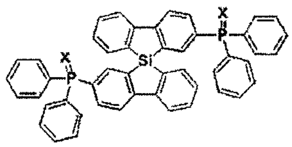
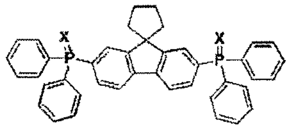

[Chemical Formula 20-18]

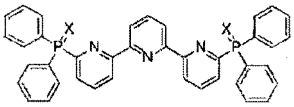
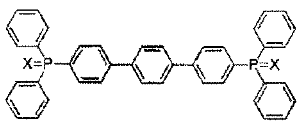
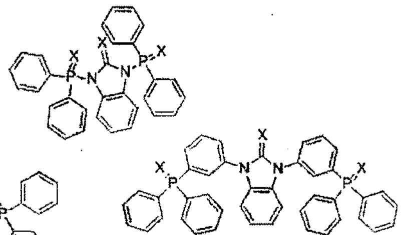
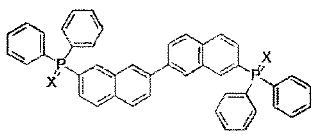
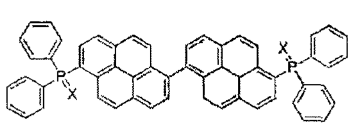
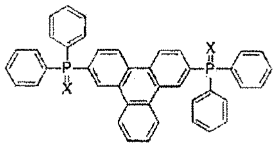
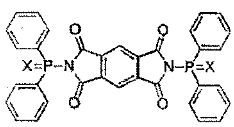
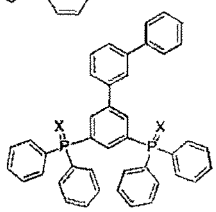
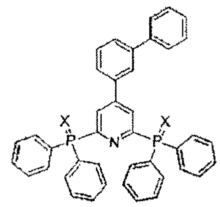

[Chemical Formula 20-19]

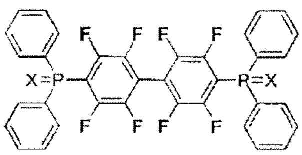
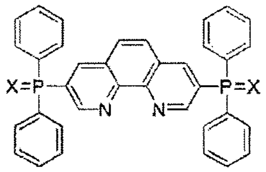
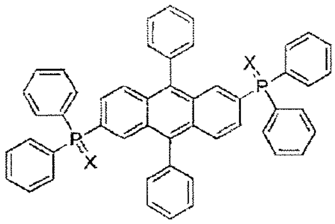
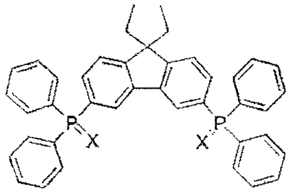
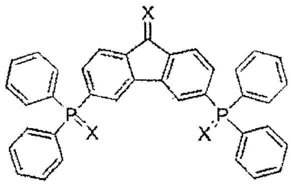
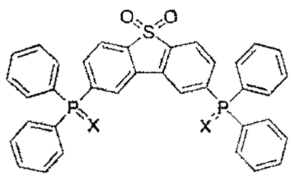
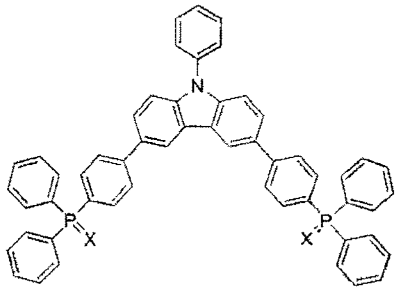
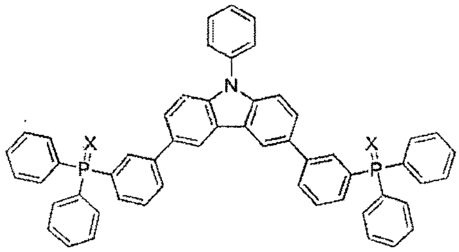

[Chemical Formula 20-20]

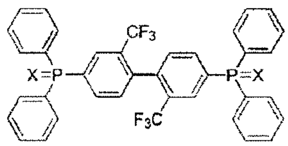
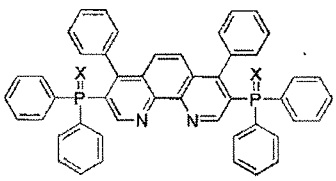
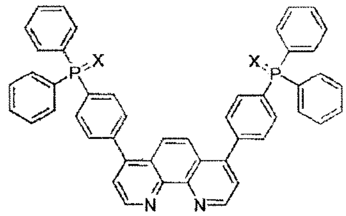
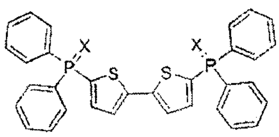
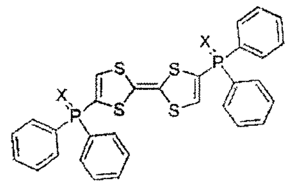
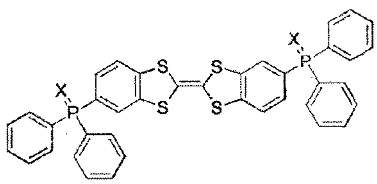
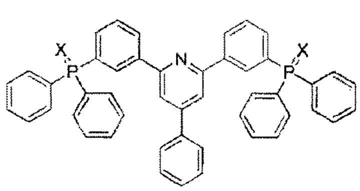
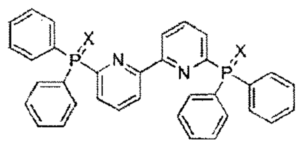
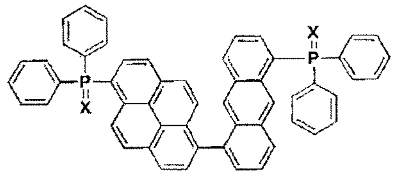

[Chemical Formula 20-21]

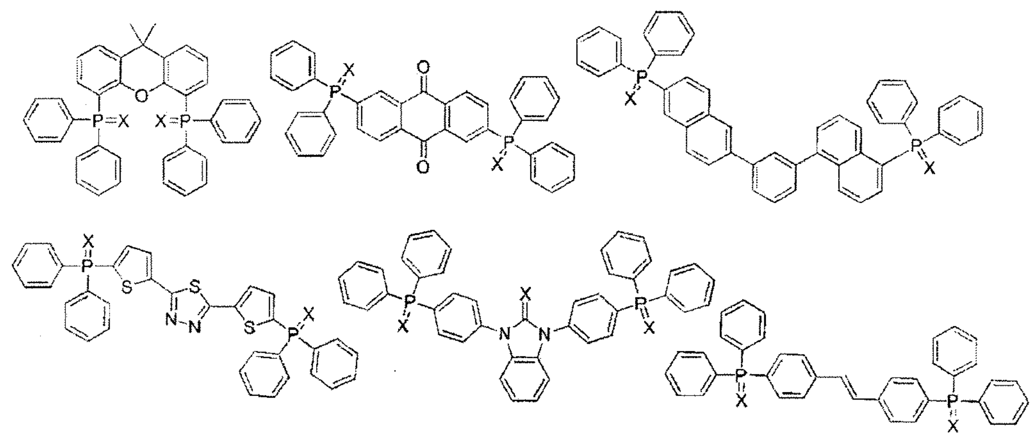

[Chemical Formula 20-22]

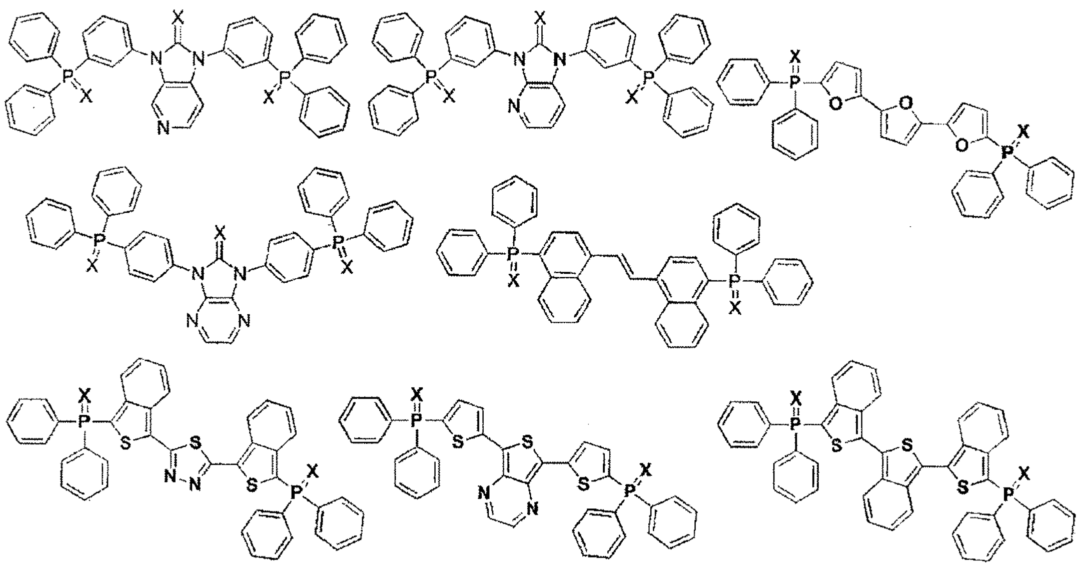

[Chemical Formula 20-23]

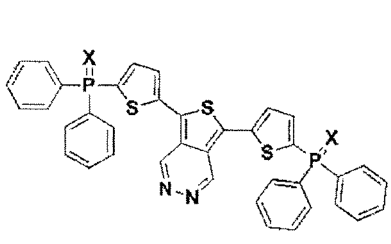
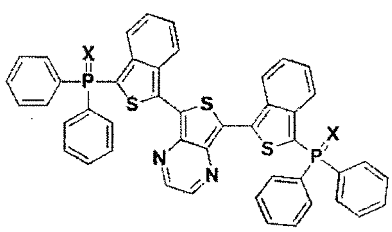
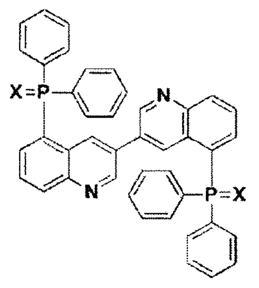

[Chemical Formula 20-24]

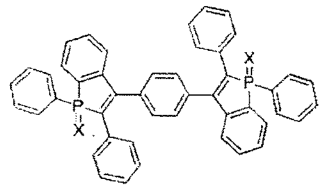
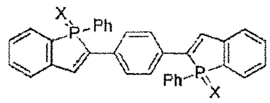
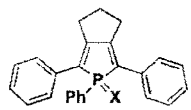
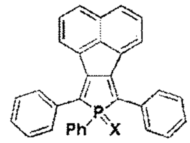

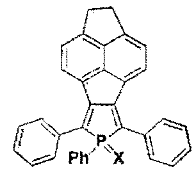
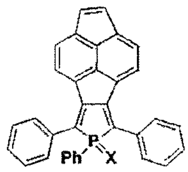
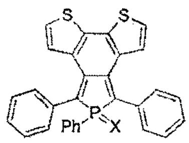
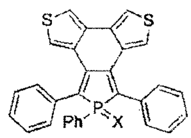
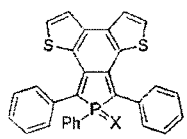

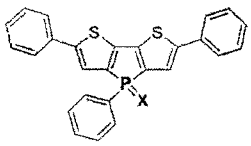
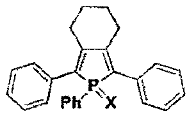
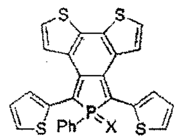
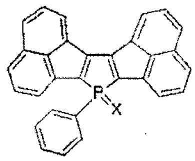
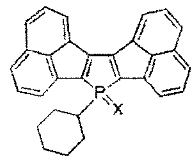

[Chemical Formula 20-25]

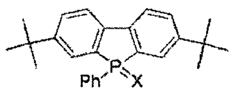
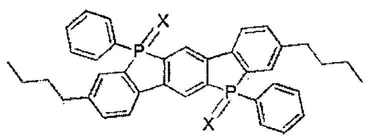
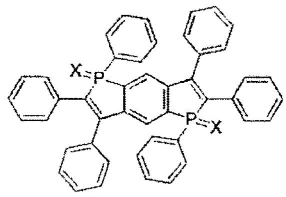

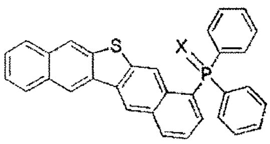
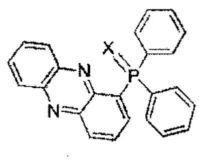
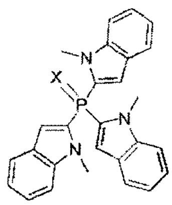

[Chemical Formula 20-26]

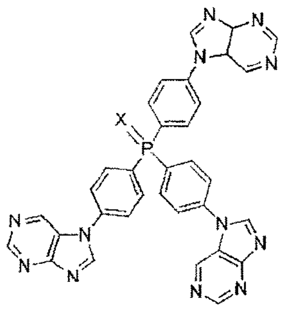 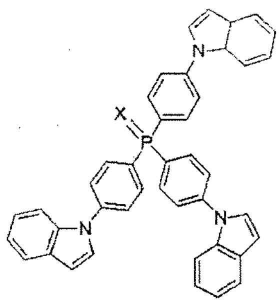 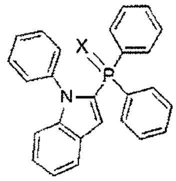 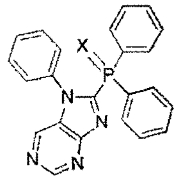

[Chemical Formula 20-27]

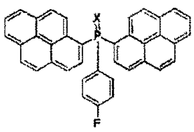 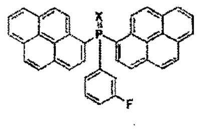 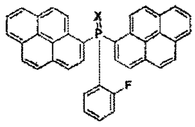 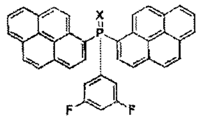 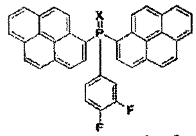

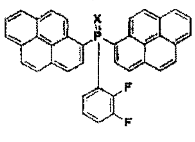 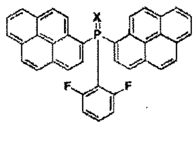 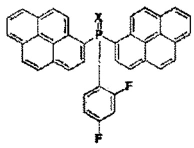 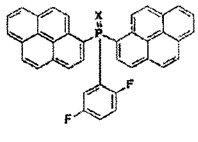 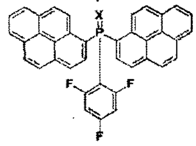

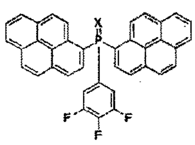 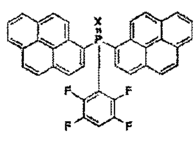 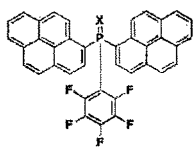 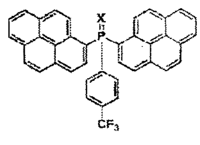 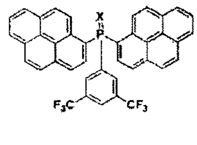

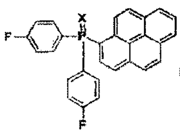 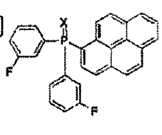 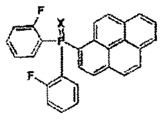 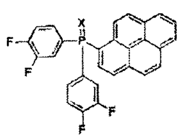 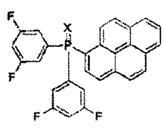 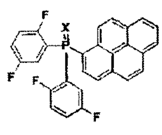

[Chemical Formula 20-28]

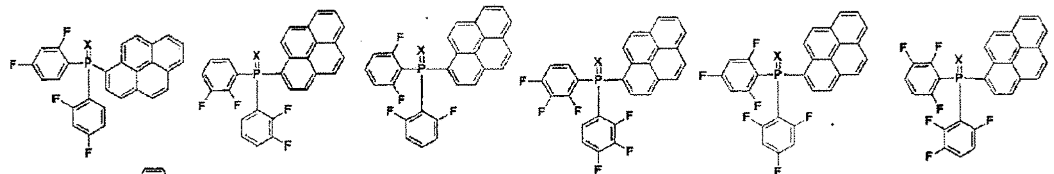

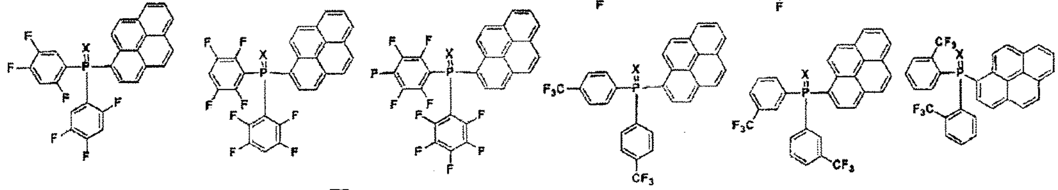

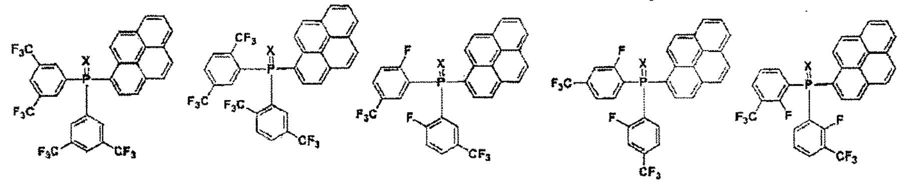

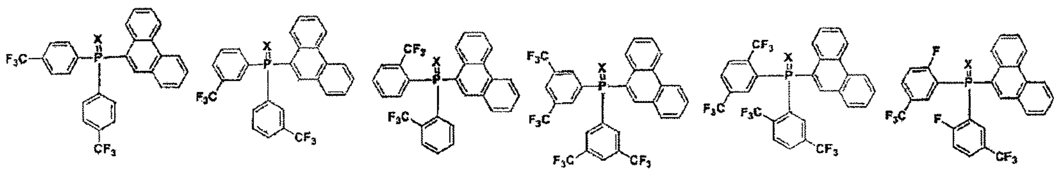

[Chemical Formula 20-29]

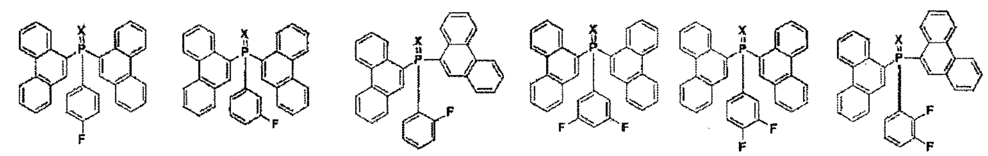

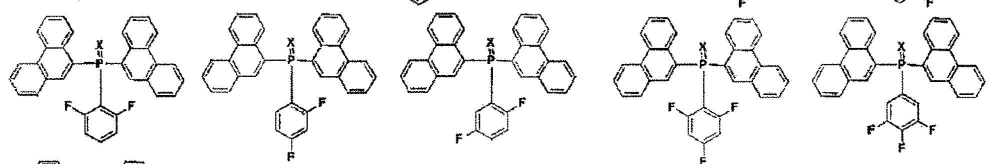

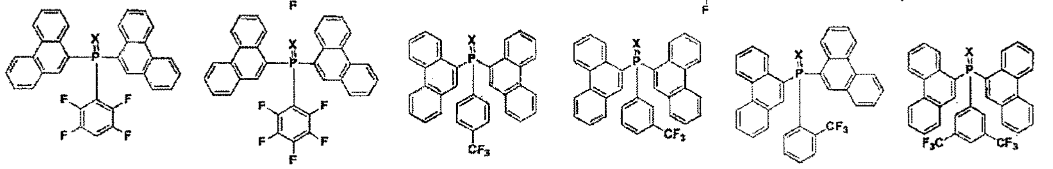

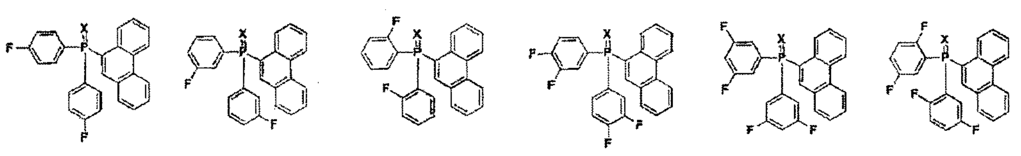

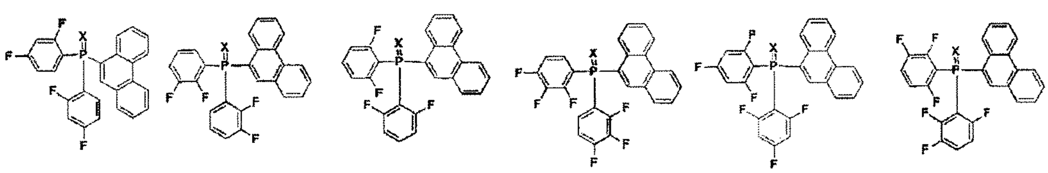

[Chemical Formula 20-30]

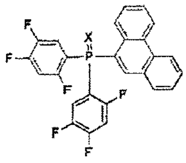 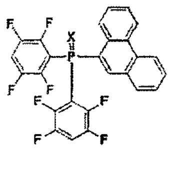 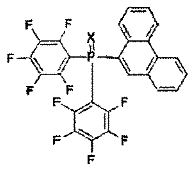 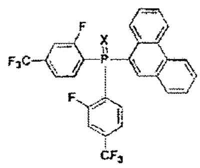 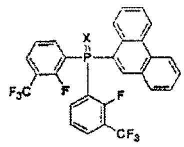

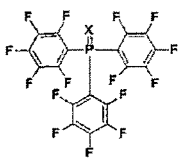 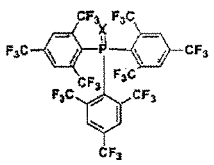 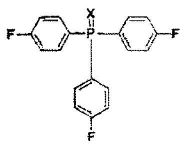 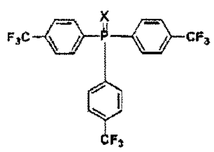 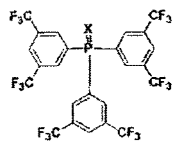

[Chemical Formula 20-31]

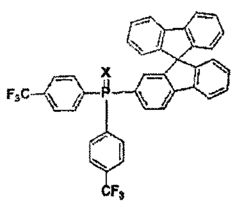 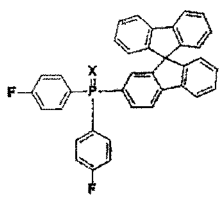 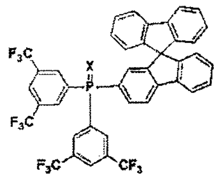 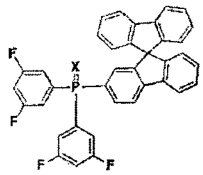

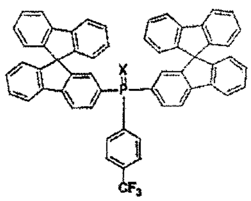 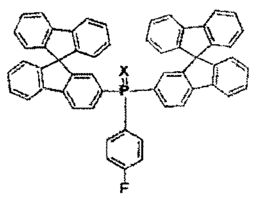 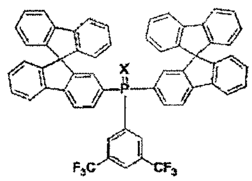 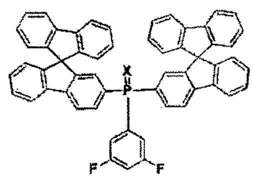

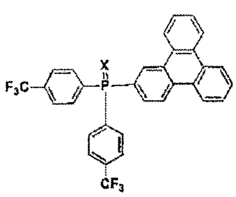 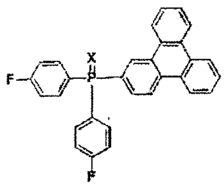 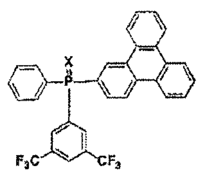 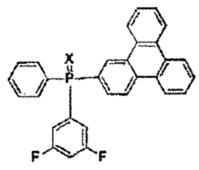

[Chemical Formula 20-32]

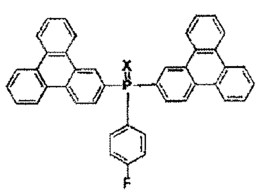 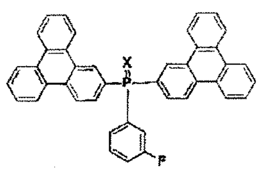 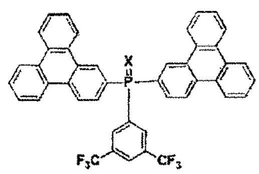 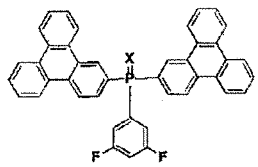

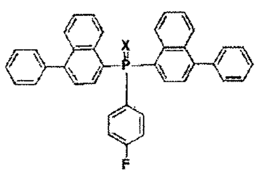 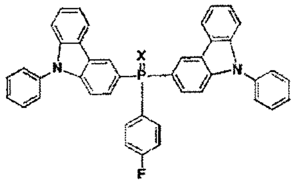 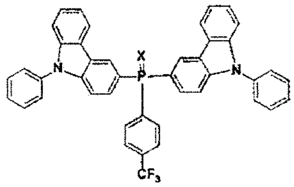 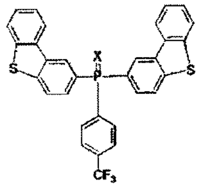

[Chemical Formula 20-33]

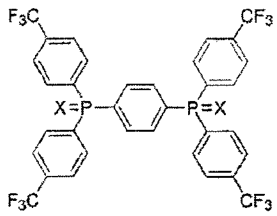
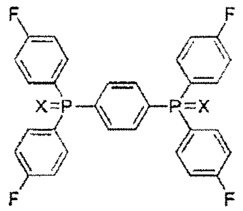
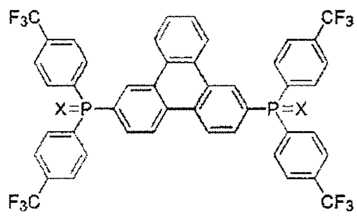
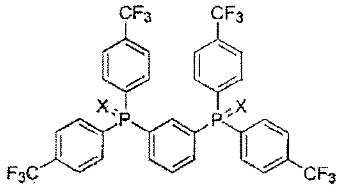
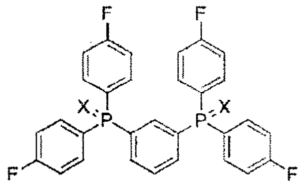
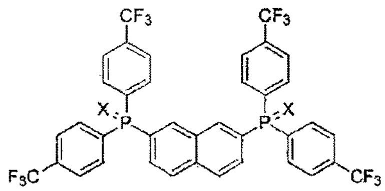
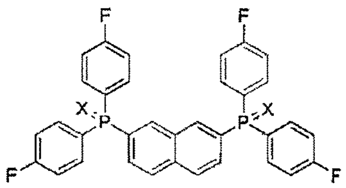
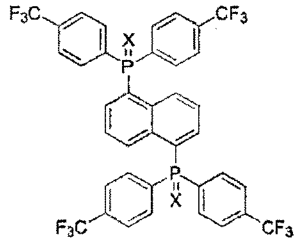
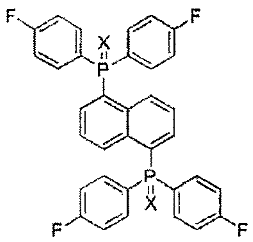

[Chemical Formula 20-34]

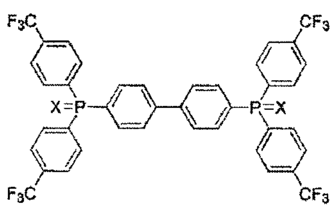
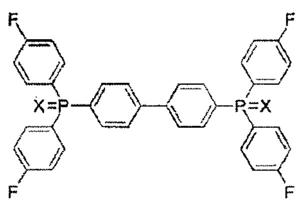
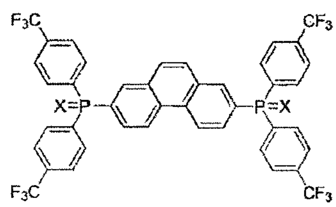
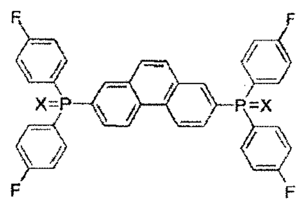
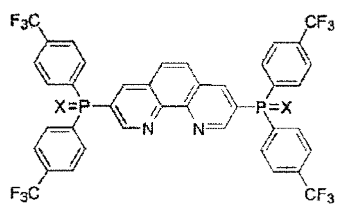
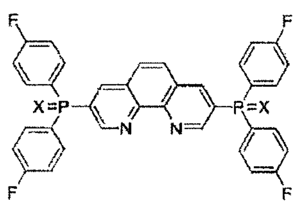
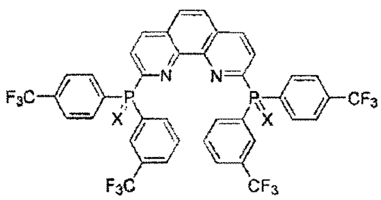
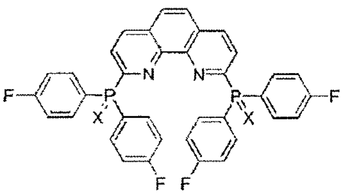
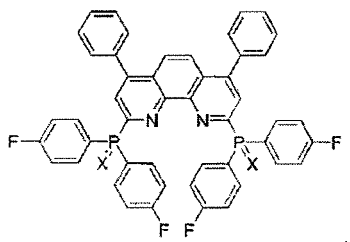

[Chemical Formula 20-35]

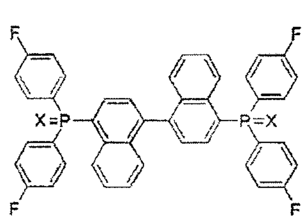
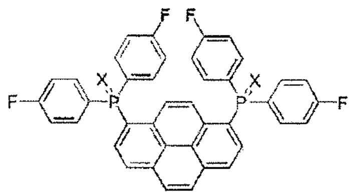
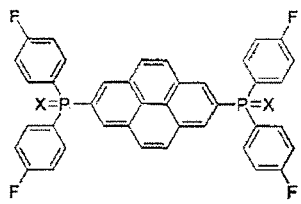
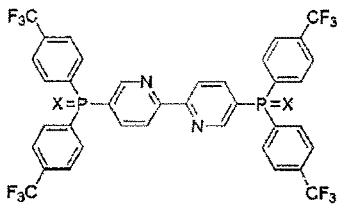
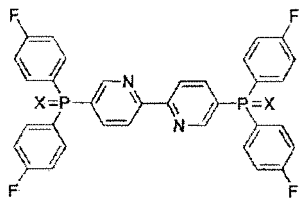
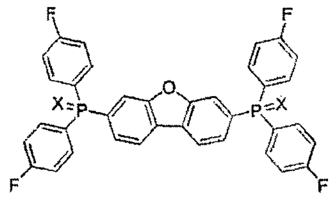
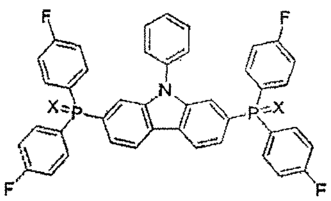
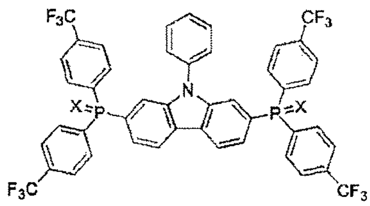
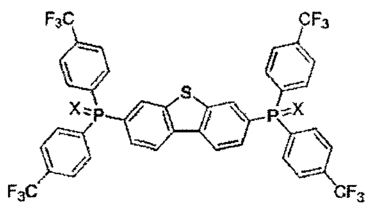

[Chemical Formula 20-36]

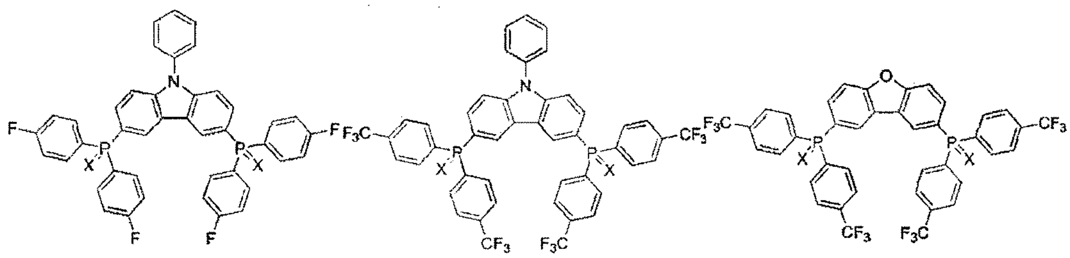
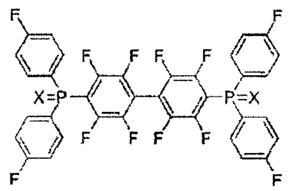
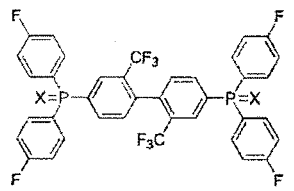
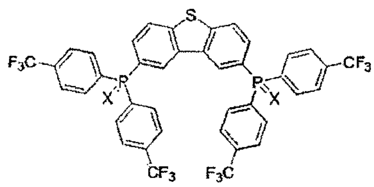

[Chemical Formula 20-37]

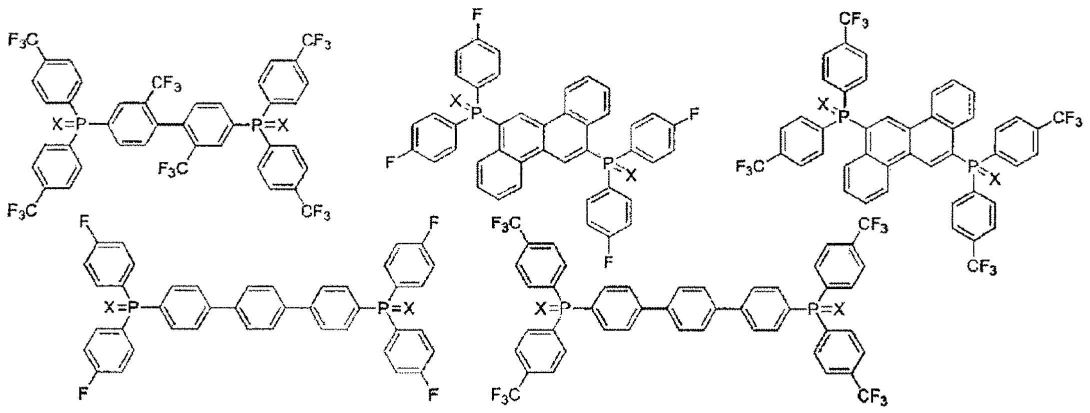

[Chemical Formula 20-38]

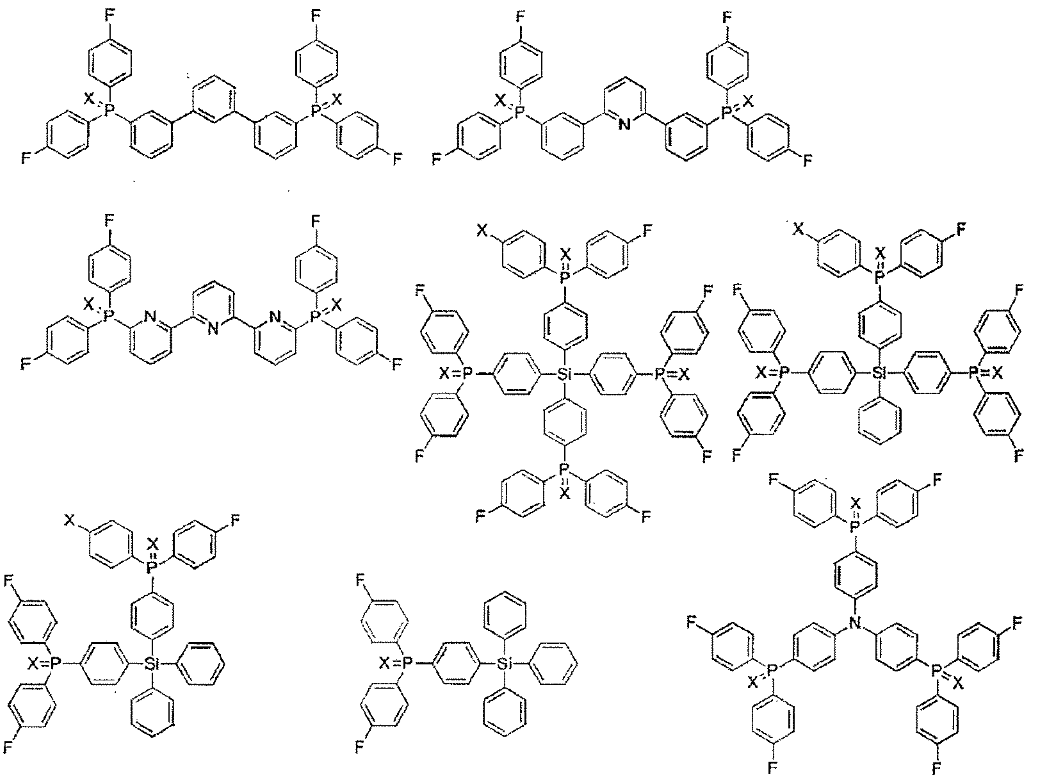

[Chemical Formula 20-39]

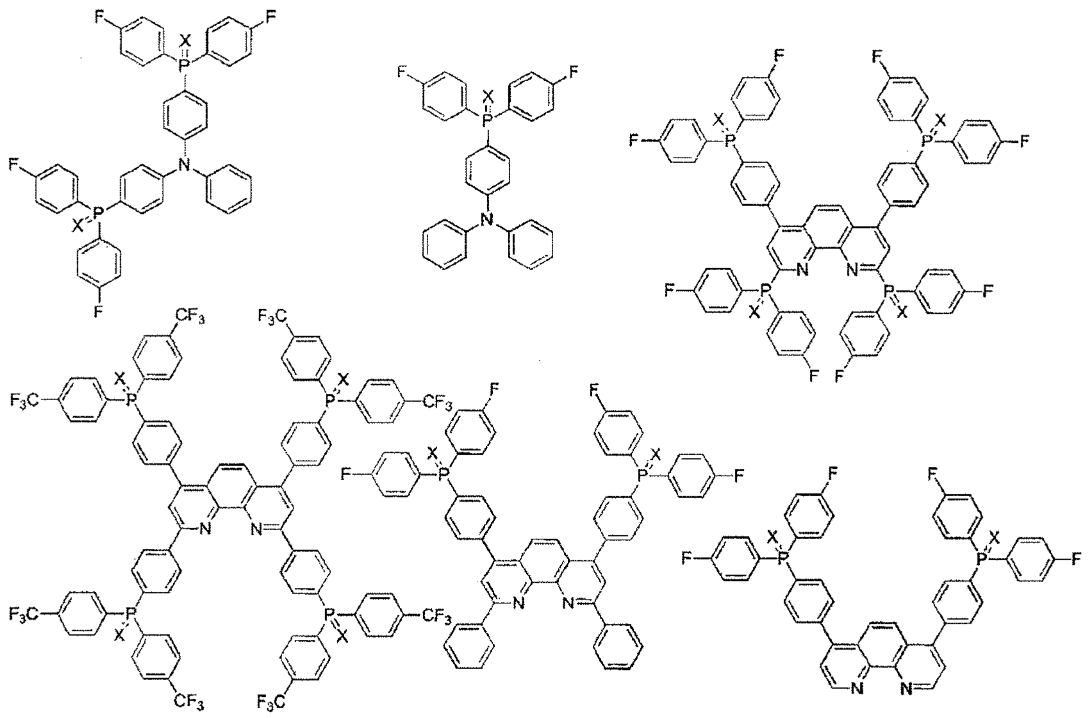

[Chemical Formula 20-40]

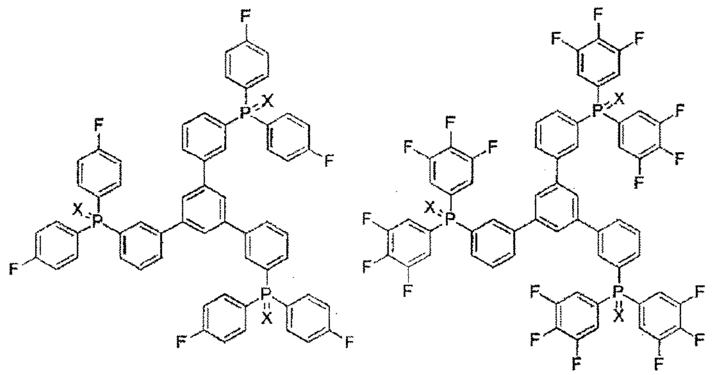

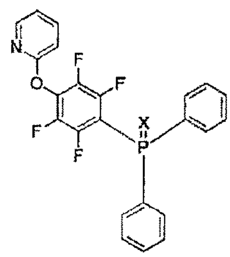

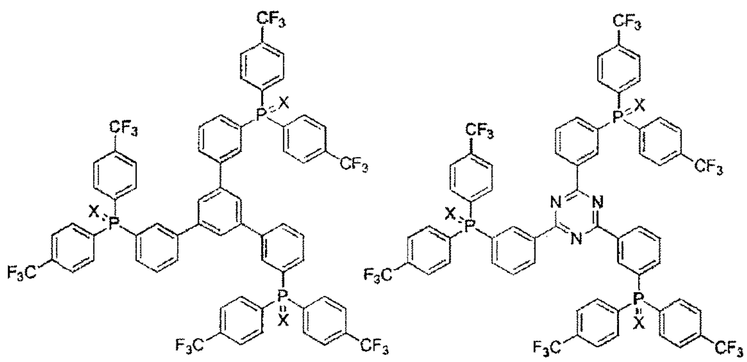

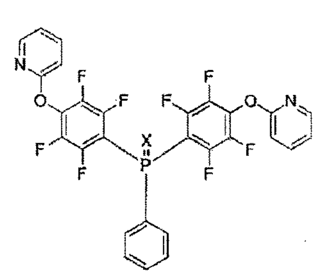

[Chemical Formula 20-41]

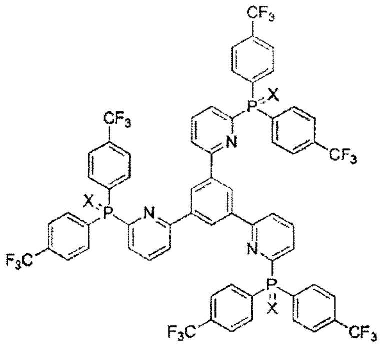

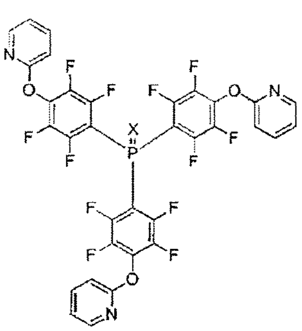

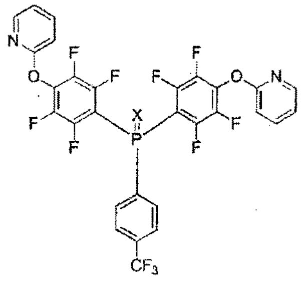

[Chemical Formula 20-42]

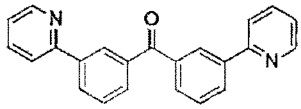

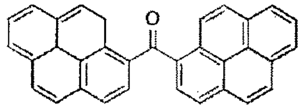

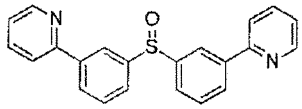

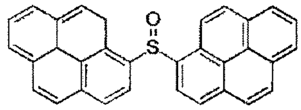

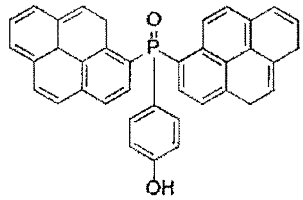

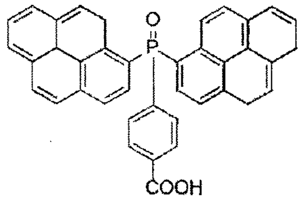

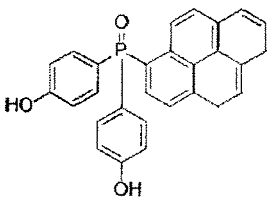

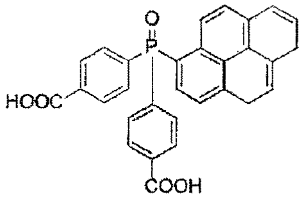

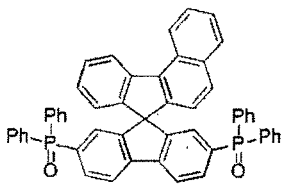

[Chemical Formula 20-43]

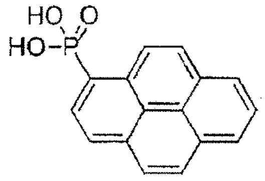

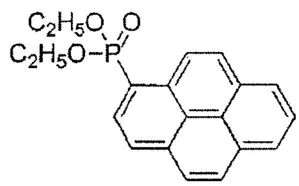

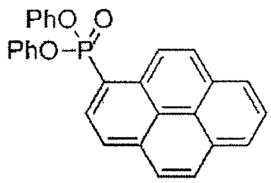

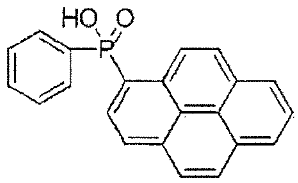

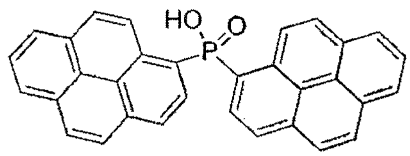

(Method of producing compound having E=X group)

The methods of producing compounds as raw materials for the compounds represented by Formulae (E1) and (P1) above are not particularly limited. For example, they can be synthesized by the methods described in know literature (WO 2011/016430, Japanese Patent Application Publication No. 2011-046697, Journal of the American Chemical Society, 128(17), 5672-5679; 2006, Organic Letters, 10(20), 4637-4640; 2008).

<2-2-6. Hole extraction layer 102>

The material of the hole extraction layer 102 is not particularly limited as long as it is one that can improve the efficiency of hole extraction from the organic active layer 103 to the anode 101. Specific examples include conductive polymers comprising polythiophene, polypyrrole, polyacetylene, triphenylenediamine, polyaniline or the like doped with sulfonic acid and/or iodine or the like, polythiophene derivatives having sulfonyl groups as substituents, arylamines and other electrically conductive organic compounds, and the p-type semiconductor compounds discussed below and the like. Of these, an electrically conductive polymer doped with sulfonic acid is preferred, and poly(3,4-ethylenedioxythiophene)poly(styrenesulfonic acid) (PEDOT:PSS) comprising a polythiophene derivative doped with polystyrene sulfonic acid is more preferred. A thin film of gold, indium, silver, palladium or another metal or the like may also be used. The metal or other thin film may be formed independently, but may also be used combination with the organic materials discussed above.

The film thickness of the hole extraction layer 102 is not particularly limited, but is normally at least 2 nm, and is normally 40 nm or less, or preferably 20 nm or less. Giving the hole extraction layer 102 a film thickness of at least 2 nm allows it to function as a buffer material, while giving the hole extraction layer 102 a film thickness of 40 nm or less serves to facilitate hole extraction and improve photoelectric conversion efficiency.

The method of forming the electron extraction layer 104 and the hole extraction layer 102 is not limited. For example, they can be formed by vacuum deposition or the like using a material that sublimates. Alternatively, they can be formed by a wet coating method such as spin coating or an ink jet method when using a material that is soluble in a solvent. When a semiconductor material is used for the hole extraction layer 102, the layer can be formed using a precursor that is then converted to a semiconductor material as in the case of the low-molecular-weight semiconductor compound of the organic active layer discussed above.

<2-2-7. Electrodes 101, 105>

The electrodes (101 and 105) of the present invention have the function of collecting holes and electrons generated by light absorption. Thus, an electrode 101 suited to hole collection (hereunder sometimes called an anode) and an electrode 105 suited to electron collection (hereunder sometimes called a cathode) are preferably used as the pair of electrodes. Either one of the pair of electrodes may be translucent, or both may be translucent. Translucent here means the property of transmitting 40% or more of sunlight. Moreover, the transparent electrode preferably has solar ray transmittance of 70% or more to allow light to pass through the transparent electrode and reach the active layer. Light transmittance can be measured with an ordinary spectrophotometer.

An electrode 101 (anode) suited to hole collection is normally made of a conductive material having a higher work function value than the cathode, and has the function of smoothly extracting the holes generated in the organic active layer 103.

The anode 101 may be of a material such as nickel oxide, tin oxide, indium oxide, indium tin oxide (ITO), indiumzirconium

oxide (IZO), titanium oxide, indium oxide, zinc oxide or another conductive metal oxide, or a metal such as gold, platinum, silver, chromium or cobalt, or an alloy thereof.

Because these materials have high work functions, they are desirable because they can be laminated with conductive polymeric materials such as PEDOT/PSS (comprising a polythiophene derivative doped with polystyrene sulfonic acid). When such a conductive polymeric material is laminated with the anode material, a wide range of metals suited to cathodes, such as Al and Mg, can also be used even though these materials do not have such high work functions because the work function of the conductive polymeric material is high.

Moreover, PEDOT/PSS (comprising a polythiophene derivative doped with polystyrene sulfonic acid) and conductive polymeric materials comprising polypyrrole or polyaniline doped with iodine or the like can also be used as anode materials.

When the anode 101 is a transparent electrode, it is desirable to use a translucent conductive metal oxide such as ITO, zinc oxide or tin oxide, and ITO is especially desirable.

The film thickness of the anode 101 is not particularly limited, but is normally at least 10 nm, or preferably at least 20 nm, or more preferably at least 50 nm. Also, it is normally 10 μm or less, or preferably 1 μm or less, or more preferably 500 nm or less. Sheet resistance can be controlled if the film thickness of the anode 101 is at least 10 nm, while light can be efficiently converted to electricity without loss of light transmittance if the film thickness of the anode 101 is 10 μm or less. In the case of a transparent electrode, the film thickness must be chosen so as to obtain both light transmittance and sheet resistance.

The sheet resistance of the anode 101 is not particularly limited, but is normally at least 1 Ω/□, and is normally 1,000 Ω/□ or less, or preferably 500 Ω/□ or less, or more preferably 100 Ω/□ or less.

The method of forming the anode 101 is preferably a vacuum film-forming method using sputtering or vapor deposition or the like, or a method of film formation by coating of an ink containing nanoparticles or a precursor.

The electrode 105 (cathode) suited to electron collection is normally made of a conductive material having a higher work function than the anode, and has the function of smoothly extracting electrons generated by organic active layer 103, and adjoins the electron extraction layer 104 of the present invention.

The material of the cathode 105 may be a metal or an alloy of a metal such as platinum, gold, silver, copper, iron, tin, zinc, aluminum, indium, chromium, lithium, sodium, potassium, cesium, calcium or magnesium; an inorganic salt such as lithium fluoride or cesium fluoride; or a metal oxide such as nickel oxide, aluminum oxide, lithium oxide or cesium oxide. These materials are desirable because they have low work functions. As in the case of the anode 101, a material having a high work function suited to the anode 101 can also be used as the cathode 105 if titania or another n-type semiconductor having electrical conductivity is used for the electron extraction layer 104. From the standpoint of electrode protection, platinum, gold, silver, copper, iron, tin, aluminum, calcium, indium and other metals and oxides using these metals are preferred as the material of the anode 101.

The film thickness of the cathode 105 is not particularly limited, but is normally at least 10 nm, or preferably at least 20 nm, or more preferably at least 50 nm, and is also normally 10 μm or less, or preferably 1 μm or less, or more preferably 500 nm or less. In the case of a transparent electrode, the film thickness must be chosen so as to achieve both light transmittance and sheet resistance. Sheet resistance is controlled if the film thickness of the cathode 105 is at least 10 nm, while light can be efficiently converted to electricity without loss of light transmittance if the film thickness of the cathode 105 is 10 μm or less.

The sheet resistance of the cathode 105 is not particularly limited, but is normally 1,000 Ω/□ or less, or preferably 500 Ω/□ or less, or more preferably 100 Ω/□ or less. There is no particular lower limit, but normally it is at least 1 Ω/□.

The method of forming the cathode 105 is preferably a vacuum film-forming method using sputtering or vapor deposition or the like, or method of film formation by coating of an ink containing nanoparticles or a precursor.

Two or more layers can also be laminated for the anode 101 or cathode 105, and their properties (electrical properties, wetting properties and the like) may also be improved by surface treatment.

After the anode 101 and cathode 105 are laminated, the photoelectrical conversion element is preferably heat treated at a temperature range of normally at least 50°C, or preferably at least 80°C, and normally 300°C or less or preferably 280°C or less or more preferably 250°C or less (this step is sometimes called the annealing step). A temperature of 50°C or more is desirable in the annealing step because it has the effect of improving the adhesion between the electron extraction layer 104 and the electrode 101 and/or between the electron extraction layer 104 and the active layer 103. A temperature of 300°C or less is preferred in the annealing step because there is less likelihood of thermal decomposition of the organic compound of the active layer.

For the temperature program, heating can be performed in stages within this range.

The heating time is normally at least 1 minute, or preferably at least 3 minutes, and is normally 3 hours or less, or preferably 1 hour or less. This annealing is preferably terminated when the solar cell performance values (open voltage, short-circuit current and fill factor) reach specific values. Annealing is preferably performed under normal pressure in an inactive gas atmosphere.

Because this annealing step improves adhesion between the electron extraction layer 104 and the electrode

101 and/or between the electron extraction layer 104 and the active layer 103, it has the effect of improving the thermal stability and durability of the photoelectric conversion element, and promoting self-organization of the organic active layer. Heating may be accomplished by placing the photoelectric conversion element on a hot plate or other heat source, or by placing the photoelectric conversion element in a heated atmosphere in an oven or the like. Heating may also be accomplished either continuously or in batches.

<2-2-8. Substrate 106>

The photoelectric conversion element of the present invention normally has a substrate 106 as a support. That is, the electrodes, active layer and buffer layers are formed on a substrate. The material of the substrate (substrate material) may be any that does not greatly detract from the effects of the present invention. Desirable examples of substrate materials include quartz, glass, sapphire, titania and other inorganic materials; polyethylene terephthalate, polyethylene naphthalate, polyethersulfone, polyimide, nylon, polystyrene, polyvinyl alcohol, ethylene vinyl alcohol copolymer, fluorine resin film, vinyl chloride, polyethylene and other polyolefins, cellulose, polyvinylidene chloride, aramide, polyphenylene sulfide, polyurethane, polycarbonate, polyarylate, polynorbornene, epoxy resin and other organic materials; paper, synthetic paper and other paper materials; and composite materials comprising stainless steel, titanium, aluminum and other metals that have been surface coated or laminated to convey insulating properties and the like.

Examples of glass include soda glass, green glass, alkali-free glass and the like. Alkali-free glass is preferred as a glass material because lower ion elution from the glass is desirable.

The shape of the substrate 106 is not limited, and a plate, film, sheet or other shape may be used. The film thickness of the substrate 106 is also not limited, but is normally at least 5 μm, or preferably at least 20 μm, and is normally no more than 20 mm, or preferably no more than 10 mm. If the film thickness of the substrate is at least 5 μm, it is less likely that the semiconductor device will not be strong enough. A film thickness of 20 mm or less is desirable for controlling costs and weight. In the case of a glass substrate, the film thickness is normally at least 0.01 mm, or preferably at least 0.1 mm, and is preferably 1 cm or less, or preferably 0.5 cm or less. A glass substrate with a film thickness of at least 0.01 mm is desirable for increasing mechanical strength and preventing breakage. A film thickness of 0.5 cm or less is preferred for controlling weight.

[3. Solar cell module]

<3-1. Solar cell module 13>

The photoelectric conversion element 107 of the present invention is preferably used as a solar cell element of a solar cell and particularly a thin-film solar cell.

Fig. 2 is a cross-section schematically illustrating the configuration of a thin-film solar cell of one embodiment. As shown in Fig. 2, the thin-film solar cell 14 of this embodiment comprises a weather-resistant protective film 1, an ultraviolet exclusion film 2, a gas barrier film 3, a getter film 4, a seal material 5, a solar cell element 6, a seal material 7, a getter film 8, a gas barrier film 9, and a back sheet 10 in that order. The solar cell element 6 generates electricity when it is exposed to light from the side with the formed weather-resistant film 1 (bottom of drawing). The getter film 8 and/or the gas barrier film 9 may be omitted when using a highly water-resistant sheet as the back sheet 10 (discussed below), such as a sheet comprising a fluorine resin film affixed to both surfaces of an aluminum foil.

<3-2. Weather-resistant protective film>

The weather-resistant protective film 1 is a film that protects the solar cell element 6 from weather changes. Some of the constituent parts of the solar cell element 6 may deteriorate from corrosion and the like caused by temperature changes, humidity changes, natural light and/or wind and rain. Therefore, the solar cell element 6 and the like are protected from weather changes and the like, and high power-generating performance is maintained by covering the solar cell element 6 with the weather-resistant protective film 1.

Because the weather-resistant protective film 1 is located in the outermost layer of the thin-film solar cell 14, it preferably has properties suited to a surface covering material for the thin-film solar cell 14, including weather resistance, heat resistance, transparency, water repellency, stain resistance and/or mechanical strength, and also preferably maintains these properties for a long period of time when exposed outdoors.

Moreover, the weather-resistant protective film 1 preferably transmits visible light so as not to impede the light absorption of the solar cell element 6. For example, the transmittance of visible light (wavelength 360 nm to 830 nm) is preferably at least 80%, or more preferably at least 90%, or especially at least 95%.

Because the thin-film solar cell 14 is heated when it receives light, moreover, the weather-resistant protective film 1 is preferably resistant to heat. From this standpoint, the melting point of the constituent material of the weather-resistant protective film 1 is normally at least 100°C, or preferably at least 120°C, or more preferably at least 130°C, and is normally no more than 350°C, or preferably no more than 320°C, or more preferably no more than 300°C. The likelihood of melting and deterioration of the weather-resistant protective film 1 during use of the thin-film solar cell 14 can be reduced by giving it a high melting point.

The material that constitutes the weather-resistant protective film 1 may be any that can protect the solar cell element 6 from weather changes. Examples of this material include polyethylene resin, polypropylene resin, cyclic polyolefin resin, AS (acrylonitrile-styrene) resin, ABS (acrylonitrile-butadiene-styrene) resin, polyvinyl chloride resin, fluorine resin, polyethylene terephthalate, polyethylene naphthalate and other polyester resins, phenol resin, polyacrylic resin, various nylons and other polyamide resins, polyimide resin, polyamide-imide resin, polyurethane resin, cellulose resin, silicone resin, polycarbonate resin and the like.

Of these, a fluorine resin is preferred, and specific examples include polytetrafluoroethylene (PTFE), tetrafluoroethylene-perfluoroalkoxyethylene copolymer (PFA), tetrafluoroethylene-hexafluoropropylene copolymer (FEP), ethylene-tetrafluoroethylene copolymer (ETFE), polychlorotrifluoroethylene (PCTFE), polyvinylidene fluoride (PVDF), polyvinyl fluoride (PVF) and the like.

The weather-resistant protective film 1 may be formed of one kind of material, or of two or more kinds of materials. Moreover, the weather-resistant protective film 1 may be formed as a monolayer film, or as a laminate film comprising two or more film layers.

The thickness of the weather-resistant protective film 1 is not specified, but is normally at least 10 μm, or preferably at least 15 μm, or more preferably at least 20 μm, and is normally 200 μm or less, or preferably 180 μm or less, or more preferably 150 μm or less. Increasing the thickness tends to increase physical strength, while decreasing it tends to improve flexibility.

The weather-resistant protective film 1 may also be subjected to corona treatment and/or plasma treatment or other surface treatment to improve adhesion with the other films.

The weather-resistant protective film 1 is preferably provided as much as possible on the outside of the thin-film solar cell 14, so that it can protect as many as possible of the constituent parts of the thin-film solar cell 14.

<3-3. Ultraviolet exclusion film 2>

The ultraviolet exclusion film 2 is a film for blocking transmission of ultraviolet rays.

Some of the constituent parts of the thin-film solar cell 14 are degraded by ultraviolet rays. Moreover, depending on the kinds of gas barrier films 3 and 9 and the like they may also be degraded by ultraviolet rays. Therefore, ultraviolet exclusion film 2 is provided on the light-receiving part of the thin-film solar cell 14 so as to cover the light-receiving surface 6a of the solar cell element 6, thereby protecting the solar cell element 6 and the gas barrier films 3 and 9 and the like as necessary from ultraviolet rays, so that the electric generating capacity can be maintained at a high level.

The required UV transmittance inhibition ability of the ultraviolet exclusion film 2 is preferably such as to achieve no more than 50%, or more preferably no more than 30%, or still more preferably no more than 10% transmittance of UV rays (for example, at a wavelength of 300 nm).

Moreover, the ultraviolet exclusion film 2 preferably transmits visible light so as not to hinder the light absorption of the solar cell element 6. For example, it preferably has at least 80% or more preferably at least 90% or still more preferably at least 95% transmittance of visible light (wavelength 360 nm to 830 nm).

Moreover, the ultraviolet exclusion film 2 is preferably resistant to heat because the thin-film solar cell 14 is heated when it receives light. From this standpoint, the melting point of the constituent material of the ultraviolet exclusion film 2 is normally at least 100°C, or preferably at least 120°C, or more preferably at least 130°C, and is normally 350°C or less, or preferably 320°C or less, or more preferably 300° or less. If the melting point is too low the ultraviolet exclusion film 2 may melt during use of the thin-film solar cell 14.

The ultraviolet exclusion film 2 is preferably highly flexible, has good adhesiveness with the adjacent films, and is also capable of excluding water vapor and oxygen.

The material making up the ultraviolet exclusion film 2 may be any that can weaken the strength of ultraviolet rays. Examples of such materials include films and the like comprising ultraviolet absorbers compounded with epoxy, acrylic, urethane or ester resins. It is also possible to use a film comprising a layer of an ultraviolet absorber dispersed or dissolved in a resin (hereunder called an "UV absorbing layer"), formed on a base film.

The ultraviolet absorber may be a salicylic, benzophenone, benzotriazole or cyanoacrylate ultraviolet absorber. Of these, a benzophenone or benzotriazole absorber is preferred. Examples include a variety of benzophenone and benzotriazole aromatic organic compounds and the like. One kind of ultraviolet absorber may be used, or any two or more kinds may be combined and used in any proportions.

As discussed above, a film comprising a UV absorbing layer formed on a base film may be used as an ultraviolet absorbing film. Such a film may be prepared for example by coating a base film with a coating solution containing an ultraviolet absorber, and drying the solution.

The material of the base film is not particularly limited, but may be polyester for example in order to provide a film with a good balance of weather resistance and flexibility.

Coating can be accomplished by any method. Examples include reverse roll coating, gravure coating, kiss coating, roll brushing methods, spray coating, air-knife coating, wire bar coating, pipe doctor methods, impregnation and coating methods or curtain coating or the like. One method may be used alone, or any two or more methods may be combined.

The solvent used in the coating solution is not particularly limited as long as it can uniformly dissolve or disperse the ultraviolet absorber. A liquid resin may be used as the solvent for example, and examples include polyester, acrylic, polyamide, polyurethane, polyolefin, polycarbonate, polystyrene and various other synthetic resins and the like. Gelatin and cellulose derivatives and other natural polymers, water, and mixed solvents of water and ethanol and other alcohols can also be used the solvent. An organic solvent may also be used as the solvent. Using an organic solvent, it is possible to dissolve or disperse a dye or resin, and thereby improve the coating properties. One kind of solvent may be used, or any two or more may be combined in any proportions.

A surfactant may also be included in the coating solution. By using a surfactant, it is possible to improve the dispersibility of the ultraviolet absorbing dye in the resin. It is thus possible to control gaps caused by fine bubbles, indentations caused by adhesion of foreign matter, and/or cissing during the drying process and the like.

A known surfactant (cationic surfactant, anionic surfactant or non-ionic surfactant) may be used as the surfactant. Of these, a silicone surfactant or fluorine surfactant is preferred. One kind of surfactant may be used, or any two or more may be combined in any proportions.

After the coating solution has been coated on the base film, it can be dried by a known method such as hot air drying or drying with an infrared heater. Of these, hot air drying is preferred for its rapid drying rate.

Examples of specific products for ultraviolet exclusion film 2 include Cut-Ace (MKV plastic Co., Ltd.) and the like.

The ultraviolet exclusion film 2 may be formed of one kind of material, or of two or more kinds of materials. Also, the ultraviolet exclusion film 2 may be formed as a monolayer film, or as a laminate film comprising two or more film layers.

The thickness of the ultraviolet exclusion film 2 is not particularly limited, but is normally at least 5 μm, or preferably at least 10 μm, or more preferably at least 15 μm, and is normally no more than 200 μm, or preferably no more than 180 μm, or more preferably no more than 150 μm. Absorption of ultraviolet tends to be greater when the thickness is greater, while transmittance of visible light tends to be greater when it is thin.

The ultraviolet exclusion film 2 can be provided in a location where it covers at least part of the light-receiving surface 6a of the solar cell element 6, but is preferably provided in a location where it covers all of the light-receiving surface 6a of the solar cell element 6.

However, the ultraviolet exclusion film 2 may also be provided in another location in addition to the location where it covers the light-receiving surface 6a of the solar cell element 6.

<3-4. Gas barrier film 3>

The gas barrier film 3 is a film to prevent permeation of water and oxygen.

The solar cell element 6 tends to be vulnerable to water vapor and oxygen, and in particular ZnO:Al and other transparent electrodes, compound semiconductor solar cell elements and organic solar cell elements may be degraded by moisture and oxygen. It is possible to protect the solar cell element 6 against water and oxygen and maintain the electric generating capacity at a high level by covering the solar cell element 6 with a gas barrier film 3.

The degree of moisture-proofing performance required of the gas barrier film 3 varies according to the type of solar cell element 6 and the like. For example, when the solar cell element 6 is a compound semiconductor solar cell element, the water vapor transmission rate per day per unit area (1 $m^2$) is preferably $1 \times 10^{-1}$ $g/m^2$/day or less, or more preferably $1 \times 10^{-2}$ $g/m^2$/day or less, or still more preferably $1 \times 10^{-3}$ $g/m^2$/day or less, or yet more preferably $1 \times 10^{-4}$ $g/m^2$/day or less, or especially $1 \times 10^{-5}$ $g/m^2$/day or less, or most preferably $1 \times 10^{-6}$ $g/m^2$/day or less.

When the solar cell element 6 is an organic solar cell element, the water vapor transmission rate per day per unit area (1 $m^2$) is preferably $1 \times 10^{-1}$ $g/m^2$/day or less, or more preferably $1 \times 10^{-2}$ $g/m^2$/day or less, or still more preferably $1 \times 10^{-3}$ $g/m^2$/day or less, or yet more preferably $1 \times 10^{-4}$ $g/m^2$/day or less, or especially $1 \times 10^{-5}$ $g/m^2$/day or less, or most preferably $1 \times 10^{-6}$ $g/m^2$/day or less. The less the water vapor permeates the film, the more deterioration of the solar cell element 6 and the ZnO:Al or other transparent electrode of this element 6 due to reactions with moisture can be controlled, thus improving power generating efficiency and extending the life of the cell.

The degree of oxygen permeability required of the gas barrier film 3 varies depending on the type of the solar cell element 6 and the like. For example, when the solar cell element 6 is a compound semiconductor solar cell element, the oxygen transmission rate per day per unit area (1 $m^2$) is preferably $1 \times 10^{-1}$ $cc/m^2$/day/atm or less, or more preferably $1 \times 10^{-2}$ $cc/m^2$/day/atm or less, or still more preferably $1 \times 10^{-3}$ $cc/m^2$/day/atm or less, or yet more preferably $1 \times 10^{-4}$ $cc/m^2$/day/atm or less, or especially $1 \times 10^{-5}$ $cc/m^2$/day/atm or less, or most preferably $1 \times 10^{-6}$ $cc/m^2$/day/atm or less.

When the solar cell element 6 is an organic solar cell element, the oxygen transmission rate per day per unit area (1 $m^2$) is preferably $1 \times 10^{-1}$ cc/$m^2$/day/atm or less, or more preferably $1 \times 10^{-2}$ cc/$m^2$/day/atm or less, or still more preferably $1 \times 10^{-3}$ cc/$m^2$/day/atm or less, or yet more preferably $1 \times 10^{-4}$ cc/$m^2$/day/atm or less, or especially $1 \times 10^{-5}$ cc/$m^2$/day/atm or less, or most preferably $1 \times 10^{-6}$ cc/$m^2$/day/atm or less. The less oxygen permeates the film, the more deterioration of the solar cell element 6 and the ZnO:Al or other transparent electrode of this element 6 due to oxidation can be controlled.

In the past it was difficult to achieve a solar cell having a superior solar cell element such as a compound semiconductor solar cell element or organic solar cell element because of the difficulty of mounting a gas barrier film 3 having such moisture exclusion and oxygen barrier properties, but with such a gas barrier film 3 it is easy to achieve a thin-film solar cell 14 which exploits the desirable properties of a compound semiconductor solar cell element, organic solar cell element or the like.

The gas barrier film 3 also preferably transmits visible light so as not to impede the light absorption of the solar cell element 6. For example, the transmittance of visible light (wavelength 360 nm to 830 nm) is normally at least 60%, or preferably at least 70%, or more preferably at least 75%, or still more preferably at least 80%, or yet more preferably at least 85%, or especially at least 90%, or most preferably at least 95%, or ideally at least 97%. In this way, more solar light can be converted to electrical energy.

Moreover, the gas barrier film 3 is preferably also resistant to heat because the thin-film solar cell 14 is often heated when it receives light. From this standpoint, the melting point of the constituent material of the gas barrier film 3 is normally at least 100°C, or preferably at least 120°C, or more preferably at least 130°C, and is normally 350°C or less, or preferably 320°C or less, or more preferably 300° or less. The likelihood of melting and deterioration of the gas barrier film 3 during use of the thin-film solar cell 14 can be reduced by giving it a high melting point.

The gas barrier film 3 may be constituted in any way as long as it can protect the solar cell element 6 from water. However, because a film that allows less water vapor and oxygen to pass through the gas barrier film 3 also has higher manufacturing costs, these considerations must be balanced when selecting the film.
The constitution of the gas barrier film 3 is explained below with examples.

The following are two preferred examples of the constitution of the gas barrier film 3.
The first example is a film comprising an inorganic barrier layer disposed on a plastic film base. In this case, the inorganic barrier layer may be formed on one side of the plastic film base, or may be formed on both sides of the plastic film base. When it is formed on both sides, the number of inorganic barrier films formed on the two sides may be the same or different on both sides.

The second example is a film comprising a two-layer unit layer consisting of an inorganic barrier layer and a polymer layer disposed adjacent to one another, formed on a plastic film base. In this case, the unit layer consisting of an inorganic barrier layer and a polymer layer disposed adjacent to one another is considered as one unit, and one unit of this unit layer (meaning one unit consisting of one inorganic barrier layer and one polymer layer) may be formed, or two or more may be formed. For example, 2 to 5 layers may be laminated.

The unit layer may be formed on only one side of the plastic film base, or may be formed on both sides of the plastic film base. When it is formed on both sides, the number of inorganic barriers layers and polymer layers formed on the two sides may be the same or different on both sides. When the unit layer is formed on the plastic film base, it is possible to form the inorganic barrier layer first and then form the polymer layer on top, or to form the polymer layer first and then form the inorganic barrier layer on top.

(Plastic film base)

The plastic film base used in the gas barrier film 3 is not particularly limited as long as it is a film capable of holding the inorganic barrier layer and polymer layer, and can be selected appropriately according to the intended use of the gas barrier film 3 and the like.
Examples of the material of the plastic film base include polyester resin, polyarylate resin, polyethersulfone resin, fluorene ring-denatured polycarbonate resin, alicyclic ring-denatured polycarbonate resin or acryloyl compounds. Those using condensed polymers including spirobiindan and spirobicromane are also desirable. Of the polyester resins, biaxially-stretched polyethylene terephthalate (PET) or biaxially-stretched polyethylene naphthalate (PEN) can be used favorably as plastic film bases because of their superior thermal dimensional stability.

The material of the plastic film base may be of one kind, or any two or more kinds may be combined in any proportions.
The thickness of the plastic film base is not particularly limited, but is normally at least 10 μm, or preferably at least 15 μm, or more preferably at least 20 μm, and is normally 200 μm or less, or preferably 180 μm or less, or more preferably 150 μm or less. Increasing the thickness tends to increase the mechanical strength, while reducing it tends to increase flexibility.

The plastic film base preferably transmits visible light so as not to impede the light absorption of the solar cell element 6. For example, the transmittance of visible light (wavelength 360 nm to 830 nm) is normally at least 60%, or

preferably at least 70%, or more preferably at least 75%, or still more preferably at least 80%, or yet more preferably at least 85%, or especially at least 90%, or most preferably at least 95%, or ideally at least 97%. In this way, more solar light can be converted to electrical energy.

The plastic film base may be formed with a layer of an anchor coat agent (anchor coat layer) in order to improve adhesion with the inorganic barrier layer. Normally, the anchor coat layer is formed by coating an anchor coat agent. Examples of anchor coat agents include polyester resin, urethane resin, acrylic resin, oxazoline group-containing resins, carboxydiimide group-containing resins, epoxy group-containing resins, isocyanate-containing resins and copolymers of these and the like. Of these, a combination of at least one kind of resin selected from the polyester resins, urethane resins and acrylic resins with at least one kind of resin selected from the oxazoline group-containing resins, carbodiimide group-containing resins, epoxy group-containing resins and isocyanate group-containing resins is preferred. One kind of anchor coat agent may be used, or any two or more may be combined in any proportions.

The thickness of the anchor coat layer is normally at least 0.005 μm, or preferably at least 0.01 μm, and is normally 5 μm or less, or preferably 1 μm or less. The slippage properties are good if the thickness is at or below the upper limit, and there is virtually no peeling of the anchor coat itself from the plastic film base due to internal stress. Moreover, it is easy to maintain a uniform thickness if the thickness is at or above the lower limit.

To improve the coating properties and adhesive properties of the anchor coat agent on the plastic film base, the plastic film base may be subjected to ordinary chemical treatment, discharge treatment or other surface treatment before the anchor coat agent is coated.

(Inorganic barrier layer)

The inorganic barrier layer is normally a layer formed of a metal oxide, nitride or oxynitride. One kind of metal oxide, nitride or oxynitride may be used to form the inorganic barrier layer, or any two or more kinds may be combined in any proportions.

Examples of metal oxides include oxides of Si, Al, Mg, In, Ni, Sn, Zn, Ti, Cu, Ce, Ta or the like. Of these, it is desirable to include aluminum oxide or silicon oxide in order to achieve both good barrier properties and high transparency, and particularly desirable to include silicon oxide from the standpoint of moisture permeability and light ray permeability in particular.

The respective metal atoms and oxygen atoms may be in any proportions, but in order to improve the transparency of the inorganic barrier layer and prevent coloration, the proportion of oxygen atoms is preferably not much smaller than the stoichiometric ratio of the oxide. On the other hand, reducing the number of oxygen atoms is desirable for increasing the density of the inorganic barrier layer and improving the barrier properties. From this standpoint, when using $SiO_x$ as a metal oxide for example, an x value of 1.5 to 1.8 is especially desirable. When using $AlO_x$ as a metal oxide for example, an x value of 1.0 to 1.4 is especially desirable.

When the inorganic barrier layer is constituted from two or more metal oxides, the metal oxides preferably include aluminum oxide and silicon oxide. When the inorganic barrier layer consists of aluminum oxide and silicon oxide, the aluminum and silicon can be in any proportions in the inorganic gas barrier layer, but the Si/Al ratio is normally at least 1/9, or preferably at least 2/8, and is normally 9/1 or less, or preferably 8/2 or less.

The barrier properties tend to be greater when the inorganic barrier layer is thicker, but a smaller thickness is desirable for suppressing cracks and preventing breaks when the film is bent. Therefore, an appropriate thickness of the inorganic barrier layer is normally at least 5 nm, or preferably at least 10 nm, and is normally 1,000 nm or less, or preferably 200 nm or less.

The method of forming the inorganic barrier layer is not particularly limited, but normally it can be formed by sputtering, vacuum deposition, ion plating, plasma CVD or the like. In the case of sputtering for example, it can be formed by a reactive sputtering system using plasma, with one or more kinds of metal targets and oxygen gas as the raw materials.

(Polymer layer)

Any polymer can be used in the polymer layer, and for example it is possible to use one that forms a film in a vacuum chamber. One kind of polymer may be used to constitute the polymer layer, or any two or more kinds may be used in any proportions.

A wide variety of compounds can be used to provide the polymer, and examples include those such as (i) to (vii) below. One kind of monomer may be used, or any two or more kinds can be used in any proportions.

(i) Examples include hexamethyldisiloxane and other siloxanes. When using hexamethyldisiloxane, one method of forming the polymer layer is to introduce hexamethyldisiloxane in vapor form into a parallel plate-type plasma unit using RF electrodes, producing a polymerization reaction in the plasma, and deposit the hexamethyldisiloxane on the plastic film base to thereby form a polysiloxane thin film as a polymer layer for example.

(ii) Other examples include diparaxylene and other paraxylenes. When using diparaxylene, one method of

forming the polymer layer is for example to heat diparaxylene vapor in a high vacuum at 650°C to 700°C to thermally decompose the vapor and generate thermal radicals. This radical monomer vapor is then introduced into a chamber, and adsorbed on the plastic film base while at the same time a radical polymerization reaction is performed to deposit polyparaxylene and form a polymer layer.

(iii) Other examples include monomers that can be used to form a polymer by addition polymerization of two alternating monomers. The resulting polymer is a polyaddition polymer. Examples of polyaddition polymers include polyurethane(diisocyanate/glycol), polyurea(diisocyanate/diamine), polythiourea(dithioisocyanate/diamine), polythioetherurethane(bisethyleneurethane/dithiole), polyimine(bisepoxy/primary amine), polypeptidoamido(bisazolactone/diamine) or polyamido(diolefin/diamide) and the like.

(iv) Other examples include acrylate monomers. Acrylate monomers include monofunctional, bifunctional and polyfunctional acrylate monomers, and any of these may be used. However, a combination of two or more kinds of acrylate monomers is preferred for obtaining a suitable evaporation rate, degree of curing and/or curing rate and the like. Examples of monofunctional acrylate monomer include aliphatic acrylate monomers, alicyclic acrylate monomers, ether acrylate monomers, cyclic ether acrylate monomers, aromatic acrylate monomers, hydroxyl group-containing acrylate monomers or carboxyl group-containing acrylate monomers and the like, and any of these may be used.

(v) Other examples include epoxy monomers, oxetane monomers and other monomers that yield light- and cation-curable polymers. Examples of epoxy monomers include alicyclic epoxy monomers, bifunctional monomers, polyfunctional oligomers and the like. Examples of oxetane monomers include monofunctional oxetanes, bifunctional oxetanes, and oxetanes having silsesquioxane structures and the like.

(vi) Another example is vinyl acetate. When vinyl acetate is used as a monomer, polyvinyl alcohol is obtained by saponifying the polymer, and this polyvinyl alcohol can be used as a polymer.

(vii) Other examples include acrylic acid, methacrylic acid, ethacrylic acid, fumaric acid, maleic acid, itaconic acid, monomethyl maleate, monoethyl maleate, anhydrous maleic acid, anhydrous itaconic acid and other unsaturated carboxylic acids and the like. These can be used to constitute copolymers with ethylene, and these copolymers can be used as the polymer. Mixtures of these, mixtures of these mixed with glycidyl ether compounds, and mixtures of these with epoxy compounds can also be used as the polymer.

When polymerizing these monomers to produce the polymer, the method of polymerizing the monomers is not limited. However, a composition containing the monomer is normally first coated or deposited to form a film, which is then polymerized. As an example of a polymerization method, polymerization is initiated by contact heating using a heater or the like or by radiant heating using infrared rays, microwaves or the like when using a thermal polymerization initiator. When using a photopolymerization initiator, polymerization is initiated by irradiation with active energy rays. Various light sources can be used for irradiating with active energy rays, such as for example a mercury arc lamp, xenon arc lamp, fluorescent lamp, carbon arc lamp, tungstenhalogen incandescent lamp or sunlight or the like. Electron beam irradiation or atmospheric-pressure plasma treatment may also be used.

The polymer layer may be formed by a method such as coating, vacuum film formation or the like.

When the polymer layer is formed by a coating method, a method such as roll coating, gravure coating, knife coating, dip coating, curtain coating, spray coating, bar coating or the like may be used. The coating solution for forming the polymer layer can also be applied in mist form. In this case, the average particle diameter of the droplets can be adjusted within a suitable range, and for example when forming a film on a plastic film base with a mist of a coating solution containing a polymerizable monomer, the average particle diameter of the droplets is normally 5 μm or less, or preferably 1 μm or less.

When the polymer layer is formed by vacuum film formation, on the other hand, a film-forming method such as vapor deposition or plasma CVD may be used.

The thickness of the polymer layer is not particularly limited, but is normally at least 10 nm, and is normally 5,000 nm or less, or preferably 2,000 nm or less, or more preferably 1,000 nm or less. With a thicker polymer layer it is easier to obtain a uniform thickness, and structural defects in the inorganic barrier layer can be efficiently buried under the polymer layer, which tends to improve the barrier properties. With a thinner polymer layer, on the other hand, the barrier properties are improved because there is less likelihood of cracks in the polymer layer itself due to bending and other external stress.

Of these, a film comprising $SiO_x$ vacuum deposited on a polyethylene terephthalate (PET) or polyethylene naphthalate (PEN) or other base film is an example of preferred gas barrier film 3.

The gas barrier film 3 may be formed of one kind of material or of two or more kinds of materials. Also, the gas barrier film 3 may be formed as a monolayer film, but may also be a laminate film comprising two or more film layers.

The thickness of the gas barrier film 3 is not particularly limited, but is normally at least 5 μm, or preferably at least 10 μm, or more preferably at least 15 μm, and is normally 200 μm or less, or preferably 180 μm or less, or more preferably 150 μm or less. Making the film thicker tends to increase the gas barrier properties, while making it thinner tends to improve flexibility and increase the transmittance of visible light.

The gas barrier film 3 may be formed in any location where it can cover the solar cell element 6 and protect it from moisture and oxygen, but preferably it covers the front surface (surface on the light-receiving side; lower surface in Fig. 2) and the reverse surface (surface opposite the light-receiving side; upper surface in Fig. 2) of the solar cell element 6. This is because the front surface and reverse surface are often formed with larger areas than other surfaces in the thin-film solar cell 14. In this embodiment, the gas barrier film 3 covers the front surface of the solar cell element 6, and a gas barrier film 9 (discussed below) covers the reverse surface of the solar cell element 6. When a highly waterproof sheet such as sheet comprising a fluorine resin film affixed to both surfaces of an aluminum foil is used as the back sheet 10 (discussed below), the getter film 8 and/or gas barrier film 9 may be omitted for some applications.

<3-5. Getter film 4>

A getter film 4 is a film that absorbs moisture and/or oxygen. Some of the constituent parts of the solar cell element 6 are degraded by moisture as discussed above, and some are degraded by oxygen. Therefore, covering the solar cell element 6 with the getter film 4 serves to protect the solar cell element 6 and the like from moisture and/or oxygen, so that the electric generating capacity can be maintained at a high level.

Unlike the gas barrier film 3 above, the getter film 4 does not prevent moisture permeation, but instead absorbs moisture. By using a film that absorbs moisture, the slight amount of moisture that penetrates the space formed by the gas barrier films 3 and 9 can be captured by the getter film 4, thereby eliminating the effects of moisture on the solar cell element 6.

The moisture absorption ability of the getter film 4 is normally at least 0.1 $mg/cm^2$, or preferably at least 0.5 $mg/cm^2$, or more preferably at least 1 $mg/cm^2$. The higher this value the greater the water absorption ability, and the more deterioration of solar cell element 6 can be prevented. There is no upper limit, but 10 $mg/cm^2$ or less is normal.

Because the getter film 4 absorbs oxygen, if the solar cell element 6 is covered with the gas barrier films 3 and 9, the slight amount of oxygen that penetrates the space formed by the gas barrier films 3 and 9 can be captured by the getter film 4, thereby eliminating the effects of oxygen on the solar cell element 6.

The getter film 4 preferably transmits visible light so as not to impede the light absorption of the solar cell element 6. For example, the transmittance of visible light (wavelength 360 nm to 830 nm) is normally at least 60%, or preferably at least 70%, or more preferably at least 75%, or still more preferably at least 80%, or yet more preferably at least 85%, or especially at least 90%, or most preferably at least 95%, or ideally at least 97%. In this way, more solar light can be converted to electrical energy.

Moreover, the getter film 4 is preferably also resistant to heat because the thin-film solar cell 14 is often heated when it receives light. From this standpoint, the melting point of the constituent material of the getter film 4 is normally at least 100°C, or preferably at least 120°C, or more preferably at least 130°C, and is normally no more than 350°C, or preferably no more than 320°C, or more preferably no more than 300°. The likelihood of melting and deterioration of the getter film 4 during use of the thin-film solar cell 14 can be reduced by giving it a high melting point.

The material making up the getter film 4 may be any that is capable of absorbing moisture and/or oxygen. Examples of such materials include such water-absorbing substances as alkali metals, alkali earth metals or alkali earth metal oxides; alkali metal or alkali earth metal hydroxides; silica gel, zeolite compounds, magnesium sulfate, sodium sulfate, nickel sulfate or other sulfate salts; and aluminum metal complexes, aluminum oxide octylate or other organic metal compounds and the like. Specific examples of alkali earth metals include Ca, Sr, Ba and the like. Oxides of alkali earth metals include CaO, SrO, BaO and the like. Other examples include Zr-Al-BaO, aluminum metal complexes and the like. Specific products include OleDry (FUTABA CORPORATION) and the like.

Examples of substances that absorb oxygen include active carbon, silica gel, active alumina, molecular sieves, magnesium oxide, iron oxide and the like. Other examples include Fe, Mn, Zn and sulfate salts, chloride salts, nitrate salts and other inorganic salts of these metals.

The getter film 4 may be formed of one kind of material or of two or more kinds of materials. Moreover, the getter film 4 may be formed as a monolayer film, or as a laminate film having two or more film layers.

The thickness of the getter film 4 is not particularly limited, but is normally at least 5 μm, or preferably at least 10 μm, or more preferably at least 15 μm, and is normally 200 μm or less, or preferably 180 μm or less, or more preferably 150 μm or less. Increasing the film thickness tends to increase mechanical strength, while decreasing it tends to increase flexibility.

There are no limitations on the location where the getter film 4 is formed as long as it is within the space formed by the gas barrier films 3 and 9, but preferably it covers the front surface (surface on the light-receiving side; lower surface in Fig. 2) and the reverse surface (surface opposite the light-receiving side; upper surface in Fig. 2) of the solar cell element 6. This is because the front surface and reverse surface are often formed with larger areas than other surfaces in the thin-film solar cell 14, and therefore moisture and oxygen tend to penetrate via these surfaces. From this standpoint, the getter film 4 is preferably provided between the gas barrier film 3 and the solar cell element 6. In this embodiment, the getter film 4 covers the front surface of the solar cell element 6, a getter film 8 (discussed below) covers the reverse

surface of the solar cell element 6, and the getter films 4 and 8 are disposed between the solar cell element 6 and the gas barrier films 3 and 9, respectively. When a highly waterproof sheet such as sheet of aluminum foil with fluorine resin film adhering to both sides is used as a back sheet 10 (discussed below), the getter film 8 and/or gas barrier film 9 may be omitted for some applications.

The getter film 4 can be formed by any method depending on the type of absorbent or drying agent, and for example a film with a absorbent or drying agent dispersed therein can be applied with an adhesive, or a solution of an absorbent or drying agent can be applied by a spin coating method, inkjet method, dispenser method or other coating method. A film-forming method such as vacuum deposition or sputtering can also be used.

The film for the absorbent or drying agent can be one using a polyethylene resin, polypropylene resin, cyclic polyolefin resin, polystyrene resin, acrylonitrile-styrene copolymer (AS resin), acrylonitrile-butadiene-styrene copolymer (ABS resin), polyvinyl chloride resin, fluorine resin, poly(meth)acrylic resin or polycarbonate resin or the like. Of these, a film of a polyethylene resin, fluorine resin, cyclic polyolefin resin or polycarbonate resin is preferred. One kind of resin may be used, or any two or more may be combined in any proportions.

<3-6. Seal material 5>

The seal material 5 is a film that reinforces the solar cell element 6. Because the solar cell element 6 is thin it is normally weak, which tends to weaken the thin-film solar cell, but strength is maintained at a high level by means of the seal material 5.
Moreover, the seal material 5 is preferably strong in order to maintain the strength of the thin-film solar cell 14.

The specific degree of strength is difficult to be pre-determined since it is also related to the strength of the weather-resistant protective film 1 and the back sheet 10 as well as the seal material 5, but preferably the thin-film solar cell 14 as a whole has good bending workability, and is strong enough to prevent peeling of the bent parts.
Moreover, the seal material 5 preferably transmits visible light so as not to impede the light absorption of the solar cell element 6. For example, the transmittance of visible light (wavelength 360 nm to 830 nm) is normally at least 60%, or preferably at least 70%, or more preferably at least 75%, or still more preferably at least 80%, or yet more preferably at least 85%, or especially at least 90%, or most preferably at least 95%, or ideally at least 97%. In this way, more solar light can be converted to electrical energy.

Moreover, the seal material 5 is preferably also resistant to heat because the thin-film solar cell 14 is often heated when it receives light. From this standpoint, the melting point of the constituent material of the seal material 5 is normally at least 100°C, or preferably at least 120°C, or more preferably at least 130°C, and is normally 350°C or less, or preferably 320°C or less, or more preferably 300° or less. The likelihood of melting and deterioration of the seal material 5 during use of the thin-film solar cell 14 can be reduced by giving it a high melting point.

The thickness of the seal material 5 is not particularly specified, but is normally at least 100 μm, or preferably at least 150 μm, or more preferably at least 200 μm, and is normally 700 μm or less, or preferably 600 μm or less, or more preferably 500 μm or less. Making the seal thicker tends to increase the strength of the thin-film solar cell 14 as a whole, while making it thinner tends to improve flexibility and increase transmittance of visible light.

A film of an ethylene-vinyl acetate copolymer (EVA) resin composition (EVA film) or the like may be used as the material constituting the seal material 5. Crosslinking agents are normally compounded in EVA films to form crosslinking structures in order to improve weather resistance. An organic peroxide that generates radicals at 100°C or more is normally used as the crosslinking agent. Examples of such organic peroxides include 2,5-dimethylhexyl-2,5-dihydroperoxide, 2,5-dimethyl-2,5-di(5-butylperoxy)hexane, t-butyl peroxide and the like. The compounded amount of these organic peroxides is normally 5 parts by weight or less, or preferably 3 parts by weight or less, and is normally at least 1 part by weight per 100 parts by weight of EVA resin. One kind of crosslinking agent may be used, or any two or more kinds may be combined and used together in any proportions.

A silane coupling agent may also be included in this EVA resin composition to improve adhesive strength. Silane coupling agents that can be used for this purpose include gamma-chloropropyl trimethoxysilane, vinyl trichlorosilane, vinyl triethoxysilane, vinyl-tris-(beta-methoxyethoxy)silane, gamma-methacryloxypropyl trimethoxysilane, beta-(3,4-ethoxycyclohexyl)ethyl trimethoxysilane and the like. The compounded amount of these silane coupling agents is normally 5 parts by weight or less, or preferably 2 parts by weight or less, and is normally at least 0.1 parts by weight per 100 parts by weight of EVA resin. One kind of silane coupling agent may be used, or any two or more kinds may be combined and used together in any proportions.

A crosslinking aid may also be included in the EVA resin composition to improve durability by increasing the gel ratio of the EVA resin. Crosslinking aids that can be used for this purpose include trallylisocyanurate and other trifunctional crosslinking aids and triallylisocyanate and other monofunctional crosslinking aids and the like. The compounded amount of these crosslinking aids is normally 10 parts by weight or less, or preferably 5 parts by weight or less, and is normally at least 1 part by weight per 100 parts by weight of the EVA resin. One kind of crosslinking aid may be used, or any two or more kinds may be combined and used together in any proportions.

Hydroquinone, hydroquinone monomethyl ether, p-benzoquinone, methyl hydroquinone or the like may also be included in the EVA resin composition to improve the stability of the EVA resin. The compounded amount of these is normally 5 parts by weight or less per 100 parts by weight of the EVA resin.
However, crosslinking treatment of EVA resin requires a relatively long time (about 1 to 2 hours), which may contribute to reducing the production speed and production efficiency of the thin-film solar cell 14 in some cases. During long-term use, moreover, decomposition gas (acetic acid gas) from the EVA resin composition or vinyl acetate groups of the EVA resin itself may adversely affect the solar cell element 6, reducing the power-generating efficiency.
For this reasons, a copolymer film of a propylene/ethylene/alpha-olefin copolymer may be used for the seal material 5 instead of an EVA film. A thermoplastic resin composition obtained by compounding the following component 1 and component 2 may be used for this copolymer.
•Component 1: A propylene polymer in the amount of normally at least 0 parts by weight, or preferably 10 parts by weight, and normally no more than 70 parts by weight, or preferably no more than 50 parts by weight.
•Component 2: A soft propylene copolymer in the amount of at least 30 parts by weight, or preferably at least 50 parts by weight, and normally no more than 100 parts by weight, or preferably no more than 90 parts by weight.
The total of the component 1 and the component 2 is 100 parts by weight. If the component 1 and the component 2 are within the desired range as discussed above, the molding properties of the seal material 5 on the sheet are good, and the resulting seal material 5 has good heat resistance, transparency and flexibility, and is suitable for the thin-film solar cell 14.
A thermoplastic resin composition obtained by compounding the component 1 and the component 2 above has a melt flow rate (ASTMD 1238, 230°C, load 2.16 kg) of normally at least 0.0001 g/10 min and normally no more than 1,000 g/10 min, or preferably no more than 900 g/10 min, or more preferably no more than 800 g/10 min.
The melting point of a thermoplastic resin composition obtained by compounding the component 1 and the component 2 is normally at least 100°C, or preferably at least 110°C, and is normally 140°C or less, or preferably 135°C or less.
The density of a thermoplastic resin composition obtained by compounding the component 1 and the component 2 is normally 0.98 g/cm$^3$ or less, or preferably 0.95 g/cm$^3$ or less, or more preferably 0.94 g/cm$^3$ or less.
A coupling agent may be compounded with the component 1 and component 2 above as a promoter of adhesion with the plastic or the like in the seal material 5. A silane, titanate or chromium coupling agent can be used favorably as the coupling agent. A silane coupling agent is especially desirable.
Known compounds can be used as this silane coupling agent, without any particular limitations, and examples include vinyl triethoxysilane, vinyl trimethoxysilane, vinyltris(beta-methoxy-ethoxysilane), gamma-glycidoxypropyltrimethoxysilane, gamma-aminopropyl triethoxysilane and the like. One kind of coupling agent may be used, or any two or more kinds may be combined and used together in any proportions.
This silane coupling is preferably included in the amount of normally at least 0.1 parts by weight, and normally 5 parts by weight or less or more preferably 3 parts by weight or less per 100 parts by weight of the thermoplastic resin composition (total of component 1 and component 2).
The coupling agent may also be graft reacted with the thermoplastic resin composition using an organic peroxide. In this case, the coupling agent is preferably included in the amount of 0.1 to 5 parts by weight per 100 parts by weight of the thermoplastic resin composition (total of component 1 and component 2). Adhesiveness equal to or greater than that obtained with a silane coupling agent blend can be obtained on glass or plastic by using such a silane-grafted thermoplastic resin composition.
When an organic peroxide is used, the amount of the organic peroxide is normally at least 0.001 parts by weight or preferably at least 0.01 parts by weight, and is normally no more than 5 parts by weight or preferably no more than 3 parts by weight per 100 parts by weight of the thermoplastic resin composition (total of component 1 and component 2).
A copolymer consisting of an ethylene/alpha-olefin copolymer can also be used for the seal material 5. An example of this copolymer is a laminate film with a hot tack temperature of 5°C to 25°C, comprising a seal material resin composition consisting of the component A and component B below, laminated with a substrate.
- Component A: Ethylene resin
- Component B: A copolymer of ethylene and an alpha-olefin, having the following properties (a) to (d):

  (a) a density of 0.86 g/cm$^3$ to 0.935 g/cm$^3$;
  (b) a melt flow rate (MFR) of 1 g/10 min to 50 g/10 min;
  (c) a single peak in an elution curve obtained by TREF (temperature rising elution fractionation), with a peak temperature of 100°C or less; and
  (d) integral elution of at least 90% at 90°C according to TREF (temperature rising elution fractionation).

The compounding ratio of the component A and component B (component A/component B) by weight is normally at

least 50/50, or preferably at least 55/45, or more preferably at least 60/40, and is normally 99/1 or less, or preferably 90/10 or less, or more preferably 85/15 or less. Increasing the compounded proportion of the component B tends to improve the transparency and heat seal properties, while decreasing it tends to improve the workability of the film.

The melt flow rate (MFR) of the seal material resin composition obtained by compounding the component A and the component B is normally at least 2 g/10 min, or preferably at least 3 g/10 min, and is normally 50 g/10 min or less, or preferably 40 g/10 min or less. The MFR may be measured and evaluated by methods conforming to JIS K7210 (190°C, 2.16 kg load).

The melting point of the seal material resin composition is preferably at least 50°C, or more preferably at least 55°C, and is normally 300°C or less, or preferably 250°C or less, or more preferably 200°C or less. The likelihood of melting and deterioration during use of the thin-film solar cell element 14 can be reduced by increasing the melting point.

The density of the seal material resin composition is preferably at least 0.80 g/cm$^3$, or more preferably at least 0.85 g/cm$^3$, and is normally 0.98 g/cm$^3$ or less, or preferably 0.95 g/cm$^3$ or less, or more preferably 0.94 g/cm$^3$ or less. The density may be measured and evaluated by methods conforming to JIS K7712.

As with the aforementioned propylene/ethylene/alpha-olefin copolymer, a coupling agent can be used in a seal material 5 using an ethylene/alpha-olefin copolymer.

Because no decomposition gas is produced from the material with the seal material 5 discussed above, it has no adverse effects on the solar cell element 6, and provides good heat resistance, mechanical strength, flexibility (solar cell seal properties) and transparency. Because the material does not require a crosslinking step, moreover, the time taken for sheet molding and for preparing the thin-film solar cell 14 is much less, and it is easier to recycle the thin-film solar cell 14 after use.

The seal material 5 may be formed of one kind of material, or of two or more kinds of materials. Also, the seal material 5 may be formed as a monolayer film, or as a laminate film having two or more film layers.

The thickness of the seal material 5 is normally at least 2 μm, or preferably at least 5 μm, or more preferably at least 10 μm, and is normally 500 μm or less, or preferably 300 μm or less, or more preferably 100 μm or less. Increasing the thickness tends to increase the mechanical strength, while decreasing it tends to improve flexibility and increase the light transmittance.

The location of the seal material 5 is not particularly limited, but it is normally provided on both sides of the solar cell element 6. This is to ensure protection of the solar cell element 6. In this embodiment, a seal material 5 and a seal material 7 are provided on the front side and reverse side, respectively, of the solar cell element 6.

<3-7. Solar cell element 6>

The solar cell element 6 is similar to the photoelectric conversion element discussed above.

•Connecting solar cell elements

One solar cell element 6 may be provided per one thin-film solar cell 14, but normally two or more solar cell elements 6 are provided. The specific number of solar cell elements 6 may be set at will. When a plurality of solar cell elements 6 are provided, the solar cell elements 6 are normally aligned in an array.

When a plurality of solar cell elements 6 are provided, the solar cell elements 6 are normally electrically connected to each other, so that the electricity from a group of connected solar cell elements 6 can be extracted from a terminal (not shown), and in this case the solar cell elements are normally serially connected so as to increase the voltage.

When solar cell elements 6 are connected to each other in this way, the distance between solar cell elements 6 is preferably small, or in other words the gap between solar cell element 6 and solar cell element 6 is preferably narrow. This is in order to increase the amount of received light by increasing the light-receiving area of the solar cell elements 6, thereby increasing the amount of power generated by the thin-film solar cell 14.

<3-8. Seal material 7>

The seal material 7 is a film similar to the seal material 5 described above, and one similar to the seal material 5 may be used in the same way apart from the installed location.

One that does not transmit visible light may also be used because the component parts on the reverse side of the solar cell element 6 do not necessarily have to transmit visible light.

<3-9. Getter film 8>

The getter film 8 is a film similar to the getter film 4 described above, and one similar to the getter film 4 may be used in the same way as necessary apart from the installed location.

One that does not transmit visible light may also be used because the component parts on the reverse side of the solar cell element 6 do not necessarily have to transmit visible light. It is also possible to use a film that contains more of the water or oxygen absorber than the getter film 4. Examples of such absorbers include CaO, BaO, Zr-Al-BaO or the like as water absorbers, and active carbon, molecular sieves or the like as oxygen absorbers.

<3-10. Gas barrier film 9>

The gas barrier film 9 is a film similar to the gas barrier film 3 described above, and one similar to the gas barrier film 9 can be used in the same way as necessary apart from the installed location.
One that does not transmit visible light may also be used because the component parts on the reverse side of the solar cell element 6 do not necessarily have to transmit visible light.

<3-11. Back sheet 10>

The back sheet 10 is a film similar to the weather-resistant protective film 1 above, and one similar to the weather-resistant protective film 1 may be used in the same way apart from the installed location. If this back sheet 10 is resistant to water and oxygen permeation, the back sheet 10 can also be made to function as a gas barrier layer.
One that does not transmit visible light may also be used because the component parts on the reverse side of the solar cell element 6 do not necessarily have to transmit visible light. The sheets explained below as (i) to (iv) are particularly desirable as the back sheet 10.

(i) Various kinds of resin films or sheets with excellent strength, weather resistance, heat resistance, water resistance and/or light resistance can be used as the back sheet 10. For example, it is desirable to use a sheet of polyethylene resin, polypropylene resin, cyclic polyolefin resin, polystyrene resin, acrylonitrile-styrene copolymer (AS resin), acrylonitrile-butadiene-styrene copolymer (ABS resin), polyvinyl chloride resin, fluorine resin, poly(meth)acrylic resin, polycarbonate resin, polyethylene terephthalate, polyethylene naphthalate or other polyester resin, various nylon and other polyamide resins, polyimide resins, polyamidimide resins, polyaryl phthalate resins, silicone resins, polysulfone resins, polyphenylene sulfide resin, polyether sulfone resin, polyurethane resin, acetal resin or cellulose resin, or various other resin sheets. Of these resin sheets, it is desirable to use a sheet of fluorine resin, cyclic polyolefin resin, polycarbonate resin, poly(meth)acrylic resin, polyamide resin or polyester resin. One of these may be used, or any two or more may be combined and used together in any proportions.

(ii) A metal thin film may be used as the back sheet 10. This may be a corrosion-proof aluminum metal foil or a stainless steel thin film or the like for example. One kind of metal may be used, or any two or more kinds may be combined and used together in any proportions.
(iii) A highly waterproof sheet comprising a fluorine resin film affixed to both surfaces of an aluminum foil for example may be used as the back sheet 10. The fluorine resin may be ethylene monofluoride (product name: Tedlar, DuPont), polytetrafluoroethylene (PTFE), a copolymer of tetrafluoroethylene with ethylene or propylene (ETFE), vinylidene fluoride resin (PVDF), vinyl fluoride resin (PVF) or the like. One kind of fluorine resin may be used, or any two or more kinds may be used together in any proportions.

(iv) The back sheet 10 may also be a base film having a vapor-deposited film of an inorganic oxide on one or both sides, and further having a heat-resistant polypropylene resin film laminated on both sides of the base film over the vapor-deposited film of the inorganic oxide. Normally, when laminating a polypropylene resin film on a base film, lamination is accomplished by pasting with a laminating adhesive. Providing a vapor-deposited film of an inorganic oxide allows this to be used as a back sheet 10 having excellent moisture-proof properties for preventing the intrusion of moisture and/or oxygen or the like.

•Base film

Basically, various resin films having excellent adhesiveness with the vapor-deposited film of inorganic oxide or the like and having excellent strength, weather resistance, heat resistance, water resistance and light resistance can be used as the base film. Examples include films of polyethylene resin, polypropylene resin, cyclic polyolefin resin, polystyrene resin, acrylonitrile-styrene copolymer (AS resin), acrylonitrile-butadiene-styrene copolymer (ABS resin), polyvinyl chloride resin, fluorine resin, poly(meth)acrylic resin, polycarbonate resin, polyethylene terephthalate, polyethylene naphthalate and other polyester resins, various nylons and other polyamide resins, polyimide resin, polyamidimide

resin, polyaryl phthalate resin, silicone resin, polysulfone resin, polyphenylene sulfide resin, polyether sulfone resin, polyurethane resin, acetal resin, cellulose resin and various other resins and the like. Of these, a fluorine resin, cyclic polyolefin resin, polycarbonate resin, poly(meth)acrylic resin, polyamide resin or polyester resin film is preferred.

Of these various kinds of resin film, it is desirable to use a film of a fluorine resin such as polytetrafluoroethylene (PTFE), vinylidene fluoride resin (PVDF) or vinyl fluoride resin (PVF) for example. Of these fluorine resin films, a film of polyvinyl fluoride resin (PVF) or a fluorine resin consisting of a copolymer of tetrafluoroethylene and ethylene or propylene (ETFE) is especially desirable from the standpoint of strength and the like. One of these resins may be used, or any two or more can be combined in any proportions.

Of the various resin films described above, it is especially desirable to use a film of a cyclic polyolefin resin such as cyclopentadiene or its derivative or cyclohexadiene or its derivative or the like.

The thickness of the base film is normally at least 12 μm, or preferably at least 20 μm, and is normally 300 μm or less, or preferably 200 μm or less.

•Vapor-deposited film of inorganic oxide

Basically any vapor-deposited film of a metal oxide can be used as the vapor-deposited film of an inorganic oxide. For example, a vapor-deposited film of a silicon (Si) or aluminum (Al) oxide may be used. In this case, $SiO_x$ (in which x is 1.0 to 2.0) can be used as the silicon oxide, and $AlO_x$ (in which x is 0.5 to 1.5) can be used as the aluminum oxide.

One kind of metal and inorganic oxide may be used, or any two or more may be combined in any proportions.

The film thickness of the vapor-deposited film of an inorganic oxide is normally at least 50 Å, or preferably at least 100 Å, and is normally 4,000 Å or less, or preferably 1,000 Å or less.

A chemical vapor deposition (CVD) method such as plasmaenhanced chemical vapor deposition, thermal chemical vapor deposition, photochemical vapor deposition or the like may be used as the method of preparing the vapor-deposited film. Specifically, a vapor-deposited film of an inorganic oxide such as silicon oxide can be formed on one side of a base film by a low-temperature chemical vapor deposition method with a low-temperature plasma-generating device or the like using an organic silicon compound or the like as the raw material of the monomer gas for deposition, an inactive gas such as argon gas or helium gas as the carrier gas, and oxygen gas or the like as the oxygen supply gas.

•Polypropylene resin film

A homopolymer of propylene or a copolymer of propylene with another monomer (such as an alpha-olefin) may be used as the polypropylene resin. An isotactic polymer may also be used as the polypropylene resin.

The melting point of the polypropylene resin is normally at least 164°C, and is normally 170°C or less. The specific gravity of the polypropylene resin is normally at least 0.90, and is normally 0.91 or less. The molecular weight of the polypropylene resin is normally at least 100,000, and is normally 200,000 or less.

The properties of the polypropylene resin are largely governed by its crystallinity, but a highly isotactic polymer has excellent tensile strength and impact strength, good heat resistance and flex fatigue resistance, and very good workability.

•Adhesive

A laminating adhesive is normally used when laminating the polypropylene resin film to the base film. The base film and polypropylene resin film are thus laminated via a laminating adhesive layer.

The adhesive constituting the laminating adhesive layer may be a polyvinyl acetate adhesive, polyacrylate ester adhesive, cyanoacrylate adhesive, ethylene copolymer adhesive, cellulose adhesive, polyester adhesive, polyamide adhesive, polyimide adhesive, amino resin adhesive, phenol resin adhesive, epoxy adhesive, polyurethane adhesive, reactive (meth)acrylic adhesive, silicone adhesive or the like. One kind of adhesive may be used, or any two or more kinds may be used together in any proportions.

The composition of this adhesive may be a water-based, solution-type, emulsion-type or dispersed composition or the like. It may be in the form of a film or sheet, powder, solid or the like. The adhesion mechanism may be by chemical reaction, solvent evaporation, heat melting, thermal pressure or the like.

This adhesive may be applied by roll coating, gravure roll coating, kiss coating, or another coating or printing method or the like. A coated amount (dried weight) of normally at least 0.1 $g/m^2$ and normally 10 $g/m^2$ or less is desirable.

<3-12. Dimensions, etc.>

The thin-film solar cell 14 of this embodiment is normally a thin film-shaped member. If the thin-film solar cell 14 is formed as such a film-shaped member, the thin-film solar cell 14 can be easily installed in an automobile or home

interior or the like. The thin-film solar cell 14 can provide a light, breakage-resistant and highly safe solar cell that can be used for many applications because it is also applicable to curved surfaces. It is also desirable from the perspective of distribution including storage and transport because it is thin and light. Moreover, costs can be greatly reduced because the film shape allows for roll-to-roll manufacture.

The specific dimensions of the thin-film solar cell 14 are not limited, but the thickness of the thin-film solar cell 14 is normally at least 300 μm, or preferably at least 500 μm, or more preferably at least 700 μm, and is normally 3,000 μm or less, or preferably 2,000 μm or less, or more preferably 1,500 μm or less.

<3-13. Manufacturing method>

The method of manufacturing the thin-film solar cell 14 of this embodiment is not limited, but for example it can be manufactured by connecting one or two or more solar cell elements 6 serially or in parallel between the weather-resistant protective film 1 and the back sheet 10, and then using an ordinary vacuum laminating unit to laminate these with the ultraviolet exclusion film 2, gas barrier films 3 and 9, getter films 4 and 8 and seal materials 5 and 7. The heating temperature in this case is normally at least 130°C, or preferably at least 140°C, and is normally 180°C or less, or preferably 170°C or less. The heating time is normally at least 10 minutes, or preferably at least 20 minutes, and is normally 100 minutes or less, or preferably 90 minutes or less. The pressure is normally at least 0.001 MPa, or preferably at least 0.01 MPa, and is normally 0.2 MPa or less, or preferably 0.1 MPa or less. Within this pressure range it is possible to obtain a secure seal, to prevent protrusion of seal materials 5 and 7 beyond the ends and loss of film thickness due to excess pressure, and to ensure dimensional stability.

[4. Applications]

The applications of the solar cell of the present invention and of the thin-film solar cell 14 described above in particular are not limited, and they can be used for any applications. The solar cell of the present invention and the thin-film solar cell in particular can be used as is, and they can also be used in a solar cell module comprising a solar cell disposed on a base material. For example, as schematically illustrated in Fig. 3, a solar cell module 13 can be prepared comprising the thin-film solar cell 14 on a base material 12, and installed in a desired location. To give a specific example, using a building construction board as the base material 12, a solar cell panel comprising the thin-film solar cell 14 on the surface of this board can be prepared as a solar cell module 13, and this solar cell panel can be installed and used on the outer wall of a building or the like.

The base material 12 is a supporting base that supports the solar cell element 6. The material forming the base material 12 may be an inorganic material such as glass, sapphire or titania; an organic material such as polyethylene terephthalate, polyethylene naphthalate, polyether sulfone, polyimide, nylon, polystyrene, polyvinyl alcohol, ethylene vinyl alcohol copolymer, fluorine resin film, vinyl chloride, polyethylene, cellulose, polyvinylidene chloride, aramide, polyphenylene sulfide, polyurethane, polycarbonate, polyarylate or polynorbornene; a paper material such as paper or synthetic paper; or a composite material comprising a metal such as stainless steel, titanium or aluminum that has been surface coated or laminated to convey insulating properties and the like. The material of the base may be of one kind, or any two or more kinds may be used together in any proportions. The mechanical strength of the organic materials or paper materials may also be enhanced by including carbon fibers.

Examples of fields to which the thin-film solar cell of the present invention is applicable include solar cells for building construction, solar cells for automobiles, solar cells for home interiors, solar cells for railroads, solar cells for ships, solar cells for airplanes, solar cells for spacecraft, solar cells for home appliances, solar cells for cellular phones, and solar cells for toys and the like. Specific examples include the following.

<4-1. Architectural applications>

4-1.1 Solar cells as home roofing materials

Using a roofing board or the like as the base material, the thin-film solar cell can be mounted on the surface of this board to prepare a solar cell panel as a solar cell unit, and this solar cell panel can be installed and used on the roof of a house. Roofing tiles can also be used directly as base materials. The property of flexibility of the solar cell of the present invention can also be exploited by affixing it to the curved surface of a roof tile.

4-1.2 Rooftops

It can also be attached to the roof of a building. The thin-film solar cell can also be mounted on a base material to prepare a solar cell unit that can then be installed on the roof of a building. In this case it is desirable to use a waterproof

sheet together with the base material to give a waterproofing effect. The flexible property of the thin-film solar cell of the present invention can also be exploited by affixing it to a non-flat roof, such as a corrugated roof for example. In this case also it is desirable to use a waterproof sheet.

4-1.3 Skylights

The thin-film solar cell of the present invention can also be used as an exterior covering of an entrance or stairwell. Entrances and the like are often designed with curves, and the flexible property of the thin-film solar cell of the present invention is useful in this case. When an entrance or the like is see-through for example, the green coloration of an organic solar cell can add beauty to the design in an age in which environmental considerations are paramount.

4-1.4 Walls

Using a construction board as the base material, the thin-film solar cell can be mounted on the surface of this board to prepare a solar cell panel as a solar cell unit, and this solar cell panel can be installed and used in an outer wall or the like of a building. It can also be installed in a curtain wall. In addition, it can also be attached to a spandrel, mullion or the like.

In this case, the shape of the base material is not limited, but normally a board is used. The material, dimensions and the like of the base material can also be set at will according to the usage environment, and examples of such base materials include Alpolic (trade name, MITSUBISHI PLASTICS, INC.) and the like.

4-1.5 Windows

It can also be used in see-through windows. The green coloration of an organic solar cell can add beauty to the design in an age in which environmental considerations are paramount.

4-1.6 Other

It can also be used in architectural exteriors in eaves, louvers, railings and the like. The flexibility of the thin-film solar cell of the present invention is also suited to these applications.

<4-2. Interiors>

The thin-film solar cell of the present invention can also be attached to slats of blinds. Such applications are possible because the thin-film solar cell of the present invention is light-weight and highly flexible. It is also applicable to interior windows because the organic solar cell element has the property of transparency.

<4-3. Vegetable factories>

More and more vegetable plants are being built using fluorescent lamps and other artificial lights, but it is difficult to control cultivation costs due to the electrical bills for lighting and the costs of replacing light sources and the like. Therefore, the thin-film solar cell of the present invention can be installed in a vegetable plant, and used to construct a lighting system in combination with LEDs or fluorescent lamps.

Using a lighting system that combines LEDs (which have a longer life than fluorescent lights) with the solar cell of the present invention, lighting costs can be reduced by about 30% in comparison with current costs.
The solar cell of the present invention can also be used in the roofs and walls of reefer containers, which are used to transport vegetables and the like at fixed temperatures.

<4-4. Road materials, civil engineering>

The thin-film solar cell of the present invention can be used in the outer walls of parking structures, in the sound insulating walls of expressways and in the outer walls of water treatment plants and the like.

<4-5. Automobiles>

The thin-film solar cell of the present invention can be used on automobile surfaces include the hood, roof, trunk lid, door, front fender, rear fender, pillars, bumpers, rear-view mirrors and the like. The roof here includes the roof of a truck bed. The resulting electrical power can be supplied to the drive motor, battery for driving the motor, electrical

components and electrical component batteries. The resulting electrical power can be used appropriately and efficiently if control means is provided for selecting the power according to the power-generating status of the solar cell panel and the power usage status of the drive motor, battery for driving the motor, electrical components and electrical component batteries.
In this case, the form of the base material 12 is not limited, but normally a board is used. The material, dimensions and the like of the base material 12 can be set at will according to the usage environment.
Examples of such base materials 12 include Alpolic (trade name, MITSUBISHI PLASTICS, INC.) and the like.

[EXAMPLES]

The present invention is explained in more detail below using examples, but the present invention is not limited to these examples as long as its intent is not exceeded. The measurements described in these examples are obtained by the following methods.
[Methods for measuring weight-average molecular weight and number-average molecular weight]
The weight-average molecular weight and number-average molecular weight (polystyrene conversion) are determined by gel permeation chromatography (GPC).
Gel permeation chromatography (GPC) measurement was performed under the following conditions.
Columns: Shim-pack GPC-803 (Shimadzu Corporation, inner diameter 8.0 mm, length 30 cm), Shim-pack GPC-804 (Shimadzu Corporation, inner diameter 8.0 mm, length 30 cm) (one of each, connected serially)
Pump: LC-10AT (Shimadzu Corporation)
Oven: CTO-10A (Shimadzu Corporation)
Detector: Differential refractive index detector (Shimadzu Corporation RID-10A) and UV-vis detector (Shimadzu Corporation SPD-10A)
Samples: Specimen dissolved in tetrahydrofuran (THF) (5 $\mu$L liquid)
Mobile phase: THF
Flow rate: 1.0 mL/min
Analysis: LC-Solution (Shimadzu Corporation)

[Elemental analysis]

The sample was wet decomposed, and the palladium (Pd) and tin (Sn) in the decomposition solution were analyzed with an ICP mass spectrometer to determine the content of each in the sample.
The sample was also burned in a sample burner (MITSUBISHI CHEMICAL ANALYTECH CO., LTD. QF-02), the combustion gas was absorbed with an alkaline absorbent containing a reducing agent, and the boron ions ($Br^-$) and iodine ions ($I^-$) in the absorbed liquid was analyzed with an ICP mass spectrometer to determine the contents of each in the sample.
Equipment: ICP mass spectrometer (Agilent Technologies, Inc. 7500ce)
Analysis: Calibration curve method

[Absorption spectrum]

A spectrophotometer (Hitachi, Ltd. U-3500) was used to measure the absorption spectrum. A chloroform solution of each copolymer (adjusted to obtain a maximum absorbancy value of 0.8 or less) was measured using a 1 cm-square quartz cell. The spectra of a copolymer A1, a copolymer A2, a copolymer A3 and a copolymer B were normalized given 0.25 as absorbancy at an absorption wavelength of 610 nm. The spectra of the copolymer A2 and a copolymer C were normalized given 0.38 as the maximum absorbancy value of the resulting spectrum.

[Measurement of X-ray diffraction (XRD) spectrum]

The X-ray diffraction (XRD) spectrum was measured with an X-ray diffractometer (Rigaku Corporation RINT_ 2000), using Cu for the anticathode.

[Measurement of lowest unoccupied molecular orbital (LUMO) of electron extraction layer material]

Based on a value for first reduction potential obtained from cyclic voltammogram measurement, the LUMO energy level was calculated as a relative value given -3.80 eV as the LUMO energy level of $C_{60}$ PCBM (Frontier Carbon Ltd. Company, 1-(3-methoxycarbonyl)propyl-1-phenyl(6,6)-$C_{60}$) (see Non-Patent Document: J. Am. Chem. Soc. 2008, 130, 15429-15436).

Temperature: Room temperature
Working electrode: Glassy carbon electrode
Counter-electrode: Platinum electrode
Reference electrode: $Ag/Ag^+$
Electrolyte: Mixed solution of o-dichlorobenzene and acetonitrile (4:1 by volume) containing tetrabutyl ammonium perchlorate (TBAP) (0.1 M)
Fullerene compound concentration: about 0.5 mM
Reference potential: Oxidation-reduction potential of ferrocene

[Measurement of glass transition temperature (Tg) by DSC]

About 4 mg of sample was placed in an aluminum sample container, and measurement was performed under conditions of $N_2$ gas 50 ml/min, temperature rising speed 10°C/min using a differential scanning calorimeter (SII NanoTechnology Inc.).

[Evaluation of photoelectric conversion element)

A 4 mm-square metal mask was attached to the photoelectric conversion element, and the current-voltage characteristics between the ITO electrode and aluminum electrode were measured with a source meter (Keithley Instruments, Inc. 2400) using a solar simulator as the light source with an Air Mass (AM) of 1.5 G and an irradiance 100 $mW/cm^2$. The open voltage Voc [V], short-circuit density Jsc [$mA/cm^2$], form factor FF and photoelectric conversion efficiency PCE [%] were measured by these means.

The open voltage Voc here is the voltage value (V) when the current value is 0 ($mA/cm^2$), while the short-circuit current density Jsc is the current density ($mA/cm^2$) when the voltage value is 0 (V). The form factor (FF) is a factor representing internal resistance, and is represented by the following formula with Pmax being the maximum output point.

$$FF = Pmax/(Voc \times Jsc)$$

The photoelectric conversion efficiency PCE is given by the following formula with Pin being the incident energy.

$$PCE = Pmax/Pin = Voc \times Jsc \times FF/Pin \times 100$$

[Field effect transistor (FET) characteristics of polymer]

Gold electrodes with gaps of length (L) 100 μm, width (W) 500 μm were formed by photolithography as source and drain electrodes on an n-type silicon (Si) substrate (Sb-doped, resistance ≤ 0.02 Ω·cm, Sumitomo Metal Industries, Ltd.) having a 300 nm-thick oxide film formed thereon. Part of the oxide film was removed to form a gate electrode. A chloroform solution (10 mmol/L) of each polymer was prepared, and 0.1 mL was dripped onto the substrate described above and spin-coated for 30 seconds at 1,000 rpm (MIKASA CO., LTD MS-A100 spin coater) to prepare a good semiconductor film with a thickness of about 50 nm.

The resulting FET element was evaluated using an Agilent Technologies, Inc. 4155C semiconductor parameter analyzer. Voltage Vd (range from -60 V to 0 V) was applied between the source and drain electrodes, voltage Vg (range from -60 V to 30 V) was applied between the source and gate electrodes, and the current Id flowing through the semiconductor film (polymer film) was measured.

The operation can be represented as follows given Vt as the threshold voltage, Ci as the capacitance per unit area of the insulating film, L as the distance between the source electrode and drain electrode, W as the width, and μ as the hole mobility of the semiconductor film.

$$\text{If } Vd < Vg - Vt,$$

$$Id = \mu Ci(W/L)[(Vg - Vt)Vd - (Vd^2/2)].$$

If Vd > Vg - Vt,

$$Id = (1/2)\mu Ci(W/L)(Vg - Vt)^2.$$

The hole mobility μ can be determined from either of the two formulae depending on the current-voltage characteristics, but in these examples, it was determined from the slope when $Id^{1/2}$ and Vd were plotted in accordance with the formula (saturated current part) for Vd > Vg - Vt.

<Example 1>

[Synthesis of copolymers}

<Synthesis example 1>

[Synthesis of imidothiophene monomer 1]

[Chemical Formula 21]

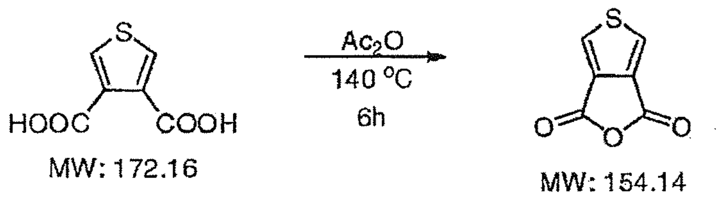


5.3 g (30.7 mmol) of thiophene dicarboxylic acid and 100 mL of anhydrous acetic acid were added to a 500 mL recovery flask, and heated for 6 hours at 140°C. The solvent was removed by vacuum distillation, and the mixture was recrystallized with toluene to give 3.5 g of 1H,3H-thieno[3,4-c]furan-1,3-dione.

[Chemical Formula 22]

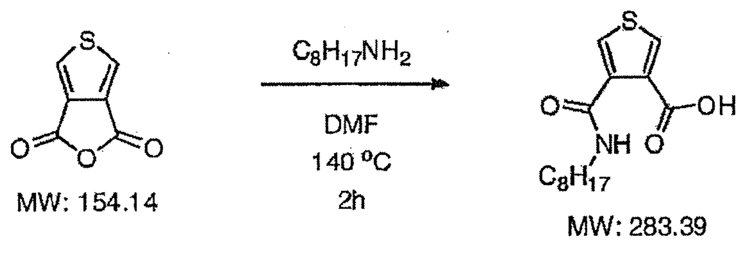


3.57 g (0.023 mol) of 1H,3H-thieno[3,4-c]furan-1,3-dione was dissolved in 35 mL of dehydrated DMF in a 100 mL recovery flask in nitrogen. 4.2 mL (0.025 mol) of n-octylamine was then added in an ice bath, and the mixture was heated for 2 hours at 140°C. This was cooled and mixed with water, and the precipitated flesh-colored powder was filtered out and washed with cold methanol to give 5.3 g of 4-[[1-octylamino]carbonyl]-3-thienophenecarboxylic acid.
[Chemical Formula 23]

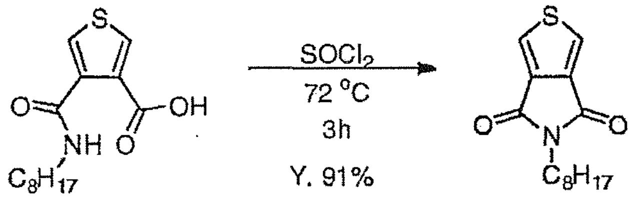


5.27 g (18.6 mmol) of 4-[[1-octylamino]carbonyl]-3-thiophenecarboxylic acid and 18 mL of thionyl chloride were added to a 100 mL recovery flask, and heated for 3 hours with the bath temperature set to 72°C. This was cooled, and dripped in 1 N sodium hydroxide aqueous solution, and the precipitated brown powder was filtered out. This was washed with cold methanol, and dried to give 4.55 g of 5-octyl-4H-thieno[3,4-c]pyrrole-4,6(5H)-dione (yield 91%).

[Chemical Formula 24]

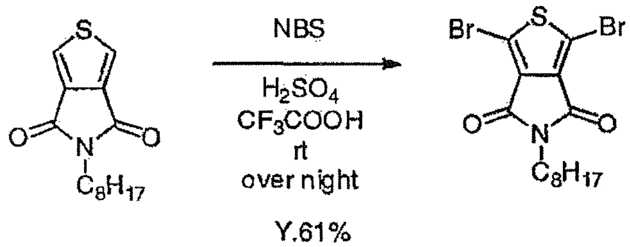


(Imidothiophene monomer 1)

(Imidothiophene monomer 1)

2.65 g (10 mmol) of 5-octyl-4H-thieno[3,4-c]pyrrole-4,6(5H)-dione was dissolved in 50 mL of trifluoroacetic acid and 15 mL of concentrated sulfuric acid in a 200 mL recover flask in nitrogen. 5.33 g (30 mmol) of NBS was agitated until it dissolved in an ice bath, the ice bath was removed, the temperature was raised to room temperature, and agitation was continued for 20 hours. This was quenched by mixing with ice water and extracted with chloroform, the solvent was removed by vacuum distillation, and the mixture was purified by column chromatography (developing solvent, hexane: chloroform 2:1 → 1:1). This was suspension washed with hexane to give 2.58 g of imidothiophene monomer 1 (1,3-dibromo-5-octyl-4H-thieno[3,4-c]pyrrole-4,6-(5H)-dione) (yield 61%).

<Synthesis Example 2>

[Synthesis of dithienosilole monomer 1]

[Chemical Formula 25]

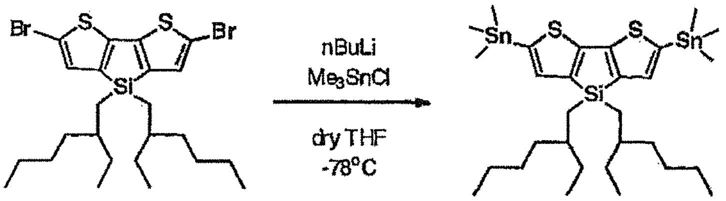


(Dithienosilole monomer 1)

(Dithienosilole monomer 1)

0.1 g of 4,4'-dioctyl-5,5-dibromo-dithieno[3,2-b:2',3'-d]silole was added to a 50 mL multi-necked flask, and thorough nitrogen substitution was performed with a vacuum pump and a drier. 5 mL of dehydrated THF was added, the system was cooled in a dry ice-acetone bath, and 0.28 mL of nBuLi in hexane solution was added and agitated for 15 minutes. 105 mg of trimethyl tin chloride was added, the temperature was raised to room temperature, and the mixture was agitated for 2 hours. This was quenched by addition of water, extracted with hexane and dried with sodium sulfate, and the solvent was removed by vacuum distillation to give 125 mg of a dithienosilole monomer 1 (4,4'-dioctyl-5,5-bis (trimethyltin)-dithieno[3,2-b:2'3'-d]silole, green oil).

<Synthesis Example 3>

[Synthesis of copolymer A]

[Chemical Formula 26]

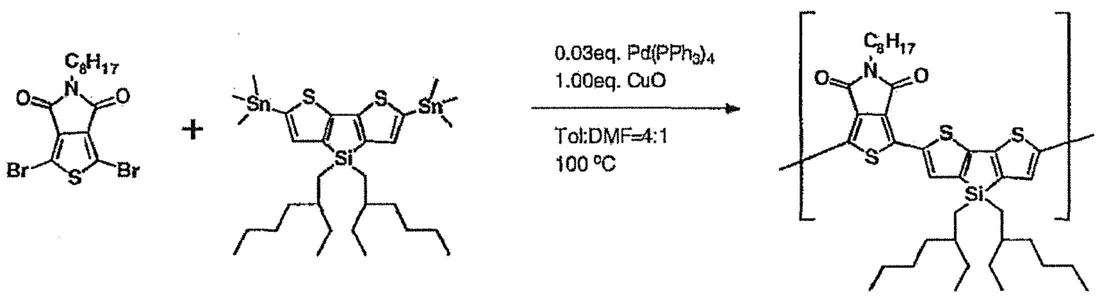


(Copolymer A)

(Copolymer A)

187 mg of the imidothiophene monomer obtained in Synthesis Example 1 (1,3-dibromo-5-octyl-4H-thieno[3,4-c]pyrrole-4,6-(5H)-dione, 0.443 mmol), 340 mg of the dithienosilole monomer obtained in Synthesis Example 2 (4,4'-dioctyl-5,5-bis(trimethyltin)-dithieno[3,2-b:2'3'-d]silole, 0.443 mmol), 15 mg (0.013 mmol) of tetrakis(triphenylphosphine) palladium (0-valent), 35 mg (0.443 mmol) of copper (II) oxide, 6.75 mL of toluene and 1.62 mL of DMF were added to a 50 mL recovery flask in nitrogen, and agitated for 20 hours at 100°C. As a terminal treatment, 0.1 mL of bromobenzene was then added and agitated for 3 hours, 0.1 mL of trimethyl(phenyl)tin was added and agitated for 3 hours, and the reaction solution was diluted 5 times with toluene and dripped into 400 mL of methanol. The precipitated copolymer was filtered out, and purified with silica gel to obtain the target copolymer A. Specifically, a chloroform solution (10 mL) of the filtered copolymer (50 mg to 100 mg) was loaded into a JAL 908-C60 unit (Japan Analytical Industry Co., Ltd.) with attached JAIGEL-3H (40ϕ) and 2H (40ϕ) columns, and separated and purified at a flow rate of 14 mL/min using a chloroform developing solution.
The weight-average molecular weight, number-average molecular weight and PDI of the separated copolymer A (hereunder called copolymer A1) were $5.5 \times 10^4$, $4.1 \times 10^4$ and 1.34, respectively. Elemental analysis of the copolymer A1 showed that the residual amounts of constituent atoms of the terminal residues of the copolymer A1 were Br: 90 ppm, Pd: 25 ppm and Sn: 67 ppm.

A copolymer A having a weight-average molecular weight, a number-average molecular weight and a PDI of $4.4 \times 10^4$, $2.8 \times 10^4$ and 1.50, respectively (hereunder called copolymer A2) and a copolymer A having a weight-average molecular weight, a number-average molecular weight and a PDI of $1.9 \times 10^4$, $1.8 \times 10^4$ and 1.08, respectively (hereunder called copolymer A3) were also obtained by reactions using the same methods. Elemental analysis of the copolymer A2 showed that the residual amounts of constituent atoms of the terminal residues of the copolymer A2 were Br: 170 ppm, Pd: 3.2 ppm and Sn: 600 ppm.

A copolymer A having a weight-average molecular weight, a number-average molecular weight and a PDI of $8.1 \times 10^4$, $3.4 \times 10^4$ and 2.37, respectively (hereunder called copolymer A4) was also obtained by a reaction using the

same methods. Elemental analysis of the copolymer A4 showed that the residual amounts of constituent atoms of the terminal residues of the copolymer A4 were Br: 210 ppm, Pd: 64 ppm and Sn: 170 ppm. The hole mobility of the copolymer A4 as measured by the methods described above is shown in Table 3.

A copolymer A having a weight-average molecular weight, a number-average molecular weight and a PDI of $3.1 \times 10^5$, $6.0 \times 10^4$ and 5.22, respectively (hereunder called copolymer A5) was also obtained by a reaction using the same methods. Elemental analysis of the copolymer A5 showed that the residual amounts of constituent atoms of the terminal residues of the copolymer A5 were Br: 73 ppm, Pd: 40 ppm and Sn: 150 ppm. The hole mobility of the copolymer A5 as measured by the methods described above is shown in Table 3.

A copolymer A having a weight-average molecular weight, a number-average molecular weight and a PDI of $2.4 \times 10^5$, $3.1 \times 10^4$ and 7.60, respectively (hereunder called copolymer A6) was also obtained by a reaction using the same methods. Elemental analysis of the copolymer A6 showed that the residual amounts of constituent atoms of the terminal residues of the copolymer A6 were Br: 200 ppm, Pd: 68 ppm and Sn: 1,300 ppm. The hole mobility of the copolymer A6 as measured by the methods described above is shown in Table 3.

A copolymer A having a weight-average molecular weight, a number-average molecular weight and a PDI of $2.6 \times 10^4$, $2.2 \times 10^4$ and 1.18, respectively (hereunder called copolymer A7) was also obtained by a reaction using the same methods. Elemental analysis of the copolymer A7 showed that the residual amounts of constituent atoms of the terminal residues of the copolymer A7 were Br: 160 ppm, Pd: 23 ppm and Sn: 210 ppm. The hole mobility of the copolymer A7 as measured by the methods described above is shown in Table 3.

<Synthesis Example 4>

[Synthesis of dithienosilole monomer 2]

[Chemical Formula 27]

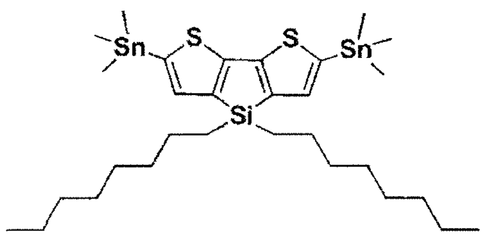

(Dithienosilole monomer 2)

(Dithienosilole monomer 2)

A dithienosilole monomer 2 (4,4'-di-n-octyl-5,5-bis(trimethyltin)-diethineo[3,2-b:2'3'-d]silole) was synthesized as in Synthesis Example 2 except that 4,4'-di-n-octyl-5,5-dibromo-dithieno[3,2-b:2'3'-d]silole (Luminescence Technology Corp.) was used in place of 4,4'-dioctyl-5,5-dibromo-dithieno[3,2-b:2',3'-d]silole.

<Synthesis Example 5>

[Synthesis of imidothiophene monomer 2]

[Chemical Formula 28]

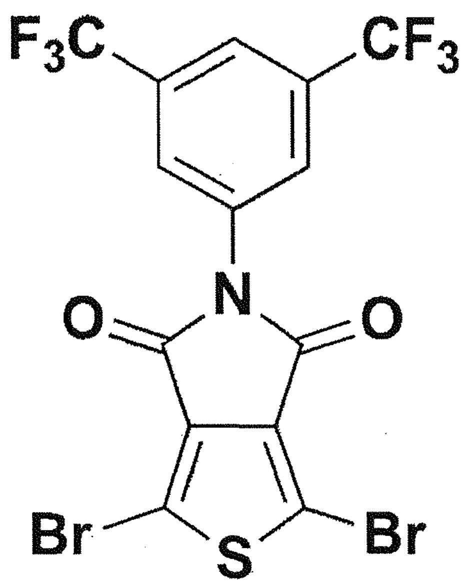

(Imidothiophene monomer 2)

(Imidothiophene monomer 2)

An imidothiophene monomer 2 (1,3-dibromo-5-(3,5-bis(trifluoromethyl)phenyl)-4H-thieno[3,4-c]pyrrole-4,6-(5H)-dione) was synthesized as in Synthesis Example 1 except that 3,5-bistrifluoromethylphenylamine was used instead of n-octylamine.

<Synthesis Example 6>

[Synthesis of copolymer B]

[Chemical Formula 29]

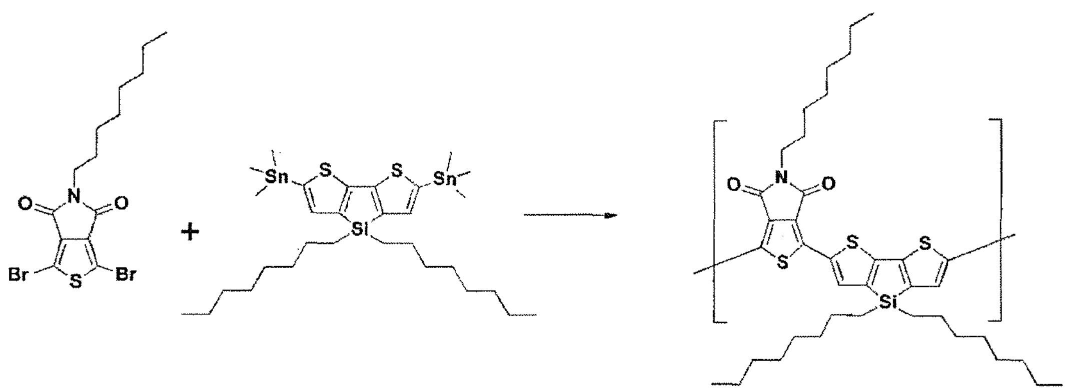

(Copolymer B)

(Copolymer B)

A copolymer B was synthesized as in Synthesis Example 3 except that the dithienosilole monomer 2 (4,4'-di-n-octyl-5,5-bis(trimethyltin)-dithieno[3,2-b:2',3'-d]silole) obtained in Synthesis Example 4 was used instead of the dithienosilole monomer 1 (4,4'-dioctyl-5,5-bis(trimethyltin)-dithieno[3,2-b:2'3'-d]silole) obtained in Synthesis Example 2. The weight-average molecular weight, number-average molecular weight and PDI of the synthesized polymer were $2.8 \times 10^4$, $3.5 \times 10^3$ and 7.87, respectively.

<Synthesis Example 7>

[Synthesis of copolymer C]

[Chemical Formula 30]

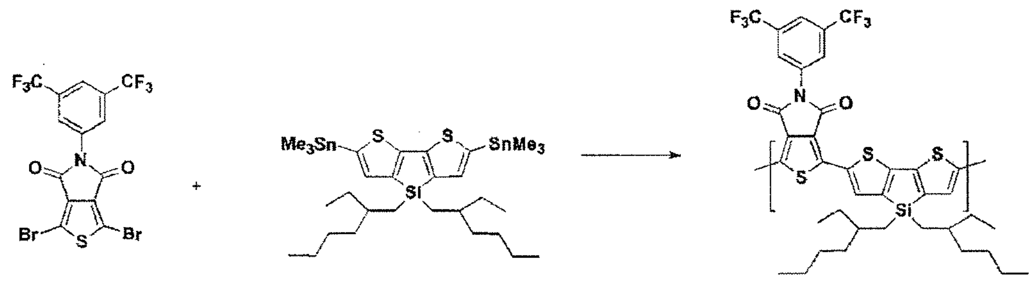

(Copolymer C)

(Copolymer C)

A copolymer C was synthesized as in Synthesis Example 6 except that the imidothiophene monomer 2 was used instead of the imidothiophene monomer 1. The weight-average molecular weight, number-average molecular weight and PDI of the copolymer C were $4.7 \times 10^4$, $3.3 \times 10^4$ and 1.42, respectively. Elemental analysis of the copolymer C showed that the residual amounts of constituent atoms of the terminal residues of the copolymer C were Br: 190 ppm, Pd: 750 ppm and Sn: 3,600 ppm.

<Absorption spectrum measurement>

Figs. 4 and 5 show the results of absorption spectrum measurement of chloroform solutions of the various copolymers (copolymer A1, copolymer A2, copolymer A3, copolymer B and copolymer C). The results of Fig. 4 show that the copolymers A1 to A3 of Example 1 had relatively high absorbancy in the absorption spectrum range of 650 nm to 700 nm. Because improved absorbancy in the absorption spectrum range of 650 nm to 700 nm means that light can be absorbed in a wider range of wavelengths, improved conversion efficiency can be expected with photoelectric conversion elements containing the copolymers A1 to A3 in the active layer.

Moreover, in the copolymer in which the substituents ($R^3$ and $R^4$) bound to Si in the dithienosilole structure are linear alkyl groups (copolymer B), the longest end of the absorption spectrum is extended to nearly 720 nm, and absorbancy in the wavelength range of 400 nm to 600 nm is improved in comparison with a copolymer (copolymer A2) in which these substituents are linear alkyl groups. The ability to absorb more light at longer wavelengths and the improved absorption characteristics in the range of 400 nm to 600 nm mean that the copolymer can absorb more light at a wider range of wavelengths. Improved conversion efficiency can be expected with a photoelectric conversion element containing such a copolymer in the active layer.

The results of Fig. 5 show that in a copolymer in which the substituent ($R^1$) bound to a nitrogen atom of the imidothiophene structure is an aryl group (copolymer C), the maximum absorption wavelength and longest end of the absorption spectrum are both extended to longer wavelengths in comparison with a copolymer (copolymer A2) in which this substituent ($R^1$) is a linear alkyl group. The ability to absorb more light at longer wavelengths means that this copolymer can absorb light at a wider range of wavelengths, and therefore improved conversion efficiency can be

expected with a photoelectric conversion element containing such a copolymer in the active layer.

<Reference Example 1>

[Photoelectric conversion element using copolymer A1]

[Preparation of organic active layer coating solution S0]

The copolymer A1 with a weight-average molecular weight of $5.5 \times 10^4$ obtained in Synthesis Example 3, which is a p-type semiconductor compound, and PC71BM (Frontier Carbon Ltd. Company, NS-E112), which is a n-type semiconductor compound, were mixed at a weight ratio of 1:1.5, and dissolved in chlorobenzene in a nitrogen atmosphere to a concentration of 1.0 wt% of the mixture. 1,8-diiodooctane was then added to this solution to a ratio of 3.2 wt% relative to the organic active layer coating solution as a whole, and agitated and mixed for 4 hours at 80°C with a hot stirrer. After agitation and mixing, the solution was filtered with a 0.45 $\mu$m polytetrafluoroethylene (PTFE) filter to give an organic active layer coating solution S0.

[Preparation of photoelectric conversion element]

A glass substrate with a patterned indium-tin oxide (ITO) transparent conductive film was sequentially ultrasound washed with a surfactant, washed with ultrapure water, and then ultrasound washed with ultrapure water, and then dried by nitrogen blowing.
Finally, the substrate was subjected to UV ozone washing. For the hole extraction layer, an aqueous dispersion of poly (3,4-ethylenedioxythiophene (poly)styrenesulfonic acid) (H.C. Starck GmbH., Clevios™ PVP AI4083) was spin coated at 4,000 rpm for 30 seconds on this substrate, and the coated substrate was heated in atmosphere for 10 minutes on a hot plate at 120°. The film thickness of the hole extraction layer was about 30 nm.
The substrate with the formed hole extraction layer was heat treated for 3 minutes at 220°C on a hot plate inside a glove box in a nitrogen atmosphere. After the substrate had cooled, the organic active layer coating solution S0 prepared as discussed above was spin coated at a rate of 230 rpm to form an organic active layer about 100 nm thick. Next, films of lithium fluoride with a film thickness of 0.6 nm as the electron extraction layer and aluminum with a film thickness of 80 nm as the electrode were formed sequentially by resistance heating vacuum deposition to prepare a 5 mm-square photoelectric conversion element.

[Evaluation of photoelectric conversion element]

The current-voltage characteristics of the prepared photoelectric conversion element were measured. The measurement results for the parameters of open voltage Voc (V), short-circuit density Jsc (mA/cm$^2$), form factor FF and photoelectric conversion efficiency PCE (%) are shown in Table 1.

<Example 2>

[Photoelectric conversion element using copolymer A2 and POPy$_2$]

A 5 mm-square photoelectric conversion element was prepared as in Reference Example 1 except that the copolymer A2 having a weight-average molecular weight of $4.4 \times 10^4$ described in Synthesis Example 3 was used in place of the copolymer A1 having a weight-average molecular weight of $5.5 \times 10^4$, POPy$_2$ obtained in accordance with the Synthesis Example 8 below was used instead of lithium fluoride for the electron extraction layer, and the film thickness of the electron extraction layer was changed from 0.6 nm to 2.5 nm. The measurement results for the current-voltage characteristics are shown in Table 1.
<Synthesis Example 8>

[POPy$_2$ synthesis example]

[Chemical Formula 31]

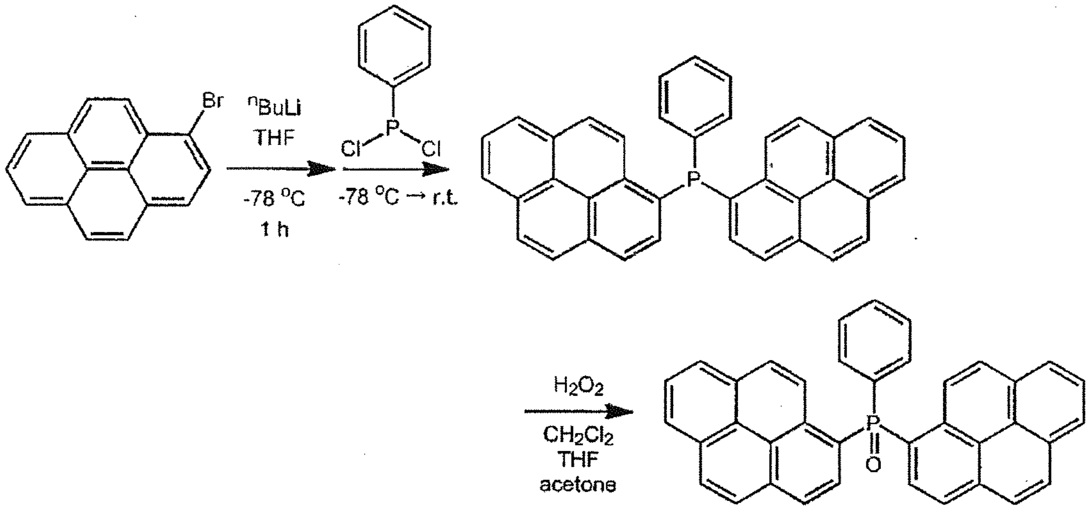


($POPy_2$)

1-bromopyrene (Tokyo Chemical Industry Co., Ltd., 14 g, 50 mmol) was dissolved in dehydrated THF (KANTO CHEMICAL CO., INC., 200 mL) in a nitrogen atmosphere, and cooled to - 78°C, after which n-BuLi (KANTO CHEMICAL CO., INC., 33 mL, 1.6 M) was gradually dripped in, and agitation was performed for 30 minutes with the temperature maintained at -78°C. Next, dichlorophenyl phosphine (Tokyo Chemical Industry Co., Ltd., 4.3 g, 9.0 mmol) was dripped in and thoroughly agitated, after which the temperature was raised to room temperature and the mixture was agitated for 1.5 hours. 30 mL of methanol (JUNSEI CHEMICAL CO., LTD.) was added to the resulting reaction solution, and the resulting coarsely purified product was filtered out and re-crystallized with benzene to obtain 10.7 g of the target compound.

The resulting compound was dissolved in 350 mL of THF (JUNSEI CHEMICAL CO., LTD.), 300 mL of $CH_2Cl_2$ (KANTO CHEMICAL CO., INC.) and 100 mL of acetone (KANTO CHEMICAL CO., INC.), hydrogen peroxide solution (Wako Pure Chemical Industries, Ltd., 10 mL 30 wt% solution) was added, and the mixture was agitated for 30 minutes at room temperature. 30 mL of water was added to the reaction solution, which was then concentrated to 600 mL, and filtered to yield 7.5 g of the target compound ($POPy_2$).

<Example 3>

[Photoelectric conversion element using copolymer A2 and BINAPO]

A 5 mm-square photoelectric conversion element was prepared as in Example 2 except that BINAPO obtained in accordance with the following Synthesis Example 9 was used instead of $POPy_2$ for the electron extraction layer, and the film thickness of the electron extraction layer was changed from 2.5 nm to 5 nm. The measurement results for the current-voltage characteristics are shown in Table 1.

<Synthesis Example 9>

[BINAPO synthesis example]

[Chemical Formula 32]

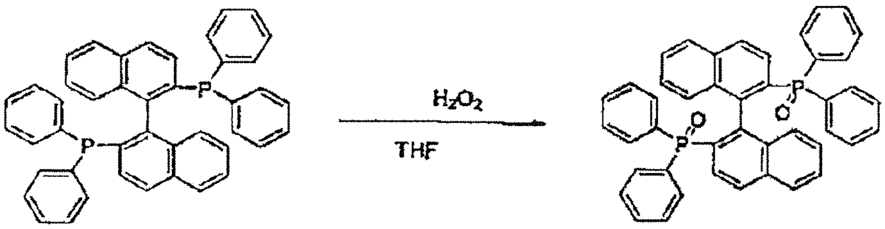


(BINAP) (BINAPO)

A 30 wt% hydrogen peroxide solution (Wako Pure Chemical Industries, Ltd., 3 mL) was added to a tetrahydrofuran (80 mL) solution of BINAP (Wako Pure Chemical Industries, Ltd., 1.86 g, 3 mmol), and agitated for 2.5 hours. 20 mL of water was then added, the tetrahydrofuran was removed by vacuum distillation, and the resulting coarsely purified product was washed with methanol and filtered to yield the target BINAPO (1.78 g, 2.7 mmol) with a yield of 91%.

<Example 4>

[Photoelectric conversion element using copolymer A2 and F-POPy$_2$

A 5 mm-square photoelectric conversion element was prepared as in Example 3 except that F-POPy$_2$ obtained in accordance with the following Synthesis Example 10 was used instead of BINAPO for the electron extraction layer. The measurement results for the current-voltage characteristics are shown in Table 1.

<Synthesis Example 10>

[F-POPy$_2$ synthesis example]

[Chemical Formula 33]

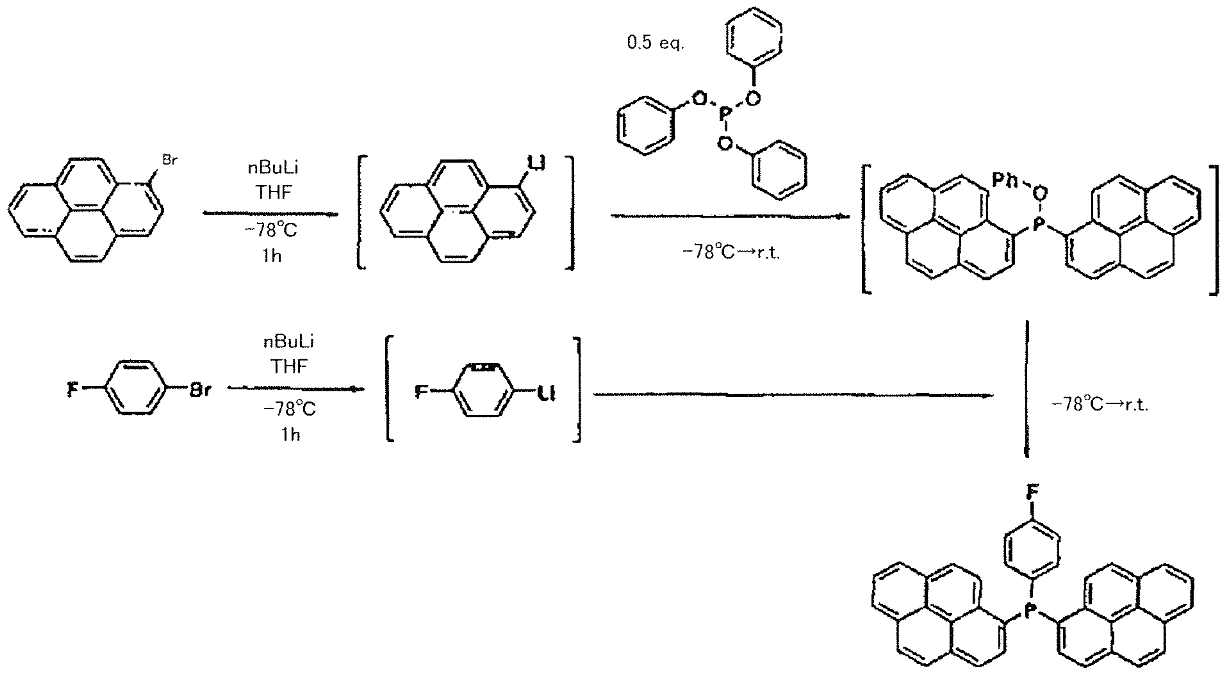


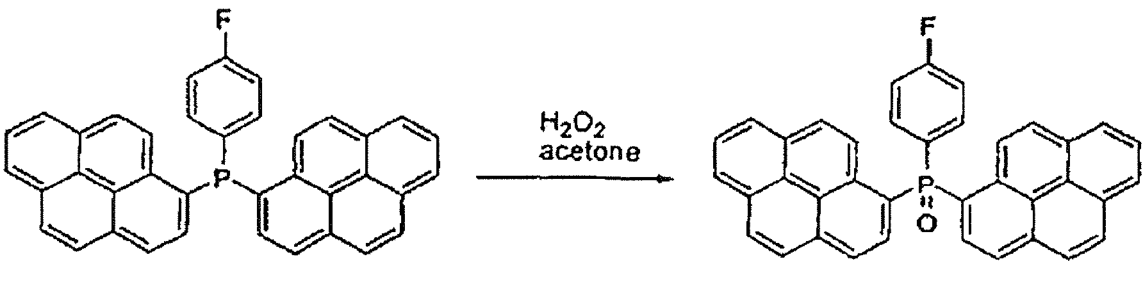


(F-POPy2)

1-bromopyrene (Tokyo Chemical Industry Co., Ltd., 5.6 g, 20 mmol) was dissolved in dehydrated tetrahydrofuran (KANTO CHEMICAL CO., INC., 100 mL) in a nitrogen atmosphere, and cooled to -78°C, after which n-butyl lithium (KANTO CHEMICAL CO., INC., Inc., 13 mL, 1.6 M) was gradually dripped in, and the mixture was agitated for 45 minutes with the temperature maintained at -78°C. Next, triphenyl phosphite (Wako Pure Chemical Industries, Ltd., 3.1 g, 10 mmol) was dripped in and thoroughly agitated, after which the temperature was raised to room temperature, and the mixture was agitated for 1.5 hours and then cooled again to -78°C. Meanwhile, 4-fluorobromobenzene (Tokyo Chemical Industry Co., Ltd., 3.5 g, 20 mmol) was dissolved in dehydrated tetrahydrofuran (50 mL) in a separate reaction container, n-butyl lithium (KANTO CHEMICAL CO., INC., 13 mL, 1.6 M) was added at -78°C in a nitrogen atmosphere, and after 30 minutes of agitation, this was dripped into the first container, the temperature was raised to room temperature, and agitation was continued for 1 hour.

20 mL of water was added to the resulting reaction solution, the tetrahydrofuran was removed by vacuum distillation, and extraction was performed with methylene chloride. The organic layer was dried by addition of magnesium sulfate, concentrated by filtration, and purified by column chromatography (developing solvent: hexane) to obtain 3.7 g of the target compound. The resulting compound was dissolved in acetone (KANTO CHEMICAL CO., INC., 150 ml), hydrogen peroxide solution (Wako Pure Chemical Industries, Ltd., 2 mL 30 wt% solution) was added, and the mixture was agitated at room temperature. 20 mL of water was added to the reaction solution, which was then concentrated, and washed with acetonitrile to give 1.9 g of the target compound (F-$POPy_2$).

<Example 5>

[Photoelectric conversion element using copolymer A2 and $(CF_3)_2$-$POPy_2$]

A 5 mm-square photoelectric conversion element was prepared as in Example 3 except that $(CF_3)_2$-$POPy_2$ obtained in accordance with the following Synthesis Example 11 was used instead of BINAPO for the electron extraction layer. The measurement results for the current-voltage characteristics are shown in Table 1.

<Synthesis Example 11>

[$(CF_3)_2$-$POPy_2$ synthesis example]

[Chemical Formula 34]

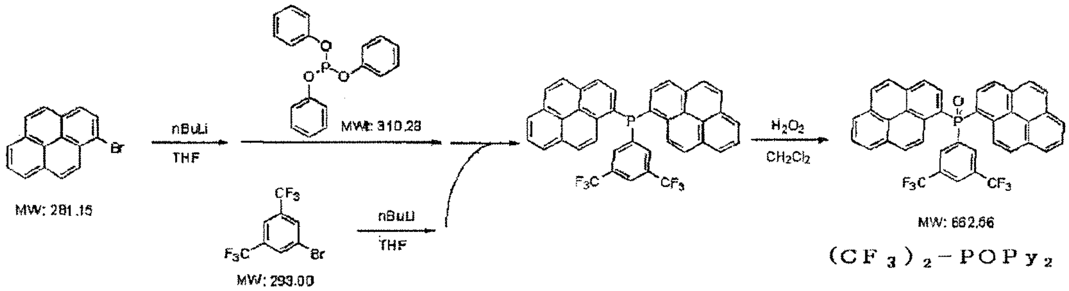


1-bromopyrene (Tokyo Chemical Industry Co., Ltd., 5.6 g, 20 mmol) was dissolved in dehydrated tetrahydrofuran (KANTO CHEMICAL CO., INC., 100 mL) in a nitrogen atmosphere, and cooled to -78°C, after which n-BuLi (KANTO CHEMICAL CO., INC., 13 mL, 1.6 M) was gradually dripped in, and agitation was performed for 30 minutes with the temperature maintained at -78°C. Next, triphenyl phosphite (Wako Pure Chemical Industries, Ltd., 3.1 g, 10 mmol) was gradually dripped in and thoroughly agitated, the temperature was returned to room temperature, and the mixture was agitated for 1.5 hours and cooled again to -78°C.

Meanwhile, 3,5-bistrifluoromethylbromobenzene (Tokyo Chemical Industry Co., Ltd., 5.8 g, 20 mmol) was dissolved in dehydrated tetrahydrofuran (50 mL) in a separate reaction container, n-butyl lithium (KANTO CHEMICAL CO., INC., 13 mL, 1.6 M) was added at -78°C in a nitrogen atmosphere, and after 30 minutes of agitation, this was dripped into the first container, the temperature was raised to room temperature, and agitation was continued for 12 hours. 20 mL of water was added to the reaction solution, the tetrahydrofuran was removed by vacuum distillation, and extraction was performed with dichloromethane. The organic layer was dried by addition of magnesium sulfate, concentrated by filtration, and purified by column chromatography (developing solvent:

hexane/dichloromethane mixed solvent) to give 0.9 g of the target precursor. The compound was identified by NMR.

0.9 g of the compound obtained above was dissolved in dichloromethane (KANTO CHEMICAL CO., INC., 100 mL), hydrogen peroxide solution (Wako Pure Chemical Industries, Ltd., 2 mL 30% solution) was added, and the mixture was agitated at room temperature. 20 mL of water was added to the reaction solution, the product was extracted and dried with sodium sulfate, and the solvent was removed by vacuum distillation. This was suspended and washed with hexane and methanol to give 0.6 g of the target ($(CF_3)_2$-$POPy_2$) (yield 9%). The resulting product was confirmed by NMR.

<Example 6>

[Photoelectric conversion unit using copolymer A4 and $POPy_2$]

A 5 mm-square photoelectric conversion element was prepared as in Example 2 except that the copolymer A4 was used instead of the copolymer A2 as a p-type semiconductor compound, o-xylene was used instead of chlorobenzene as the solvent of the organic active layer coating solution S0, and the film thickness of the active layer was changed from 100 nm to 120 nm. The measurement results for the current-voltage characteristics are shown in Table 1.

<Comparative Example 1>

[Photoelectric conversion element using PBDTTPD]

[Preparation of organic active layer coating solution S1]

The p-type semiconductor compound PBDTTPD obtained in the following Synthesis Example 12 was mixed with the n-type semiconductor compound PC71BM (Frontier Carbon Ltd. Company, NS-E112) at a weight ratio of 1:1.5, and dissolved in chlorobenzene in a nitrogen atmosphere to a concentration of the mixture of 0.8 wt%. 1,8-diiodooctane was then added to this solution to a ratio of 2.0 wt% relative to the organic active layer coating solution as a whole, and agitated and mixed for 4 hours at 80°C with a hot stirrer. After agitation and mixing, the solution was filtered with a 0.45 μm polytetrafluoroethylene (PTFE) filter to obtain an organic active layer coating solution S1.

[Preparation and evaluation of photoelectric conversion element]

A photoelectric conversion element was prepared by the same methods as in Reference Example 1 using the organic active layer coating solution S1 instead of the organic active layer coating solution S0, and the current-voltage characteristics of the resulting photoelectric conversion element were measured. The spin coating conditions for the organic active layer were 300 rpm, and the thickness of the organic active layer was about 100 nm. The measurement results for the current-voltage characteristics are shown in Table 1.

<Synthesis Example 12>

[PBDTTPD synthesis]

[Chemical Formula 35]

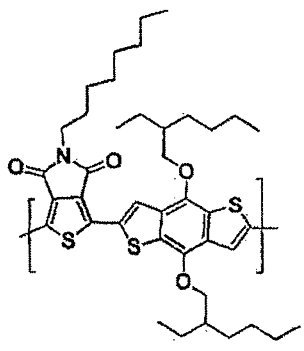

(PBDTTPD)

(PBDTTPD)

Poly(2,6-(4,8-bis(2-ethylhexyloxy)benzo[1,2-b:4,5-b']dithiophene))-alt-(5-octyl-4H-thieno[3,4-c]pyrrole-4,6(5H)-dione-1,3-dilyl) (PBDTTPD) was synthesized with reference to the descriptions of J. Am. Chem. Soc. 2010, 132, 7595-7597.

<Comparative Example 2>

[Photoelectric conversion element using PDTSBT]

[Preparation of organic active layer coating solution S2]

The p-type semiconductor compound PDTSBT obtained in the following Synthesis Example 13 and the n-type semiconductor compound PC71BM (Frontier Carbon Ltd. Company, NS-E112) were mixed to obtain a weight ratio of

1:1, and dissolved in chlorobenzene in a nitrogen atmosphere to a concentration of the mixture of 1.0 wt%. 1,8-diiodooctane was then added to this solution to a ratio of 3.2 wt% relative to the organic active layer coating solution as a whole, and agitated and mixed for 4 hours at 80°C with a hot stirrer. After agitation and mixing, the solution was filtered with a 1.0 μm polytetrafluoroethylene (PTFE) filter to give an organic active layer coating solution S2.

[Preparation and evaluation of photoelectric conversion element]

A photoelectric conversion element was prepared by the same methods as in Reference Example 1 above using the organic active layer coating solution S2 instead of the organic active layer coating solution S0, and the current-voltage characteristics of the resulting photoelectric conversion element were measured. The spin coating conditions for the organic active layer were 500 rpm, and the thickness of the organic active layer was about 80 nm. The measurement results for the current-voltage characteristics are shown in Table 1.

<Synthesis Example 13>

[PDTSBT synthesis]

[Chemical Formula 36]

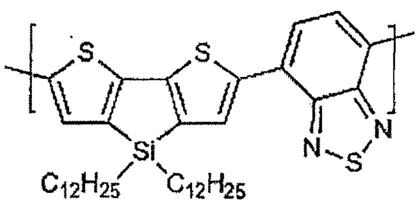

(PDTSBT)

(PDTSBT)

Poly(2,6-(4,4-bis(2-ethylhexyl)4H-silolo[3,2-b:4,5-b']dithiophene)-alt-(benzo[c][1,2,5]thiadiazole-4,7-diyl)) (PDTSBT) was synthesized with reference to the descriptions of WO 2010/022058.

<Comparative Example 3>

A 5 mm-square photoelectric conversion element was prepared as in Example 2 except that no $POPy_2$ was used as an electron extraction layer, and a 10 nm-thick film of Ca with an 80 nm-thick film of aluminum laminated thereon was used as the electrode instead of an 80 nm-thick film of aluminum. The measurement results for the current-voltage characteristics are shown in Table 1.

[Table 1]

| | p-type semiconductor material | Electron extraction layer | Electrode | Voc (V) | Jsc (mA/cm$^2$) | FF (-) | PCR (%) |
|---|---|---|---|---|---|---|---|
| Reference Ex. 1 | Copolymer A1 | LiF | Aluminum | 0.88 | 12.8 | 0.68 | 7.6 |
| Ex. 2 | Copolymer A2 | $POPy_2$ | Aluminum | 0.87 | 13.7 | 0.73 | 8.7 |
| Ex. 3 | Copolymer A2 | BINAPO | Aluminium | 0.87 | 12.8 | 0.72 | 8.0 |
| Ex. 4 | Copolymer A2 | F-$POPy_2$ | Aluminum | 0.87 | 13.4 | 0.73 | 8.5 |
| Ex. 5 | Copolymer A2 | $(CF_3)_2$-$POPy_2$ | Aluminum | 0.87 | 13.4 | 0.73 | 8.5 |

(continued)

| | p-type semiconductor material | Electron extraction layer | Electrode | Voc (V) | Jsc (mA/cm2) | FF (-) | PCR (%) |
|---|---|---|---|---|---|---|---|
| Ex. 6 | Copolymer A4 | $POPy_2$ | Aluminum | 0.90 | 14.5 | 0.73 | 9.5 |
| CE 1 | PBDTTPD | LiF | Aluminum | 0.82 | 11.6 | 0.54 | 5.1 |
| CE 2 | PDTSBT | LiF | Aluminum | 0.52 | 13.3 | 0.55 | 3.9 |
| CE 3 | Copolymer A2 | None | Ca/aluminum laminate | 0.89 | 11.6 | 0.72 | 7.4 |

As shown in Table 1, using a compound having an E=X group, and in Examples 2 and 6 in particular using the phosphine compound $POPy_2$ having a double bond between a phosphorus atom and an atom selected from group 16 of the periodic table as an electron extraction layer material and using an organic semiconductor material comprising a copolymer containing an imidothiophene structure and a dithienosilole structure as an active layer material, the photoelectric conversion characteristics were greatly superior to those of Comparative Examples 1 and 2. Moreover, using a compound having an E=X group, and in Examples 2 to 6 in particular using a phosphine compound having a double bond between a phosphorus atom and an atom selected from group 16 of the periodic table as an electron extraction layer material, a high photoelectric conversion efficiency was obtained in comparison with Reference Example 1 using lithium fluoride as the electron extraction layer material and Comparative Example 3 using a laminated electrode of Ca and aluminum with no electron extraction layer material.

[Measurement of LUMO and glass transition temperature (Tg) of electron extraction layer material]

The LUMO and glass transition temperature (Tg) of each electron extraction layer material were measured by the methods described above. The respective results are shown in Table 2.

[Table 2]

| | Electron extraction layer | LUMO (eV) | Tg (°C) |
|---|---|---|---|
| Synthesis Example 8 | $POPy_2$ | -2.74 | 141.3 |
| Synthesis Example 9 | BINAPO | -2.33 | 133.8 |
| Synthesis Example 10 | F-$POPy_2$ | -2.75 | 140.8 |
| Synthesis Example 11 | $(CF_3)_2$-$POPy_2$ | -2.80 | 122.9 |

It can be seen from the results of Table 1 and Table 2 that photoelectric conversion efficiency is improved by using a compound with a LUMO in a specific range as the material of the electron extraction layer. Moreover, photoelectric conversion efficiency is also improved by using a compound with a Tg in a specific range as the material of the electron extraction layer, whereby improved durability of the photoelectric conversion elements can be expected.

[Measurement of X-ray diffraction]

The X-ray diffraction spectrum of the copolymer A2 is shown in Fig. 6. A diffraction peak ($2\theta$ = 4.77°) was detected. The surface separation (d) as calculated from this peak value is d = 1.85 nm. In P3HT and other thiophene oligomers, the molecules are strongly aligned, forming a dense overlapping two-dimensional lamellar structure, and a diffraction peak is observed corresponding to a surface separation near d = 1.6. Judging from this, it appears that the copolymer A2 is also a crystalline material having a layered structure of aligned molecules.
[Measurement of field effect transistor (FET) characteristics]
[Table 3]

| Polymer | Hole mobility [$cm^2/Vs$] | Mw | Mn | PDI |
|---|---|---|---|---|
| Copolymer A4 | $2.6 \times 10^{-3}$ | $8.1 \times 10^4$ | $3.4 \times 10^4$ | 2.37 |
| Copolymer A5 | $6.2 \times 10^{-3}$ | $3.1 \times 10^5$ | $6.0 \times 10^4$ | 5.22 |
| Copolymer A6 | $2.4 \times 10^{-3}$ | $2.4 \times 10^5$ | $3.1 \times 10^4$ | 7.60 |
| Copolymer A7 | $3.7 \times 10^{-4}$ | $2.6 \times 10^4$ | $2.2 \times 10^4$ | 1.18 |

It can be seen from Table 3 that the copolymer of the present invention has high hole mobility. The hole mobility is also shown to correlate with the number-average molecular weight (Mn).

These results support the claim that the copolymer of the present invention can form a film by a practical coating process, and because it has light absorption at long wavelengths, a photoelectric conversion element having an active layer containing the polymer of the present invention and an electron extraction layer containing a compound represented by General Formula (E1) has a high open voltage and conversion efficiency, and/or excellent durability, and can be used in solar cells and the like.

While the invention has been described in detail and with reference to specific embodiments thereof, it will be apparent to one skilled in the art that various changes and modifications can be made therein without departing from the spirit and scope thereof.

[Reference Signs List]

| | |
|---|---|
| 1 | Weather-resistant protective film |
| 2 | UV exclusion film |
| 3,9 | Gas barrier film |
| 4,8 | Getter film |
| 5,7 | Seal material |
| 6 | Solar cell element |
| 10 | Back sheet |
| 12 | Base material |
| 13 | Solar cell module |
| 14 | Thin-film solar cell |
| 101 | Anode |
| 102 | Hole extraction layer |
| 103 | Active layer (mixed layer of p-type semiconductor compound and n-type semiconductor compound) |
| 104 | Electron extraction layer |
| 105 | Cathode |
| 106 | Substrate |
| 107 | Photoelectric conversion element |

## Claims

**1.** A photoelectric conversion element, comprising a pair of electrodes, an active layer disposed between the electrodes, and an electron extraction layer disposed between at least one of the electrodes and the active layer,
wherein the active layer contains a copolymer having a repeating unit represented by General Formula (1) below, and the electron extraction layer contains a compound represented by General Formula (E1) below:

[Chemical Formula 1]

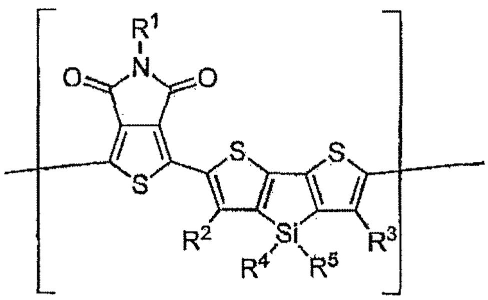

(1)

(in Formula (1), $R^1$ represents an optionally substituted alkyl group, optionally substituted alkenyl group or optionally substituted aryl group, and $R^2$ to $R^5$ each independently represent a hydrogen atom, halogen atom, optionally substituted alkyl group, optionally substituted alkenyl group or optionally substituted aryl group);

[Chemical Formula 2]

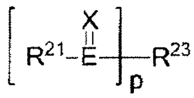

(E1)

(in Formula (E1), E represents $PR^{22}$, S, S(=O) or C; p represents an integer of 1 or greater, $R^{21}$ and $R^{22}$ each independently represent an arbitrary substituent, and $R^{21}$ and $R^{22}$ may bind to each other to form a ring; when p is 2 or greater, a plurality of $R^{21}$ and a plurality of $R^{22}$ may each independently be different, and any two or more of the plurality of $R^{21}$ and the plurality of $R^{22}$ may bind to each other to form a ring; $R^{23}$ represents an optionally substituted p-valent hydrocarbon group, an optionally substituted p-valent heterocyclic group, or a p-valent group with at least one of an optionally substituted hydrocarbon group and an optionally substituted heterocyclic group linked thereto; and X represents an atom selected from group 16 of the periodic table).

**2.** The photoelectric conversion element according to Claim 1, wherein the compound represented by General Formula (E1) above is a compound represented by General Formula (P1) below:

[Chemical Formula 3]

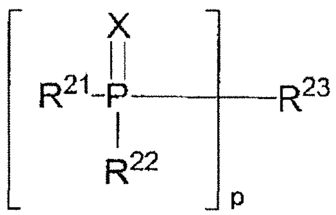

(P1)

(in Formula (P1), p represents an integer of 1 or greater, $R^{21}$ and $R^{22}$ each independently represent an arbitrary substituent, and $R^{21}$ and $R^{22}$ may bind to each other to form a ring; when p is 2 or greater, a plurality of $R^{21}$ and a plurality of $R^{22}$ may each independently be different, and any two or more of the plurality of $R^{21}$ and the plurality of $R^{22}$ may bind to each other to form a ring; $R^{23}$ represents an optionally substituted p-valent hydrocarbon group, an optionally substituted p-valent heterocyclic group, or a p-valent group with at least one of an optionally substituted hydrocarbon group and an optionally substituted heterocyclic group linked thereto; and X represents an atom selected from group 16 of the periodic table).

**3.** The photoelectric conversion element according to Claim 1 or 2, wherein $R^{21}$ and $R^{22}$ each independently represent an optionally substituted hydrocarbon group, optionally substituted alkoxy group or optionally substituted heterocyclic

group.

**4.** The photoelectric conversion element according to any of Claims 1 to 3, wherein the active layer also contains at least one kind of n-type semiconductor compound selected from the group consisting of fullerene compounds, borane derivatives, thiazole derivatives, benzothiazole derivatives, benzothiadiazole derivatives, N-alkyl substituted naphthalene tetracarboxylic diimides, N-alkyl substituted perylene diimide derivatives and n-type polymer semiconductor compounds.

**5.** The photoelectric conversion element according to any of Claims 1 to 4, which is a solar cell.

**6.** A solar cell module comprising the photoelectric conversion element according to Claim 5.

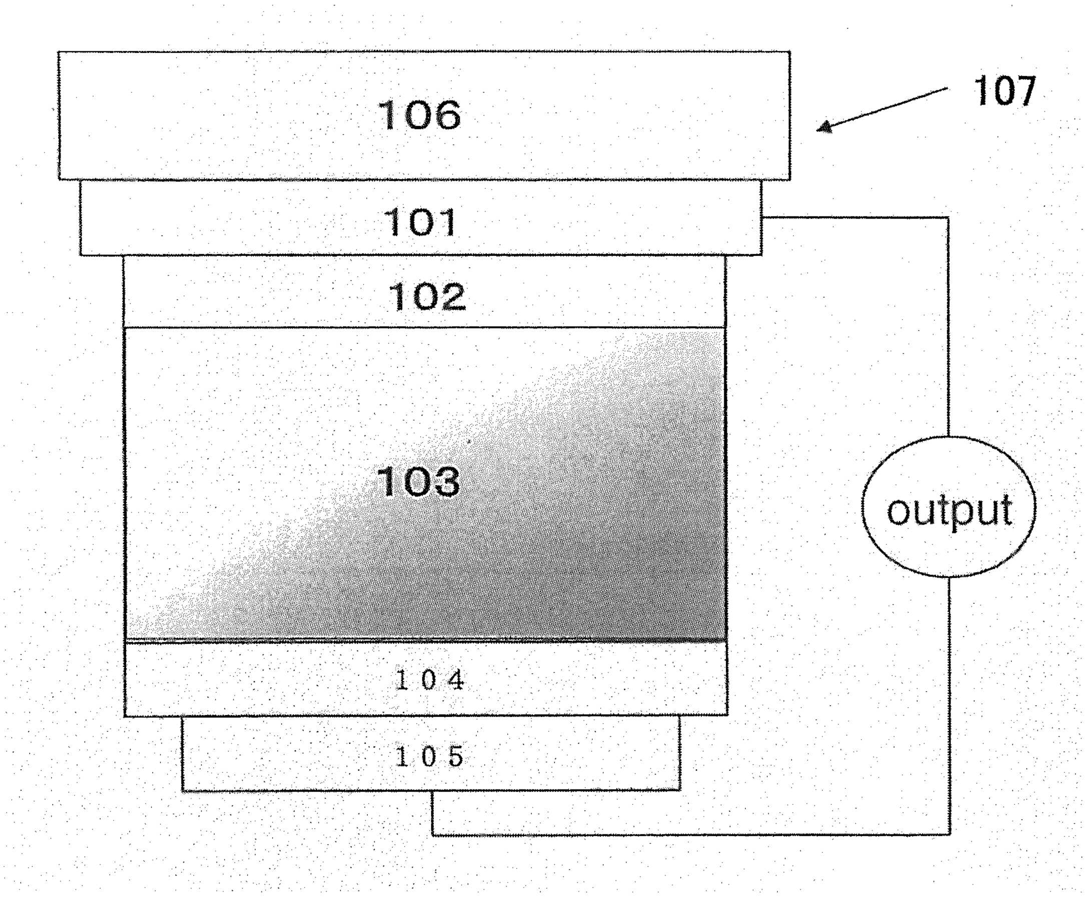


Fig. 1

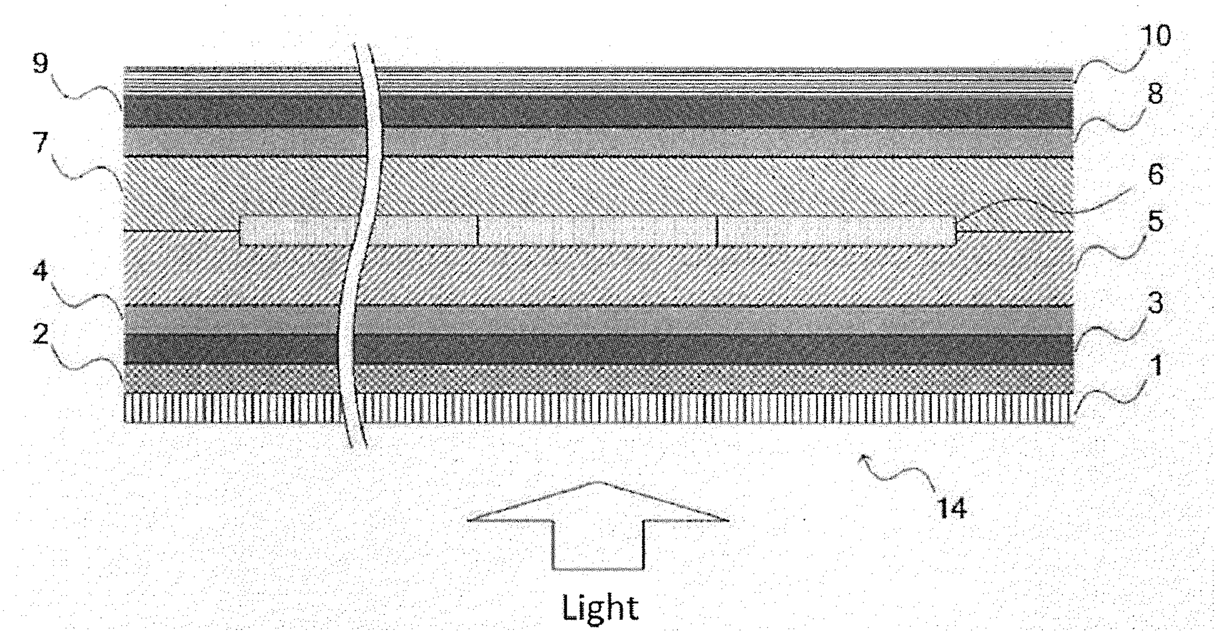


Fig. 2

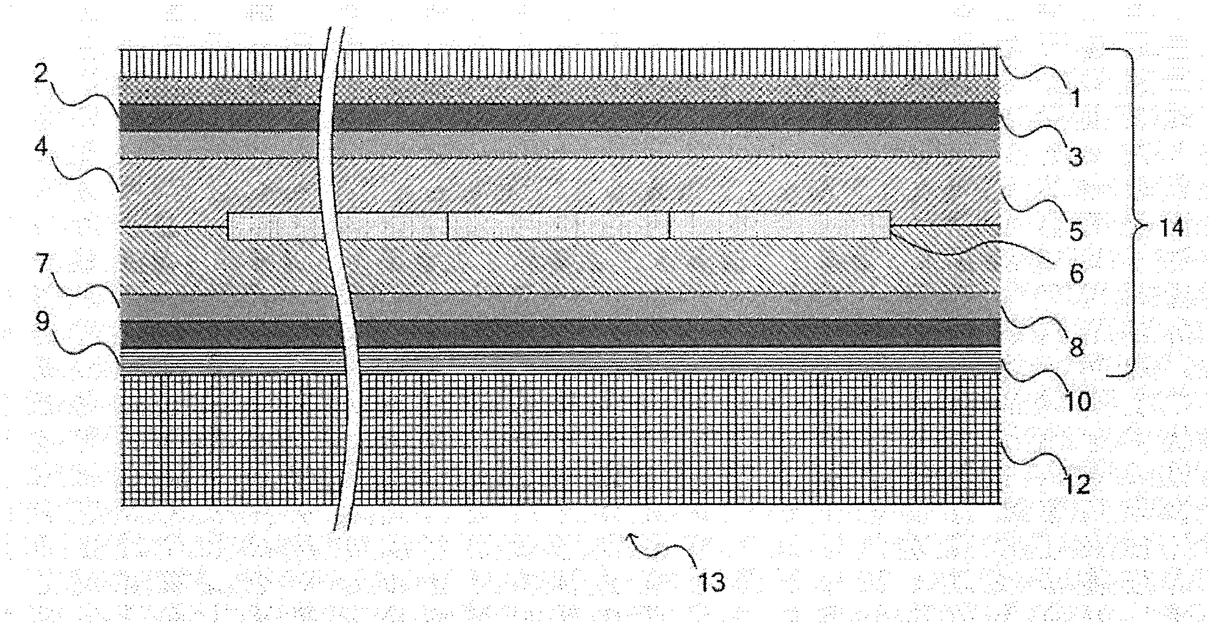


Fig. 3

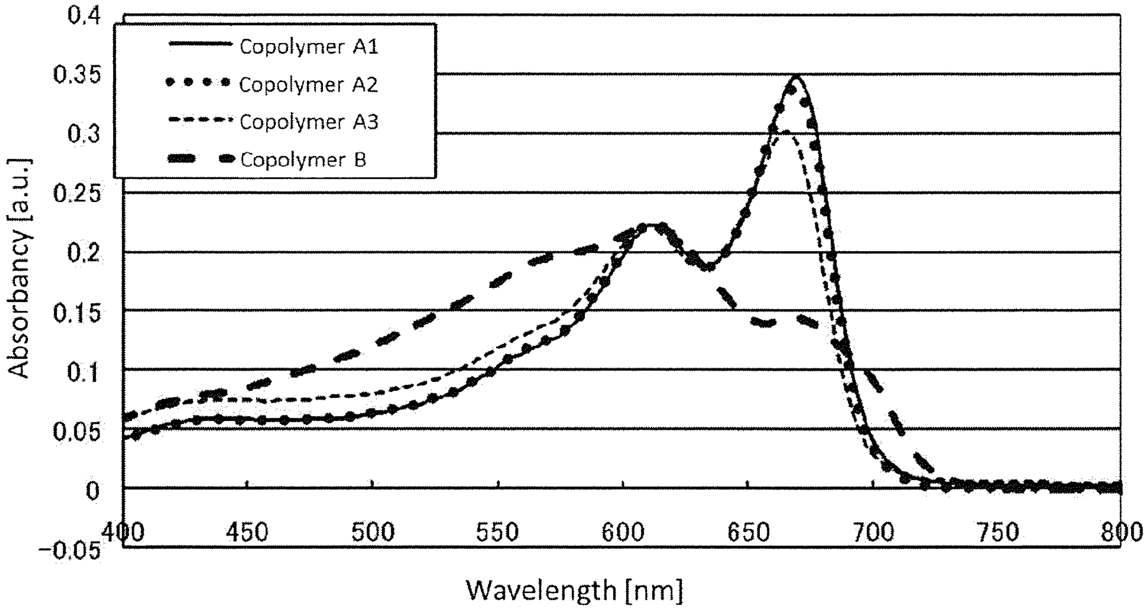
Copolymer A1
Copolymer A2
Copolymer A3
Copolymer B
Absorbancy [a.u.]
0.4
0.35
0.3
0.25
0.2
0.15
0.1
0.05
0
-0.05
400
450
500
550
600
650
700
750
800
Wavelength [nm]

Fig. 4

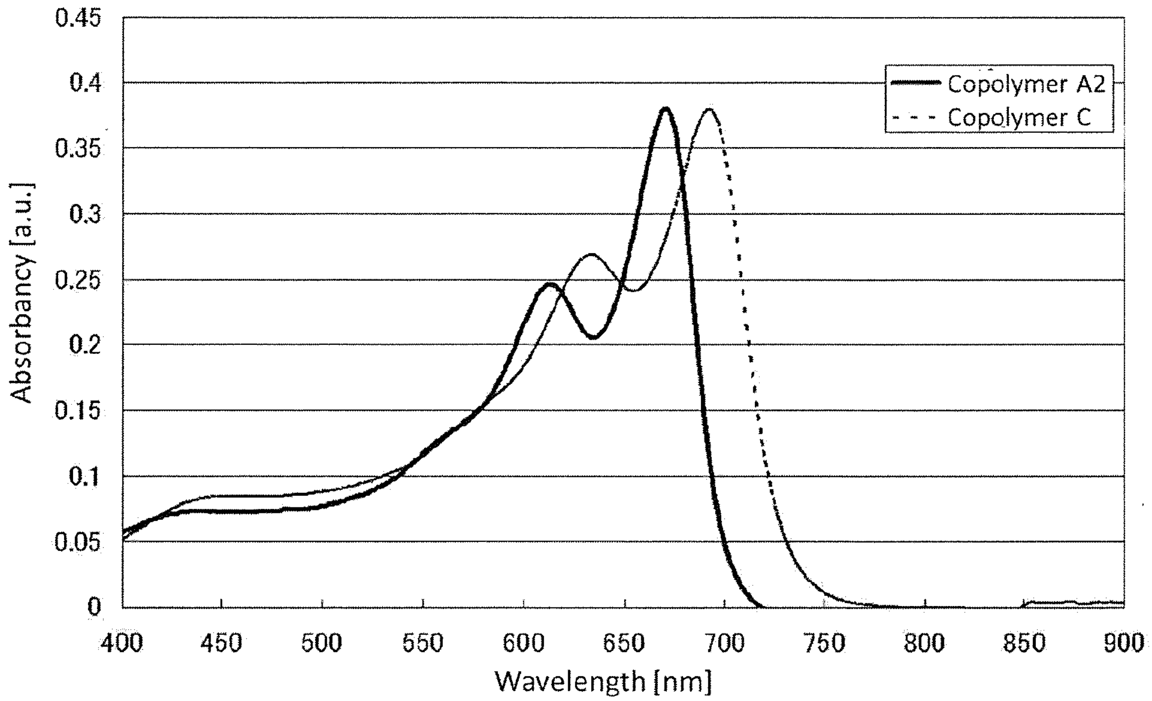
0.45
0.4
0.35
0.3
0.25
0.2
0.15
0.1
0.05
0
Absorbancy [a.u.]
Copolymer A2
Copolymer C
400
450
500
550
600
650
700
750
800
850
900
Wavelength [nm]

Fig. 5

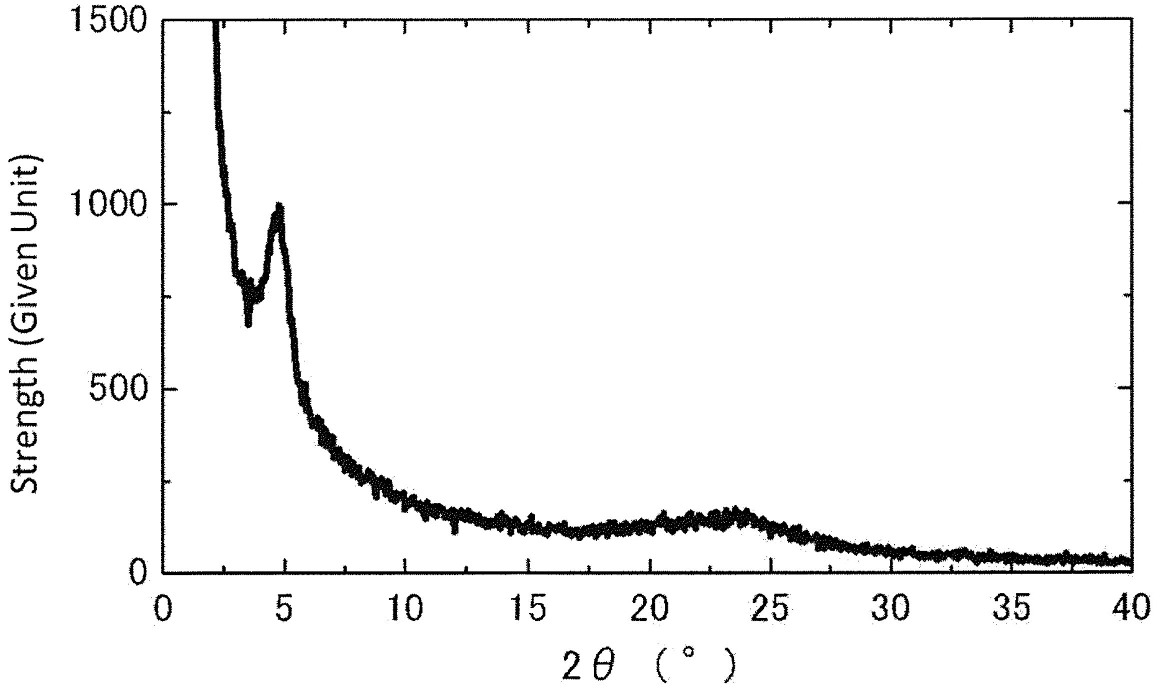


Fig. 6

| INTERNATIONAL SEARCH REPORT | International application No. PCT/JP2012/051870 |
|---|---|

A. CLASSIFICATION OF SUBJECT MATTER
*H01L51/42*(2006.01)i, *C08G61/12*(2006.01)i, *H01L29/786*(2006.01)i, *H01L51/05*(2006.01)i, *H01L51/30*(2006.01)i

According to International Patent Classification (IPC) or to both national classification and IPC

B. FIELDS SEARCHED

Minimum documentation searched (classification system followed by classification symbols)
H01L51/42, C08G61/12, H01L29/786, H01L51/05, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| Y | Yong Zhang et al., "Conjugated polymers based on C, Si and N-bridged dithiophene and thienopyrroledione units: synthesis, field-effect transistors and bulk heterojunction polymer solar cells", Journal of Materials Chemistry, 2011.01.27, vol. 21, pp. 3895-3902 | 1-6 |
| P,Y | Ta-Ya Chu et al., "Bulk heterojunction solar cells using thieno[3,4-c]pyrrole-4,6-dione and dithieno[3,2-b:2',3'-d] silole copolymer with a power conversion efficiency of 7.3%", Journal of the American Chemical Society, 2011.03.04, vol. 133, pp. 4250-4253 | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 March, 2012 (07.03.12) | 19 March, 2012 (19.03.12) |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.
PCT/JP2012/051870

C (Continuation). DOCUMENTS CONSIDERED TO BE RELEVANT

| Category* | Citation of document, with indication, where appropriate, of the relevant passages | Relevant to claim No. |
|---|---|---|
| P,Y | Mao-Chuan Yuan et al., "A crystalline low-bandgap polymer comprising dithienosilole and thieno[3,4-c]pyrrole-4,6-dione units for bulk heterojunction solar cells", Polymer, 2011.05.05, vol. 52, pp. 2792-2798 | 1-6 |
| P,Y | Young-Rae Hong et al., "Polymer solar cells based on copolymers of dithieno[3,2-b:2',3'-d] silole and thienopyrroledione", Chemical Communications, 2011.05.07, vol. 47, pp. 4920-4922 | 1-6 |
| P,Y | Chad M. Amb et al., "Dithienogermole as a fused electron donor in bulk heterojunction solar cells", Journal of the American Chemical Society, 2011.06.06, vol. 133, pp. 10062-10065 | 1-6 |
| P,Y | WO 2011/63534 A1 (Universite Laval), 03 June 2011 (03.06.2011), claims; Polymer ZP16 (Family: none) | 1-6 |
| Y | JP 2006-73583 A (Toray Industries, Inc.), 16 March 2006 (16.03.2006), claims; paragraphs [0033] to [0040], [0060] (Family: none) | 1-6 |
| Y | JP 2007-527116 A (Merck Patent GmbH), 20 September 2007 (20.09.2007), claims; paragraph [0034] & JP 2007-526634 A & US 2007/0164273 A1 & US 2007/0170419 A1 & EP 1716724 A & EP 1716725 A & WO 2005/084082 A1 & WO 2005/084081 A1 & DE 102004008304 A & DE 102004008304 A1 & KR 10-2006-0127138 A & KR 10-2006-0133584 A & CN 1922929 A & CN 1922930 A | 1-6 |
| P,Y | WO 2011/16430 A1 (Mitsubishi Chemical Corp.), 10 February 2011 (10.02.2011), claims; paragraphs [0188] to [0205], [0745] to [0853] & JP 2011-54947 A & JP 2011-54948 A & JP 2011-86925 A | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010507233 A
- WO 2010022058 A
- JP 2006063334 A
- JP 2010045186 A
- WO 2008066933 A
- JP 2007324587 A
- WO 2011016430 A
- WO 2008059771 A
- WO 2008018931 A
- WO 2009086210 A
- WO 2008063609 A
- WO 2009115513 A
- WO 2009098250 A
- WO 2009000756 A
- WO 2009091670 A
- WO 2007146250 A
- WO 2009098253 A
- WO 2010012710 A
- JP 2011046697 A


### Non-patent literature cited in the description


- *J. Am. Chem. Soc.,* 2010, vol. 132, 7595-7597
- **XUGANG GUO.** Thieno[3,4-c]pyrrole-4,6-dione-Based Donor-Acceptor Conjugated Polymers for Solar Cells, [on line. *Macromolecules,* 21 January 2011, http://pubs.acs.org/doi/pdfplus/10.1021/ma101878w
- *J. Mater. Chem.,* 2011, vol. 21, 3895-3902
- A Practical Guide for X-ray Crystal Structure Analysis. *Applied Physics Library,* vol. 4
- Yuukigousei no tame no senikinzokusyokubaihannou. CROSS-COUPLING REACTIONS: BASIC CHEMSTRY AND INDUSTRIAL APPLICATIONS. CMC Publishing CO., LTD,
- *J. Am. Chem. Soc.,* 2010, vol. 132 (22), 7595-7597
- *J. Mater. Chem.,* 2011, vol. 21, 3895
- *J. Am. Chem. Soc.,* 2008, vol. 130, 16144-16145
- Handbook of Conducting Polymers. 2007, vol. 2
- *Materials Science and Engineering,* 2001, vol. 32, 1-40
- *Pure Appl. Chem.,* 2002, vol. 74, 2031-3044
- Handbook of THIOPHENE-BASED MATERIALS. 2009, vol. 2
- *J. Am. Chem. Soc.,* 2008, vol. 130 (46), 15429-15436
- *J. Am. Chem. Soc.,* 1993, vol. 115, 9798-9799
- *Chem. Mater.,* 2007, vol. 19, 5363-5372
- *Chem. Mater.,* 2007, vol. 19, 5194-5199
- *Angew. Chem. Int. Ed. Engl.,* 1993, vol. 32, 78-80
- *Tetrahedron Lett.,* 1997, vol. 38, 285-288
- *J. Chem. Soc., Perkin Trans. 1,* 1997, 1595
- *Thin Solid Films,* 2005, vol. 489, 251-256
- *Adv. Funct. Mater.,* 2005, vol. 15, 1979-1987
- *J. Org. Chem.,* 1995, vol. 60, 532-538
- *Journal of the American Chemical Society,* 2006, vol. 128 (17), 5672-5679
- *Organic Letters,* 2008, vol. 10 (20), 4637-4640
- *J. Am. Chem. Soc.,* 2008, vol. 130, 15429-15436